(19) Europäisches Patentamt
European Patent Office
Office européen des brevets

(11) EP 1 617 288 A1

(12) # EUROPEAN PATENT APPLICATION

(43) Date of publication:
**18.01.2006 Bulletin 2006/03**

(21) Application number: **05015446.7**

(22) Date of filing: **15.07.2005**

(51) Int Cl.:
*G03F 7/038* (2006.01) *G03F 7/004* (2006.01)
*G03F 7/031* (2006.01) *G03F 7/029* (2006.01)

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.07.2004 JP 2004208777**

(71) Applicant: **FUJI PHOTO FILM CO., LTD.**
**Minami-Ashigara-shi, Kanagawa (JP)**

(72) Inventors:
- **Tsuchimura, Tomotaka,**
**Fuji Photo Film Co., Ltd**
**Haibara-gun**
**Shizuoka (JP)**
- **Arimura, Keisuke,**
**Fuji Photo Film Co., Ltd**
**Haibara-gun**
**Shizuoka (JP)**
- **Sorori, Tadahiro,**
**Fuji Photo Film Co., Ltd**
**Haibara-gun**
**Shizuoka (JP)**

(74) Representative: **HOFFMANN EITLE**
**Patent- und Rechtsanwälte**
**Arabellastrasse 4**
**81925 München (DE)**

(54) **Photosensitive composition and lithographic printing plate precursor**

(57) A photosensitive composition comprising: at least one photopolymerization initiator; an N-oxyamide compound represented by formula (1); and a compound of undergoing a reaction by an effect of at least one of a radical and an acid to irreversibly change in its physical or chemical property,

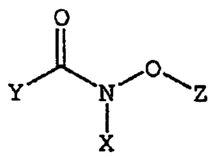

(1)

wherein X, Y and Z each independently represents a monovalent substituent.

EP 1 617 288 A1

## Description

### FIELD OF THE INVENTION

The present invention relates to a photosensitive composition containing a novel photoinitiation system, in particular, a photoinitiation system with high sensitivity and excellent stability. Also, the present invention relates to a photopolymerizable composition particularly excellent as a material for lithographic printing plate precursors capable of plate-making by scan exposure based on digital signals.
Furthermore, the present invention relates to a lithographic printing plate precursor having a photosensitive layer comprising the above-described photosensitive composition.

### BACKGROUND OF THE INVENTION

Conventionally, a PS plate comprising a hydrophilic support having provided thereon a lipophilic photosensitive resin layer has been widely used as a lithographic printing plate. According to the usual plate-making method therefor, a printing plate precursor is subjected to mask exposure (plane exposure) through a lith film and then the non-image area is dissolved and removed, whereby a desired printing plate is obtained.
In recent years, digitization technology of electronically processing, storing and outputting image information by using a computer has been widespread and various new methods for outputting an image, which can cope with this technology, have been used in practice. This tendency has brought about the demand for a computer-to-plate (CTP) technique of requiring no lith film but directly producing a printing plate by scanning highly directive light such as laser light according to digitized image information. As a result, it has become an important technical concern to obtain a printing plate precursor compatible with the plate-making by CTP.
As one of the systems for obtaining a lithographic printing plate capable of scan exposure, a constitution such that a photopolymerizable composition having an excellent photosensitive speed is used for the ink-receptive photosensitive resin layer (hereinafter, referred to as a "photosensitive layer") formed on a hydrophilic support has been heretofore proposed and already put into market. The printing plate precursor having such a constitution enables simple and easy development and further assures preferred plate and printing performances such as excellent resolution, inking property, press life and scumming resistance.
The above-described photopolymerizable composition fundamentally comprises an ethylenically unsaturated compound, a photopolymerization initiation system and a binder resin, and the image formation proceeds as follows. The photopolymerization initiation system absorbs light to produce an active radical and this induces addition polymerization of the ethylenically unsaturated compound, as a result, the photosensitive layer is insolubilized.
In most of conventional proposals on the photopolymerizable composition capable of scan exposure, use of a photoinitiation system having excellent photosensitivity is disclosed. A large number of such systems are described, for example, in Bruce M. Monroe et al., Chemical Revue, Vol. 93, pp. 435-448 (1993) and R.S. Davidson, Journal of Photochemistry and Biology A: Chemistiy, Vol. 73, pp. 81-96 (1993).
As for conventional CTP systems using a photopolymerizable composition comprising such an initiation system and employing a long-wavelength visible light source such as Ar laser (488 nm) and FD-YAG laser (532 nm), writing at a higher speed is demanded so as to elevate the productivity in the plate-making process. However, this requirement is not yet satisfied, because the output of light source or the sensitivity of photosensitive material is not sufficiently high.
On the other hand, for example, a semiconductor laser using an InGaN-type material and being capable of continuous oscillation in the region from 350 to 450 nm has recently come into practical use. The scan exposure system using such a short-wave light source is advantageous in that the semiconductor laser can be produced at a low cost in view of its structure and an economical system can be established while ensuring a sufficiently high output. Furthermore, as compared with conventional systems using an FD-YAG or Ar laser, a photosensitive material having sensitivity in a short-wave region and in turn enabling operation under brighter safelight can be used.
However, a photoinitiation system having sufficiently high sensitivity for scan exposure in a short-wavelength region of 350 to 450 nm is not yet known at present.
The technique for obtaining a high-sensitivity photoinitiation system is still widely demanded in the imaging field (see, for example, JP-A-2000-258910, J.P. Faussier, "Photoinitiated Polymerization-Theory and Applications": Rapra Review, Vol. 9, Report, Rapra Technology (1998), and M. Tsunooka et al., Prog. Polym. Sci., 21, 1 (1996)) and is expected to be applicable to, for example, the image formation such as stereolithography, holography and color hard copy, the electronic material production field such as photoresist, and the usage for photocurable resin materials such as ink, paint and adhesive. In these industrial fields, it is demanded for inducing decomposition of the activator with good efficiency to find out a sensitizing dye excellent in light absorptivity and sensitization ability.

SUMMARY OF THE INVENTION

An object of the present invention is to provide a photosensitive composition which can give a lithographic printing plate precursor or the like for scan exposure having excellent workability, profitability and press life as well as compatibility with CTP system. In particular, an object of the present invention is to provide a photosensitive composition having high sensitivity to light at a wavelength over a wide range from 350 to 450 nm, which is suitable for a lithographic printing plate precursor or the like having high sensitivity to light at an oscillation wavelength of a short-wave semiconductor laser.

Another object of the present invention is to provide a lithographic printing plate precursor having a photosensitive layer comprising the photosensitive composition.

As a result of intensive investigations to achieve the above-described objects, the present inventors have found that a novel photoinitiation system comprising an N-oxyamide compound having a specific structure and a photopolymerization initiator gives particularly high photosensitivity. The present invention has been accomplished based on this finding.

That is, the present invention is as follows.

(1) A photosensitive composition comprising:

(i) at least one photopolymerization initiator,
(ii) an N-oxyamide compound represented by formula (1), and
(iii) a compound of undergoing a reaction by the effect of at least one of a radical and an acid to irreversibly change in its physical or chemical property,

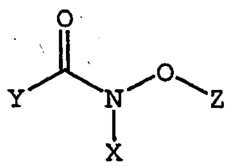

(1)

(wherein X, Y and Z each independently represents a monovalent substituent).

(2) The photosensitive composition as described in (1) above, wherein the compound of undergoing a reaction by the effect of at least one of a radical and an acid to irreversibly change in its physical or chemical property is a compound having an ethylenically unsaturated double bond.
(3) A lithographic printing plate precursor comprising a photosensitive layer containing the photosensitive composition described in (1) above.

The photosensitive composition comprising an N-oxyamide compound represented by formula (1) and a photopolymerization initiator of the present invention has sufficiently high sensitivity for scan exposure using a laser light source for example at a wavelength shorter than 450 nm and is useful in obtaining, for example, a lithographic printing plate precursor for scan exposure which is handleable even under bright safelight, excellent in workability, profitability, press life and the like, and compatible with CTP system.

DETAILED DESCRIPTION OF THE INVENTION

The embodiment of the present invention is described in detail below.

[A. Photoinitiation System]

The photoinitiation system of the present invention comprises (i) an N-oxyamide compound having a specific structure represented by formula (1) and (ii) a photopolymerization initiator.

[Photopolymerization initiator]

The photopolymerization initiator (radical polymerization initiator is preferably used) used in the invention is described below. The photopolymerization initiator used in the invention is a compound undergoes chemical change through action of light or interaction with electronically-excited state of sensitizing dye to generate at least any one of a

radical, acid and base.

As the photopolymerization initiator, those known in the field of art can be used without limitation. Specifically, a large number of the photopolymerization initiators are described, for example, in Bruce M. Monroe, Chemical Review, 93, 435 (1993), R.S. Davidson, Journal of Photochemistry and Photobiology A: Chemistry, 73, 81 (1993), J.P. Fouassier, Photoinitiated Polymerization-Theory and Applications, Rapra Review, Vol. 9, Report, Rapra Technology (1998) and M. Tsunooka et al., Prog. Polym. Sci., 21, 1 (1996). Further, a large number of compounds utilized in chemically amplified photoresists and photo-cation polymerization are described in Yuki Electronics Zairyo Kenkyukai, ed., Imaging-yo Yuki Zairyo, pages 187 to 192, Bun-Shin Publishing (1993). Moreover, compounds undergoing oxidatively or reductively cleavage of bond through interaction with electronically-excited state of sensitizing dye described, for example, in F.D. Saeva, Topics in Current Chemistry, 156, 59 (1990), G.G. Maslak, Topics in Current Chemistry, 168, 1 (1993), H.B. Shuster et al., JACS, 112, 6329 (1990) and I.D.F. Eaton et al., JACS, 102, 3298 (1980) are also known.

Preferred examples of the photopolymerization initiator include (a) an aromatic ketone, (b) an aromatic onium salt compound, (c) an organic peroxide, (d) a hexaarylbiimidazole compound, (e) a ketoxime ester compound, (f) a borate compound, (g) an azinium compound, (h) a metallocene compound, (i) an active ester compound, and (j) a compound having a carbon-halogen bond.

The aromatic ketone (a) preferably includes compounds having a benzophenone skeleton or a thioxantone skeleton described in J.P. Fouassier and J. F. Rabek, Radiation Curing in Polymer Science and Technology, pages 77 to 117 (1993). More preferred examples of the aromatic ketone (a) include α-thiobenzophenone compounds described in JP-B-47-6416, benzoin ether compounds described in JP-B-47-3981, α-substituted benzoin compounds described in JP-B-47-22326, benzoin derivatives described in JP-B-47-23664, aroylphophonic esters described in JP-A-57-30704, dialkoxybenzophenones described in JP-B-60-26483, benzoin ethers described in JP-B-60-26403 and JP-A-62-81345, α-aminobenzophenones described in JP-B-1-34242, U.S. Patent 4,318,791 and European Patent 284,561, p-di(dimethylaminobenzoyl)benzene described in JP-A-2-211452, thio-substituted aromatic ketones described in JP-A-61-194062, acylphosphinesulfides described in JP-B-2-9597, acylphosphines described in JP-B-2-9596, thioxantones described in JP-B-63-61950, and coumarins described in JP-B-59-42864.

The aromatic onium salt compound (b) includes aromatic onium salts of elements of Groups V, VI and VII in the periodic table, specifically, N, P, As, Sb, Bi, O, S, Se or Te, and I. For example, iodonium salts described in European Patent 104,143, U.S. Patent 4,837,124, JP-A-2-150848 and JP-A-2-296514, sulfonium salts described in European Patents 370,693, 233,567, 297,443, 297,442, 297,210 and 422,570, U.S. Patents 3,902,144, 4,933,377, 4,760,013, 4,734,444 and 2,833,827, diazonium salts (e.g., benzene diazonium salt that may have a substituent), diazonium salt resins (e.g., formaldehyde resin of diazodiphenylamine), N-alkoxypiridium salts (e.g., those described, for example, in U.S. Patent 4,743,528, JP-A-63-138345, JP-A-63-142345, JP-A-63-142346 and JP-B-46-42363, specifically, e.g., 1-methoxy-4-phenylpyridinium tetrafluoroborate), and compounds described in JP-B-52-14727, JP-B-52-14728 and JP-B-52-14729 are preferably used. As the active species, a radical or an acid is generated.

The organic peroxide (c) includes almost all organic compounds having one or more oxygen-oxygen bonds in the molecules thereof, and preferred examples thereof include peroxide esters, for example, 3,3',4,4'-tetra(tert-butylperoxycarbonyl)benzophenone, 3,3',4,4'-tetra(tert-amylperoxycarbonyl)benzophenone, 3,3',4,4'-tetra(tert-hexylperoxycarbonyl)benzophenone, 3,3',4,4'-tetra(tert-octylperoxycarbonyl)benzophenone, 3,3',4,4'-tetra(cumylperoxycarbonyl)benzophenone, 3,3',4,4'-tetra(p-isopropylcumylperoxycarbonyl)benzophenone and di-tert-butyldiperoxy isophthalate.

The hexaarylbiimidazole compound (d) includes, for example, lophine dimers described in JP-B-45-37377 and JP-B-44-86516, specifically, for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The ketoxime ester compound (e) includes, for example, 3-benzoyloxyiminobutan-2-one, 3-acetoxyiminobutan-2-one, 3-propyonyloxyiminobutan-2-one, 2-acetoxyiminopentan-3-one, 2-acetoxyimino-1-phenylpropan-1-one, 2-benzoyloxyimino-1-phenylpropan-1-one, 3-p-toluenesulfonyloxyiminobutan-2-one and 2-ethoxycarbonyloxyimino-1-phenylpropan-1-one,

The borate compound (f) as other example of the photopolymerization initiator in the invention includes compounds described in U.S. Patents 3,567,453 and 4,343,891, European Patents 109,772 and 109,773.

The azinium compound (g) as other example of the photopolymerization initiator includes compounds having N-O bond described in JP-A-63-138345, JP-A-63-142345, JP-A-63-142346, JP-A-63-143537 and JP-B-46-42363.

The metallocene compound (h) as other example of the photopolymerization initiator includes titanocene compounds described in JP-A-59-152396, JP-A-61-151197, JP-A-63-41484, JP-A-2-249 and JP-A-2-4705, and iron-arene complexes described in JP-A-1-304453 and JP-A-1-152109.

Specific examples of the titanocene compound include dicyclopentadienyl-Ti-dichloride, dicyclopentadienyl-Ti-biphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,3,5,6-tetrafluorophen-1-yl, dimethylcyclopentadienyl-Ti-bis-2,4-difluorophen-1-yl, bis(cyclopentadienyl)bis[2,6-difluoro-3-(pyr-1-yl)phenyl]titanium, bis(cyclopentadienyl)bis[2,6-difluoro-3-(methylsulfonamido)phenyl]titanium and bis(cyclopentadienyl)bis[2,6-difluoro-3-(N-butylpivaloylamino)phenyl]titanium.

The active ester compound (i) includes, for example, nitrobenzyl ester compounds described in European Patents 290,750, 46,083, 156,153, 271,851 and 388,343, U.S. Patents 3,901,710 and 4,181,531, JP-A-60-198538 and JP-A-53-133022, iminosulfonate compounds described in European Patents 199,672, 84,515, 199,672, 44,115 and 101,122, U.S. Patents 4,618,564, 4,371,605 and 4,431,774, JP-A-64-18143, JP-A-2-245756 and JP-A-4-365048, and compounds described in JP-B-62-6223, JP-B-63-14340 and JP-A-59-174831.

The compound having a carbon-halogen bond (j) preferably includes, for example, compounds described in Wakabayashi et al., Bull. Chem. Soc. Japan, 42, 2924 (1969), compounds described in British Patent 1,388,492, compounds described in JP-A-53-133428, and compounds described in German Patent 3,337,024.

Further, compounds described in F.C. Schaefer et al., J. Org. Chem.,29, 1527 (1964), compounds described in JP-A-62-58241 and compounds described in JP-A-5-281728 are exemplified. Moreover, compounds described in German Patent 2,641,100, compounds described in German Patent 3,333,450, compounds described in German Patent 3,021,590 and compounds described in German Patent 3,021,599 are exemplified.

Specific preferred examples of the compounds (a) to (j) include those described below.

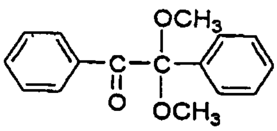
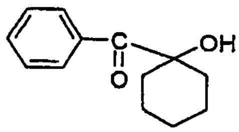
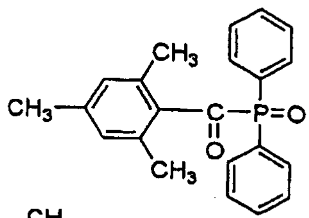
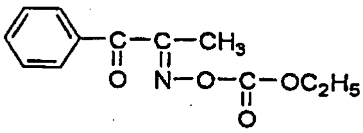
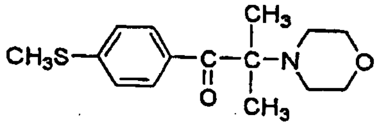
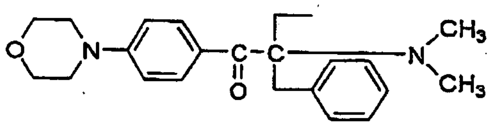
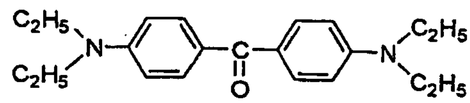
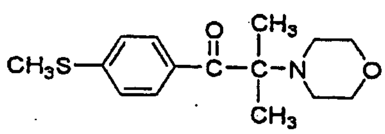
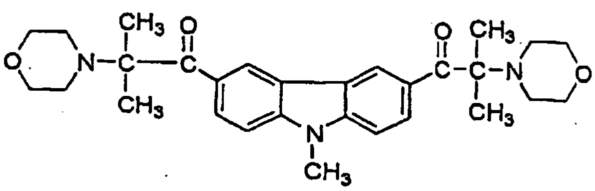
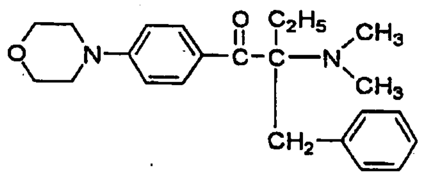

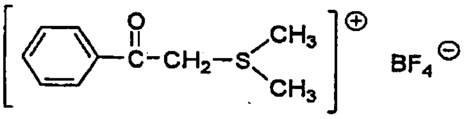

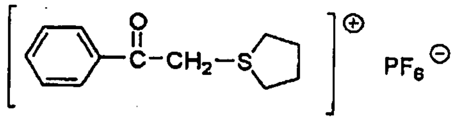

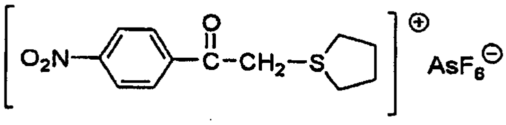

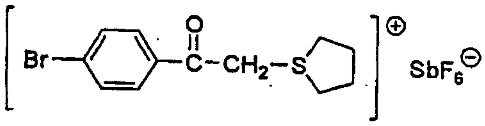

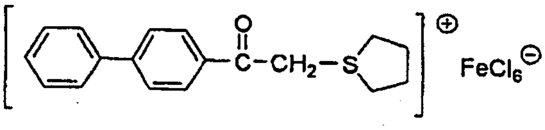

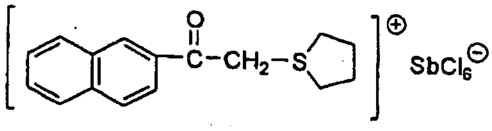

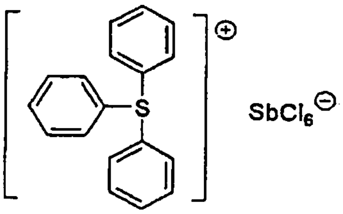

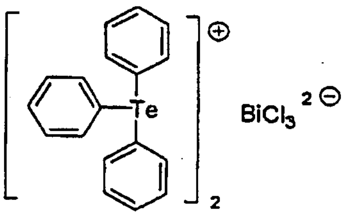

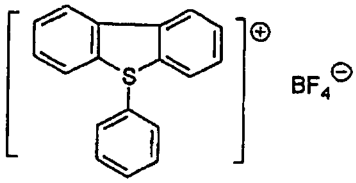

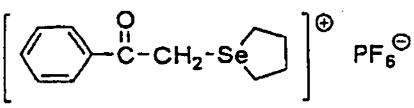

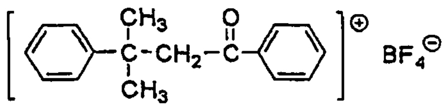

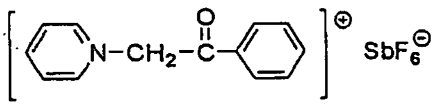

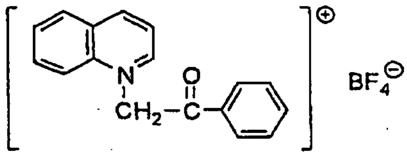

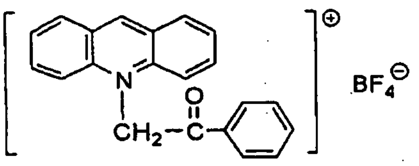

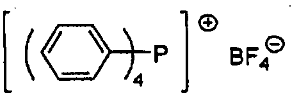

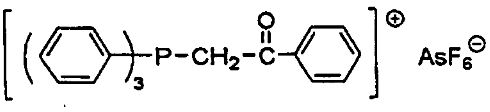

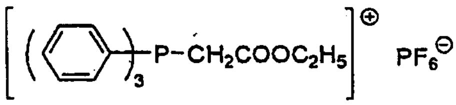

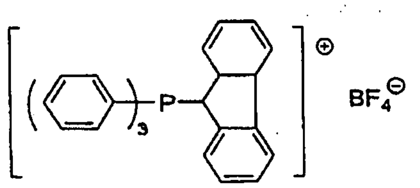
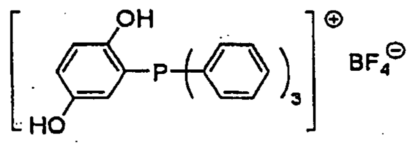

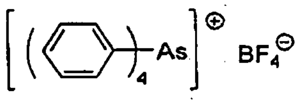
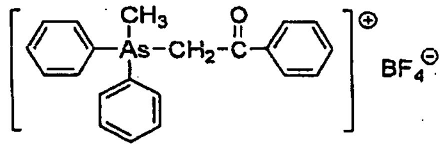

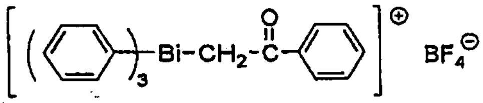
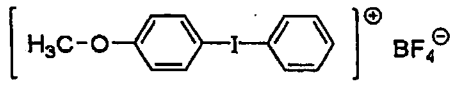

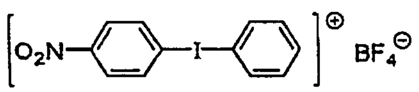
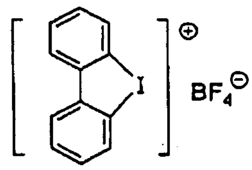

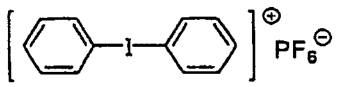
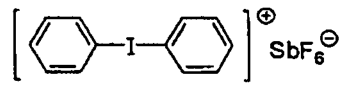

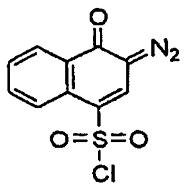
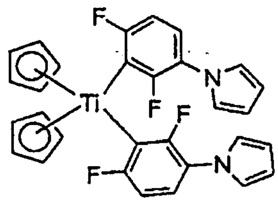
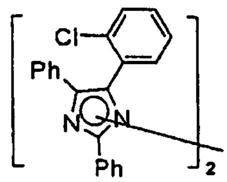

Of the photopolymerization initiators, the titanocene compound is particularly preferred in view of the improvement in sensitivity because it is apt to coordinate with the benzotriazole compound or sulfone compound described above to form the highly active species.

Like the foregoing sensitizing dye, the photopolymerization initiator can be subjected to various chemical modifications for further improving characteristics of the light-sensitive layer. There may be employed techniques, for example, connection to the sensitizing dye or to the addition polymerizable unsaturated compound or other radical-generating part, introduction of a hydrophilic moiety, introduction of a substituent for improving compatibility or depressing deposition of crystals, introduction of a substituent for improving adhesion property, and polymerization.

Regarding the method of using the photopolymerization initiator, a suitable method can be appropriately selected depending upon the designed performance of the light-sensitive material similar to the addition polymerizable compound described hereinafter and the sensitizing dye described hereinbefore. For example, compatibility with the light-sensitive layer can be enhanced by using two or more photopolymerization initiators in combination.

Regarding the amount of the photopolymerization initiator used, an increased amount of the photopolymerization initiator usually provides more advantages in view of light sensitivity. A sufficient light sensitivity can be obtained by using the photopolymerization initiator in an amount of from 0.5 to 80 parts by weight, preferably from 1 to 50 parts by weight, per 100 parts by weight of the component of the polymerizable composition. On the other hand, in consideration

of the objects of the invention, the amount of the photopolymerization initiator is preferably small. By using the photopolymerization initiator in combination with the sensitizing dye, a sufficient light sensitivity can be obtained even when the amount of the photopolymerization initiator is reduced to as small as 30 parts by weight or less, further 25 parts by weight or less, still further 20 parts by weight or less, per 100 parts by weight of the component of the polymerizable composition.

One of the characteristic features of the photoinitiation system for use in the preferable embodiment of the present invention is to have excellent photosensitive property in the region of 350 to 450 nm. The photoinitiation system containing a titanocene compound for use in the preferable embodiment of the present invention is useful as a photopolymerizable composition for scan exposure and this is described, for example, JP-B-4-47680. The titanocene compound has absorption in the wavelength region of 350 to 450 nm and therefore, efficiently causes decomposition upon exposure with light in the short-wavelength region from 350 to 450 nm, but the titanocene compound does not show sufficiently high photosensitivity by itself. The present inventors have found that when an N-oxyamide compound having a specific structure is allowed to coexit with a photopolymerization initiator such as a titanocene compound, the photosensitivity of the photopolymerization initiator such as a titanocene compound can be enhanced. The reasons therefor are not clearly known, but it is considered that the N-oxyamide compound of the present invention interacts with the photopolymerization initiator such as a titanocene compound upon exposure and decomposes to newly produce a radical and this contributes to the elevation of photosensitivity. Furthermore, a sensitizing dye for example having absorption in the wavelength region of 350 to 450 nm may be arbitrarily caused to coexist in the photoinitiation system of the present invention. In order to realize sufficiently high sensitivity for scan exposure, a sensitizing dye is preferably caused to coexist in the photoinitiation system.

(A1) N-Oxyamide Compound

The N-oxyamide compound for use in the present invention is a compound represented by the following formula (1):

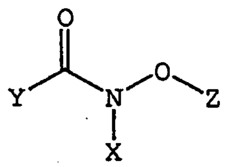

(1)

(wherein X, Y and Z each independently represents a monovalent substituent, provided that X and Y, Y and Z or X and Z may combine with each other to form a ring).

Specific examples of X in formula (1) include a hydrogen atom, an alkyl group, a substituted alkyl group, an aryl group, a substituted aryl group, an alkenyl group, a substituted alkenyl group, an alkynyl group, a substituted alkynyl group, a substituted carbonyl group, a substituted sulfinyl group and a substituted sulfonyl group.

Specific examples of Z in formula (1) include a hydrogen atom, an alkyl group, a substituted alkyl group, an aryl group, a substituted aryl group, an alkenyl group, a substituted alkenyl group, an alkynyl group, a substituted alkynyl group, a substituted carbonyl group, a substituted sulfinyl group, a substituted sulfonyl group and a silyl group.

Specific examples of Y in formula (1) include a hydrogen atom, an alkyl group, a substituted alkyl group, an aryl group, a substituted aryl group, an alkenyl group, a substituted alkenyl group, an alkynyl group, a substituted alkynyl group, a substituted carbonyl group, a substituted oxy group, a substituted thio group and a substituted amino group.

Specific examples of these substituents include the followings.

The alkyl group includes a linear, branched or cyclic alkyl group having from 1 to 20 carbon atoms, and specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among these, preferred are a linear alkyl group having from 1 to 12 carbon atoms, a branched alkyl group having from 3 to 12 carbon atoms and a cyclic alkyl group having from 5 to 10 carbon atoms.

The substituted alkyl group is a group constituted by the bonding of a substituent and an alkylene group. The substituent is a monovalent nonmetallic atom group (monovalent nonmetallic atomic group) excluding hydrogen, and preferred examples thereof include a halogen atom (e.g., -F, - Br, -Cl, -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy goup,

an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-allrylureido group, an N'-alkyl-N-arylureido group, an N',N'-dialkyl-N-alkylureido group, an N',N'-dialkyl-N-arylureido group, an N'-azyl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group and a conjugate base group thereof (hereinafter referred to as a "carboxylato"), an alkoxycarbonyl group, an aryloxycarbonyl group, a carbamoyl group, an N-alkylcarbamoyl goup, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo ($-SO_3H$) group and a conjugate base group thereof (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group ($-SO_2NHSO_2$(alkyl)) and a conjugate base group thereof, an N-arylsulfonylsulfamoyl group ($-SO_2NHSO_2$(allyl)) and a conjugate base group thereof, an N-alkylsulfonylcarbamoyl group ($-CONHSO_2$(alkyl)) and a conjugate base group thereof, an N-arylsulfonylcarbamoyl group ($-CONHSO_2$(allyl)) and a conjugate base group thereof, an alkoxysilyl group ($-Si(O\text{-alkyl})_3$), an aryloxysilyl group ($-Si(O\text{-aryl})_3$), a hydroxysilyl group ($-Si(OH)_3$) and a conjugate base group thereof, a phosphono group ($-PO_3H_2$) and a conjugate base group thereof (hereinafter referred to as a "phosphonato goup"), a dialkylphosphono group ($-PO_3(\text{alkyl})_2$), a diarylphosphono group ($-PO_3(\text{aryl})_2$), an alkylarylphosphono group ($-PO_3$(alkyl)(aryl)), a monoalkylphosphono group ($-PO_3H$(alkyl)) and a conjugate base group thereof (hereinafter referred to as an "alkylphosphonato group"), a monoarylphosphono group ($-PO_3H$(aryl)) and a conjugate base group thereof (hereinafter referred to as an "arylphosphonato group"), a phosphonoxy group ($-OPO_3H_2$) and a conjugate base group thereof (hereinafter referred to as a "phosphonatoxy group"), a dialkylphosphonoxy group ($-OPO_3(\text{alkyl})_2$), a diarylphosphonoxy group ($-OPO_3(\text{aryl})_2$), an alkylarylphosphonoxy group ($-OPO_3$(alkyl)(aryl)), a monoalkylphosphonoxy group ($-OPO_3H$(alkyl)) and a conjugate base group thereof (hereinafter referred to as an "alkylphosphonatoxy group"), a monoarylphosphonoxy group ($-OPO_3H$(aryl)) and a conjugate base group thereof (hereinafter referred to as an "arylphosphonatoxy group"), a cyano group, a nitro group, an aryl group, an alkenyl group and an alkynyl group.

Specific examples of the alkyl group in these substituents include those described above; specific examples of the aryl group include a phenyl group, a biphenyl group, a naphthyl group, a tolyl group, a xylyl group, a mesityl group, a cumenyl group, a fluorophenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a phenyl group, a nitrophenyl group, a cyanophenyl group, a sulfophenyl group, a sulfonatophenyl group, a phosphonophenyl group and phosphonatophenyl group; specific examples of the alkenyl group include a vinyl group, a 1-propenyl group, a 1-butenyl group, a cinnamyl group and a 2-chloro-1-ethenyl group; and specific examples of the alkynyl group include an ethynyl group, a 1-propynyl group, a 1-butynyl group, a trimethylsilylethynyl group and a phenylethynyl group.

Examples of the acyl group ($R^{4}$'CO-) include those where $R^{4}$' is a hydrogen atom or the above-described alkyl, aryl, alkenyl or alkynyl group.

The alkylene group in the substituted alkyl group includes a divalent organic residue obtained by eliminating any one hydrogen atom on the above-described alkyl group having from I to 20 carbon atoms, and the alkylene group is preferably a linear alkylene group having from 1 to 12 carbon atoms, a branched alkylene group having from 3 to 12 carbon atoms or a cyclic alkylene group having from 5 to 10 carbon atoms.

Specific preferred examples of the substituted alkyl group include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, a methoxycarbonylmethyl group, a methoxycarbonylbutyl group, an ethoxycarbonylmethyl group, a butoxycarbonylmethyl group, an allyloxycarbonylmethyl group, a benzyloxycarbonylmethyl group, a methoxycarbonylphenylmethyl group, a trichloromethylcarbonylmethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfopropyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopmpyl group, a methylphosphonobutyl group, a methylphosphonatobutyl group, a tolylphosphonohexyl group, a tolylphosphonatohexyl group, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl- group, a 2-methylpropenylmethyl group, a 2-propynyl group, a 2-butynyl group, a 3-butynyl group and the following groups:

$CH_3CONHSO_2CH_2CH_2CH_2CH_2$-,

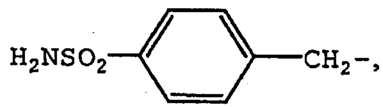

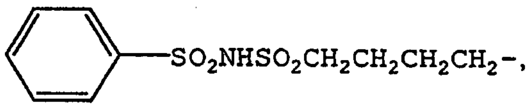

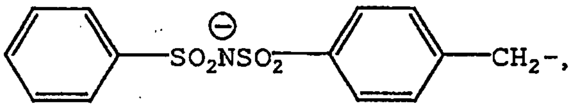

$HS$-$CH_2CH_2CH_2CH_2$-,

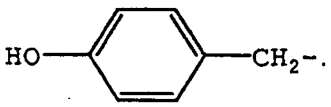

The aryl group includes a condensed ring formed by 1 to 3 benzene rings and a condensed ring formed by a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among these, preferred are a phenyl group and a naphthyl group.

The substituted aryl group is a group constituted by bonding a substituent to an aryl group and includes those described above as the aryl group in which a monovalent nonmetallic atom group excluding hydrogen is present as a substituent on the ring-forming carbon atom. Preferred examples of the substituent include the above-described alkyl group and substituted alkyl group and also include the substituents described above for the substituted alkyl group.

Specific preferred examples of the substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, a phenylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propynylphenyl group, a 2-butynylphenyl group, a 3-butynylphenyl group, a tetrachlorophenyl group, a tetrabromophenyl group and a tetrafluorophenyl group.

Examples of the alkenyl group include a vinyl group, a 1-propenyl group, a 1-butenyl group, a cinnamyl group

and a 2-chloro-1-ethenyl group, and examples of the alkynyl group include an ethynyl group, a 1-propynyl group, a 1-butynyl group and a trimethylsilylethynyl group.

The substituted alkenyl group is a group constituted by replacing a hydrogen atom of the alkenyl group with a substituent. The substituent may be the above-described substituent for the substituted alkyl group, and the alkenyl group may be the above-described alkenyl group. Preferred examples of the substituted alkenyl group include the following groups:

$CH_3O_2CCH_2CH{=}CHCH_2$-, 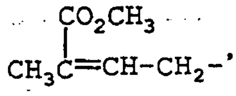

$HO_2CCH_2CH{=}CHCH_2$-, 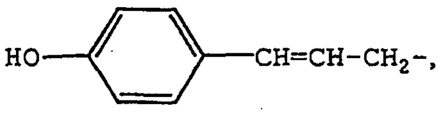

$CH_2{=}CH{-}{-}CH{=}CH{-}{-}CH_2$-, Cl--$CH_2CH{=}CHCH_2$-,

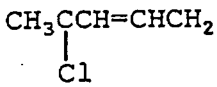 , 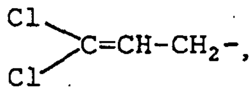

HS--$CH_2CH{=}CHCH_2$-.

The substituted alkynyl group is a group constituted by replacing a hydrogen atom of the alkynyl group with a substituent. The substituent may be the above-described substituent for the substituted alkyl group, and the alkynyl group may be the above-described alkynyl group.

The halogen atom is preferably a fluorine atom, a chlorine atom, a bromine atom or an iodine atom.

As for the substituted oxy group, for example, a group represented by $R^{14}O$- where $R^{14}$ is a monovalent nonmetallic atom group excluding hydrogen, may be used. Preferred examples of the substituted oxy group include an alkoxy group, an aryloxy group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, a phosphonoxy group and a phosphonatoxy group. Examples of the alkyl group and aryl group in these groups include those described above as the alkyl group, substituted alkyl group, aryl group and substituted aryl group. The acyl group ($R^{15}CO$-) in the acyloxy group include those where $R^{15}$ is the above-described alkyl group, substituted alkyl group, aryl group or substituted aryl group. Among those substituted oxy groups, more preferred are an alkoxy group, an aryloxy group, an acyloxy group and an arylsulfoxy group.

Specific preferred examples of the substituted oxy group include a methoxy group, an ethoxy group, a propyloxy group, an isopropyloxy group, a butyloxy group, a pentyloxy group, a hexyloxy group, a dodecyloxy group, a benzyloxy group, an allyloxy group, a phenethyloxy group, a carboxyethyloxy group, a methoxycarbonylethyloxy group, an ethoxycarbonylethyloxy group, a methoxyethoxy group, a phenoxyethoxy group, a methoxyethoxyethoxy group, an ethoxyethoxyethoxy group, a morpholinoethoxy group, a morpholinopropyloxy group, an allyloxyethoxyethoxy group, a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, an acetyloxy group, a benzoyloxy group, a naphthyloxy group, a phenylsulfonyloxy group, a phosphonoxy group and a phosphonatoxy group.

As for the substituted thio group, a group represented by $R^{16}S$- where $R^{16}$ is a monovalent nonmetallic atom group excluding a hydrogen atom, may be used. Preferred examples of the substituted thio group include an alkylthio group, an arylthio group, an alkyldithio group, an aryldithio group and an acylthio group. Examples of the alkyl group and aryl group in these groups include those described above as the alkyl group, substituted alkyl group, aryl group and substituted aryl group. $R^{15}$ of the acyl group ($R^{15}CO$-) in the acylthio group has the same meaning as above. Among those substituted thio groups, preferred are an alkylthio group and an arylthio group. Specific preferred examples of the substituted thio group include a methylthio group, an ethylthio group, a phenylthio group, an ethoxyethylthio group, a carboxyethylthio group and a methoxycarbonylthio group.

As for the substituted amino group, a group represented by $R^{17}$NH- or ($R^{18}$)($R^{19}$)N- where $R^{17}$, $R^{18}$ and $R^{19}$ each is a monovalent nonmetallic atom group excluding a hydrogen atom, may be used. Preferred examples of the substituted amino group include an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group an aryloxycarbonylamino group, an N-alkyl-N-alkoxycarbonylamino group, an N-alkyl-N-aryloxycarbonylamino group, an N-aryl-N-alkoxycarbonylamino group and an N-aryl-N-aryloxycarbonylamino group. Examples of the alkyl group and aryl group in these groups include those described above as the alkyl group, substituted alkyl group, aryl group and substituted aryl group. $R^{15}$ of the acyl group ($R^{15}$CO-) in the acylamino group, N-alkylacylamino group and N-arylacylamino group has the same meaning as above.

Among those substituted amino groups, more preferred are an N-alkylamino group, an N,N-dialkylamino group, an N-arylamino group and an acylamino group. Specific preferred examples of the substituted amino group include a methylamino group, an ethylamino group, a diethylamino group, a morpholino group, a piperidino group, a pyrrolidino group, a phenylamino group, a benzoylamino group and an acetylamino group.

As for the substituted carbonyl group, a group represented by $R^{20}$-CO- where $R^{20}$ is a monovalent nonmetallic atom group, may be used. Preferred examples of the substituted carbonyl group include a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group and an N-alkyl-N-arylcarbamoyl group. Examples of the alkyl group and aryl group in these groups include those described above as the alkyl group, substituted alkyl group, aryl group and substituted aryl group above.

Among these substituents, more preferred are a formyl group, an acyl group, a carboxyl group, an alkoxycarbonyl group, an aryloxycarbonyl group, a carbamoyl group, an N-alkylcarbamoyl group, an N',N-dialkylcarbamoyl group and an N-arylcarbamoyl group, and still more preferred are a formyl group, an acyl group, an alkoxycarbonyl group and an aryloxycarbonyl group. Specific preferred examples of the substituted carbonyl group include a formyl group, an acetyl group, a benzoyl group, a carboxyl group, a methoxycarbonyl group, an allyloxycarbonyl group, an N-methylcarbamoyl group, an N-phenylcarbamoyl group, an N,N-diethylcarbamoyl group and a morpholinocarbonyl group.

As for the substituted sulfinyl group, a group represented by $R^{21}$-SO- where $R^{21}$ is a monovalent nonmetallic atom group, may be used. Preferred examples thereof include an alkylsulfinyl group, an arylsulfinyl group, a sulfinamoyl group, an N-alkylsulfinamoyl group, an N,N-dialkylsulfinamoyl group, an N-arylsulfinamoyl group, an N,N-diarylsulfinamoyl group and an N-alkyl-N-arylsulfinamoyl group. Examples of the alkyl group and aryl group in these groups include those described above as the alkyl group, substituted alkyl group, aryl group and substituted aryl group above. Among the above-described substituted sulfinyl groups, more preferred are an alkylsulfinyl group and an arylsulfinyl group. Specific examples of the substituted sulfinyl group include a hexylsulfinyl group, a benzylsulfinyl group and a tolylsulfinyl group.

As for the substituted sulfonyl group, a group represented by $R^{25}$-$SO_2$- where $R^{25}$ is a monovalent nonmetallic atom group, may be used. Preferred examples thereof include an alkylsulfonyl group and an arylsulfonyl group. Examples of the alkyl group and aryl group in these groups include those described above as the alkyl group, substituted alkyl group, aryl group and substituted aryl group. Specific examples of the substituted sulfonyl group include a butylsulfonyl group and a chlorophenylsulfonyl group.

As for the silyl group, a group represented by ($R^{22}$)($R^{23}$)($R^{24}$)Si- where $R^{22}$, $R^{23}$ and $R^{24}$ each is a monovalent nonmetallic atom group, preferably the above-described alkyl group, substituted alkyl group, aryl group or substituted aryl group, may be used. Preferred Examples of the silyl group include a trimethylsilyl group, a tributylsilyl group, a tert-butyldimethylsilyl group and a dimethylphenylsilyl group.

These substituents each may further have a substituent, and specific examples thereof include the groups described as specific examples of X, Y and Z.

X, Y and Z may combine with each other to form a cyclic structure.

Examples of the cyclic structure formed when X and Y, Y and Z, or X and Z combine with each other include a saturated or unsaturated aliphatic ring. The aliphatic ring is preferably a 5-, 6-, 7- or 8-membered aliphatic ring formed in cooperation with the carbon atoms to which those substituents are bonded, more preferably a 5- or 6-membered aliphatic ring. In these aliphatic rings, a substituent may be present on the carbon atom constituting the ring (examples of the substituent include those described above as examples of the substituent in the substituted alkyl group), or a part of the ring-constituting carbons may be replaced with a heteroatom (e.g., oxygen, sulfur, nitrogen). Furthermore, a part of the aliphatic ring may form a part of an aromatic ring. Specific preferred examples thereof include a cyclopentane ring, a cyclohexane ring, a cycloheptane ring, a cyclooctane ring, a cyclo-1,3-dioxapentane ring, a cyclopentene ring, a

cyclohexene ring, a cycloheptene ring, a cyclooctene ring, a cyclo-1,3-dioxapentene ring, a cyclo-1,3-dioxahexene ring, a cyclohexadiene ring, a beazocyclohexene ring, a benzocyclohexadiene ring, a tetrahydropyranone ring, maleimide, succinimide, phthalimide, 1,2,3,6-tetrahydrophthalimide, 1,2-cyclohexanedicarboxyimide, 2,4,6-piperidinetrione and 1,4,5,6,7,7-hexachloro-5-norbornene-2,3-dicarboxyimide.

Examples of the aromatic ring formed when X and Y, Y and Z, or X and Z combine with each other include a quinolinc ring, an isoquinolinc ring, an acridinc ring, a phenanthridinc ring, a benzoquinoline ring and a benzoisoquinoline ring. Among these, a quinoline ring is preferred. Such an aromatic ring may have a substituent on the carbon atom constituting the ring (examples of the substituent include the above-described substituents on the substituted alkyl group).

Furthermore, these ring structures each may further have a substituent, and examples of the substituent include those described above as specific examples of X, Y and Z.

Specific examples of the compound represented by formula (1) for use in the present invention are set forth below, but the present invention is not limited thereto.

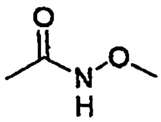 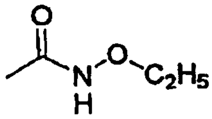 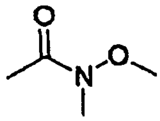 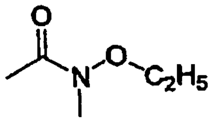

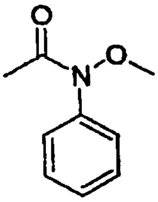 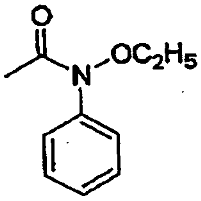 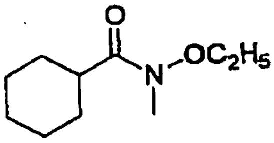 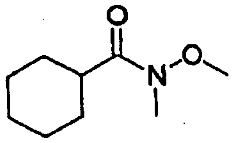

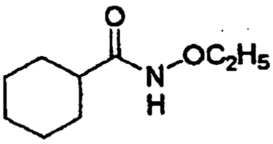 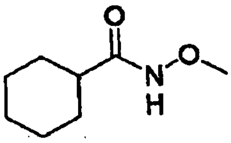 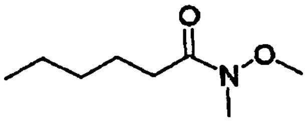

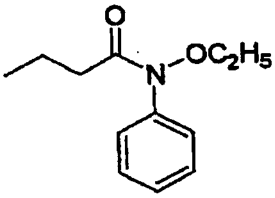 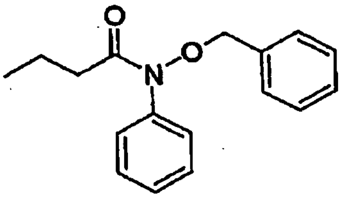 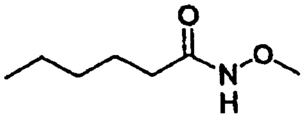

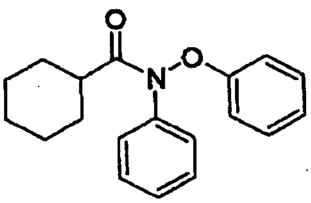 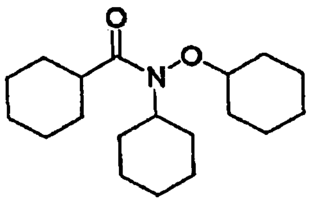 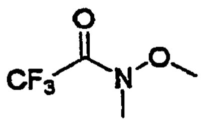

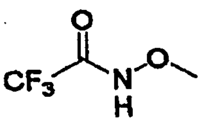 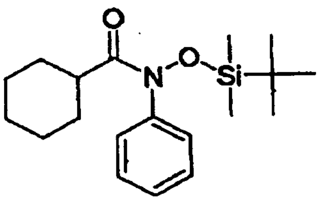 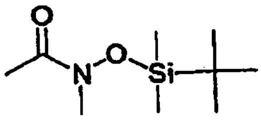

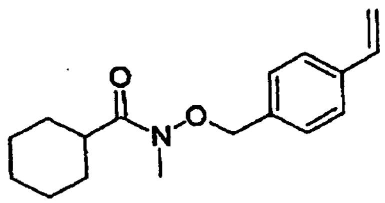
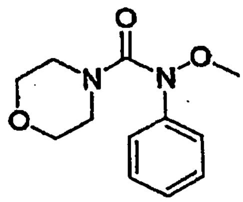
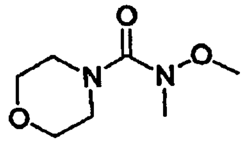

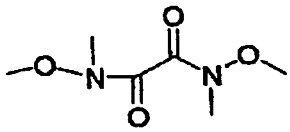
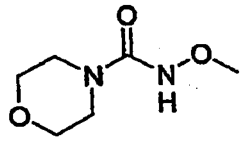

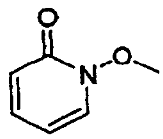
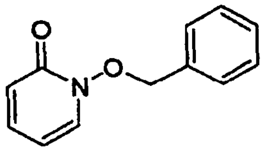
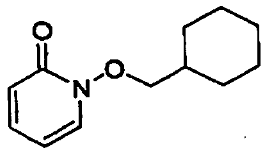

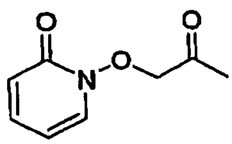
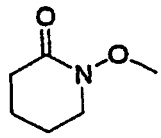
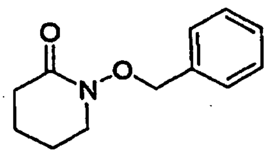
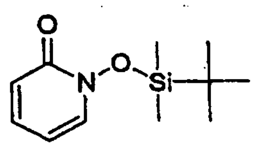

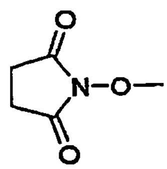
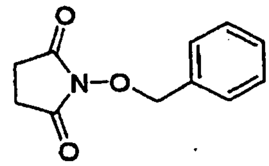
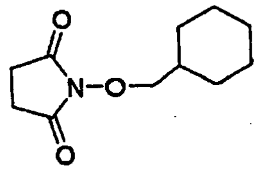

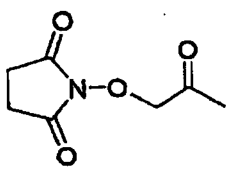
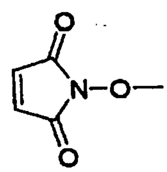
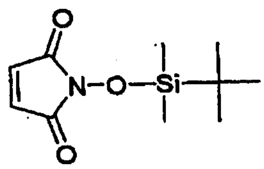
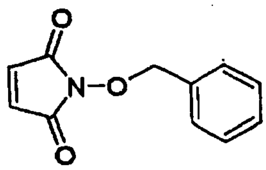

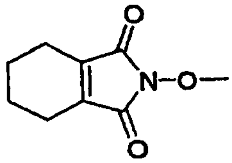

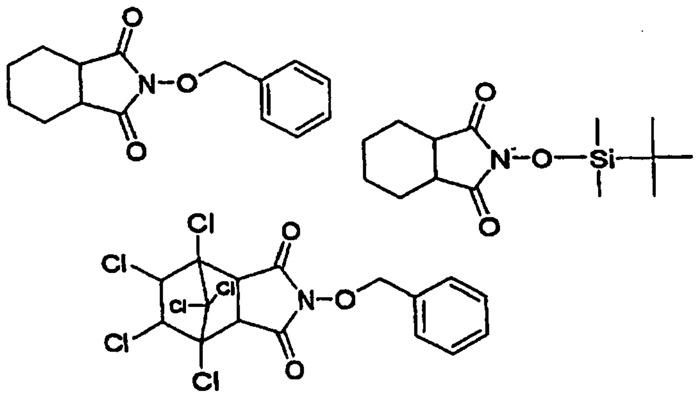

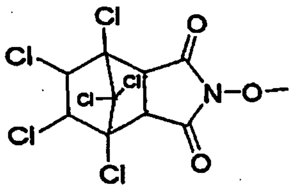

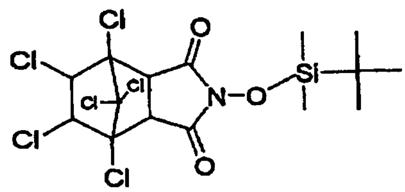

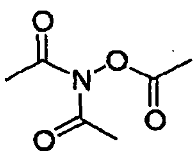

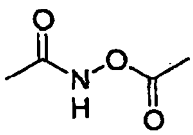

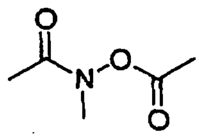

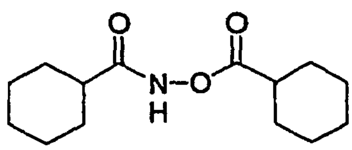

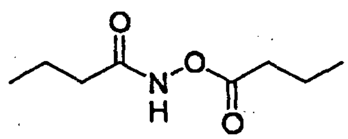

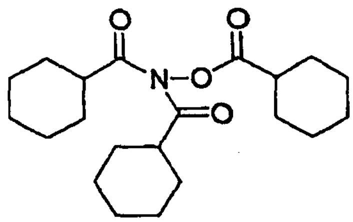

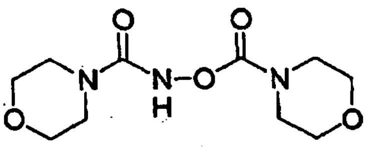

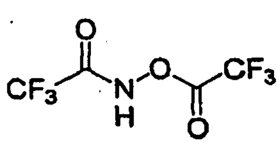

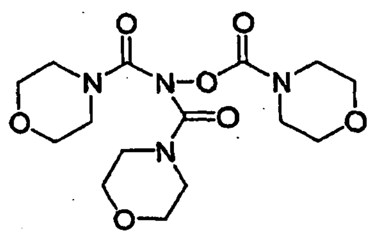

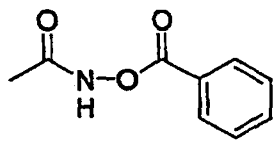

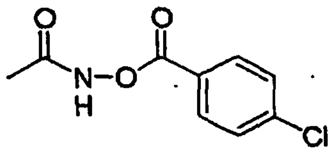 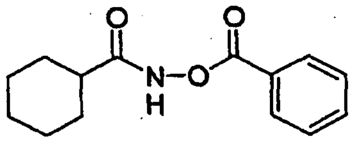 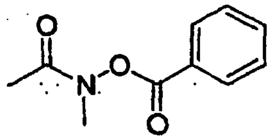

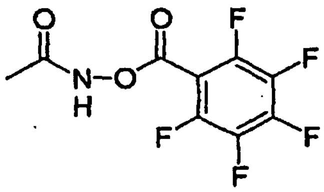 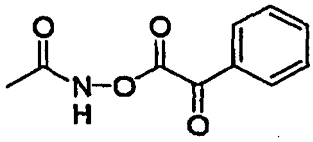

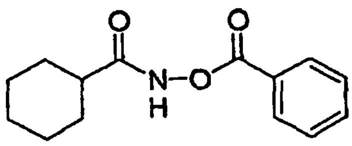 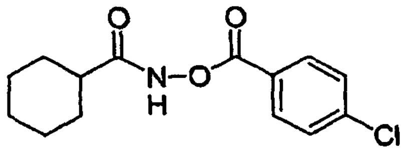

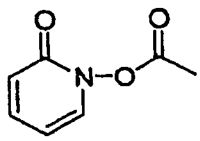 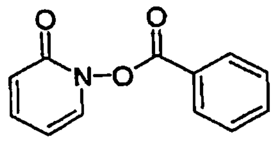 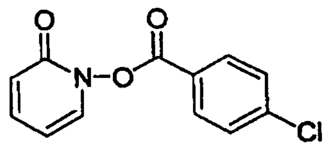

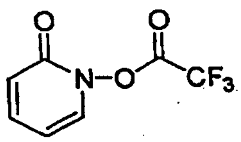 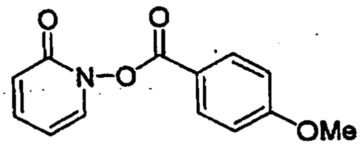 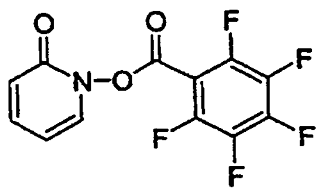

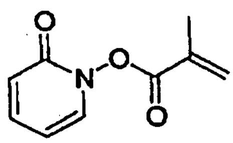 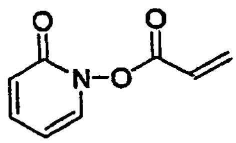 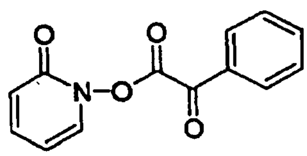

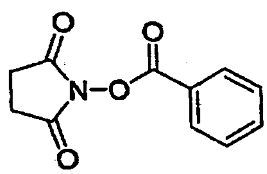 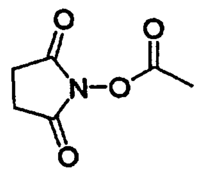 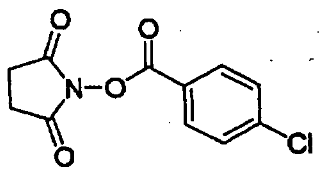

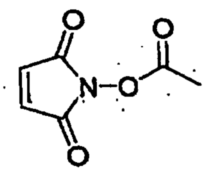
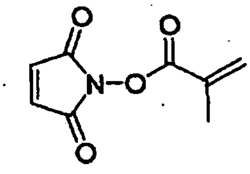
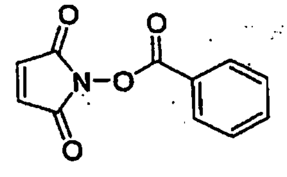

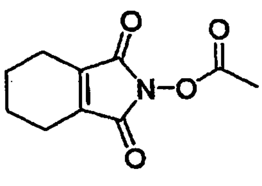
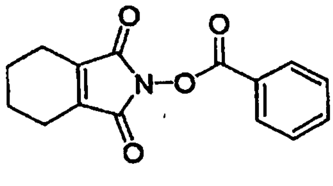
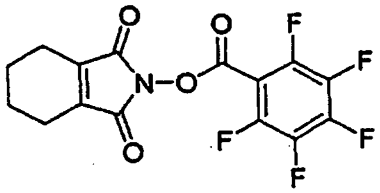

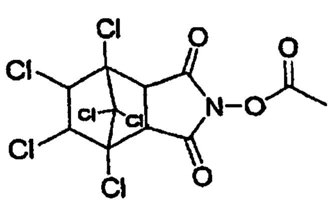
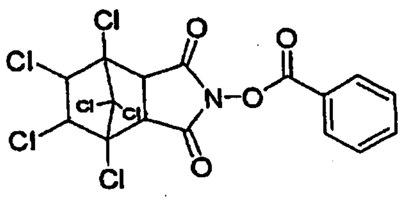

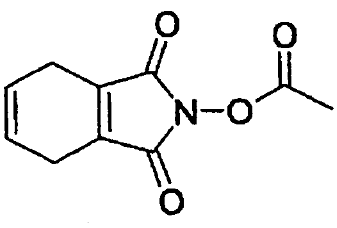
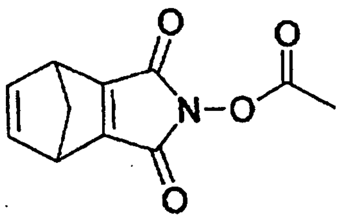

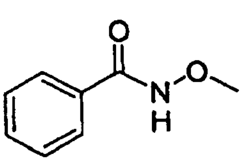
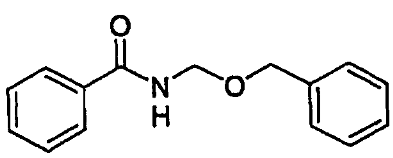
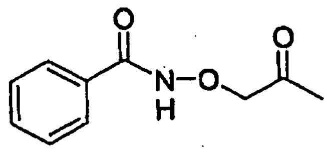

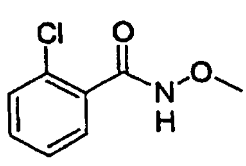
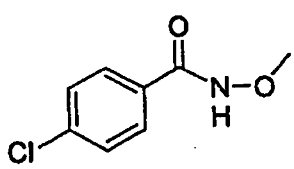
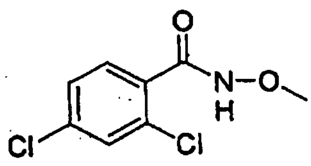

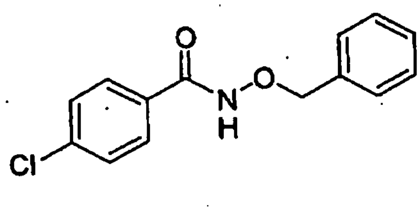
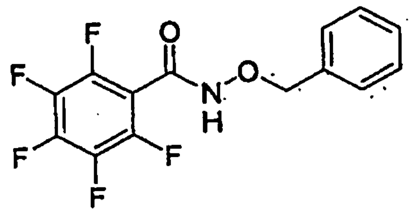

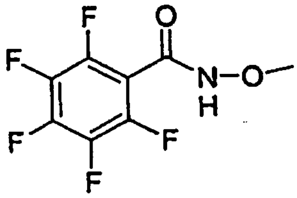 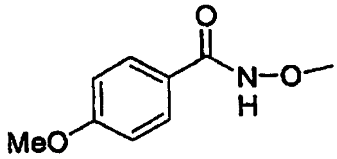

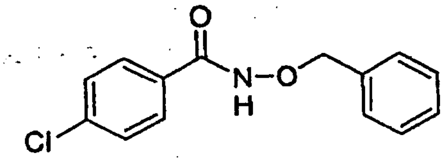 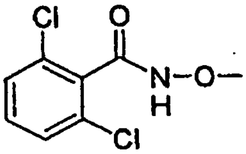

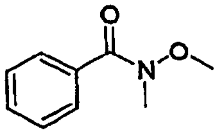 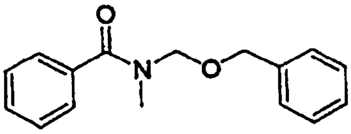 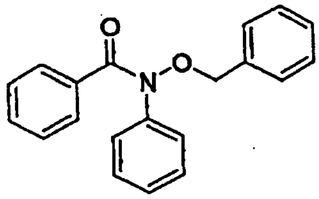

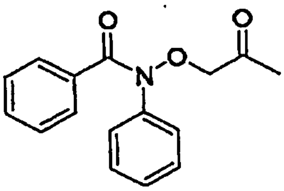 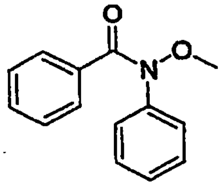 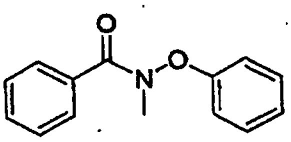

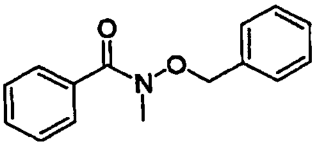 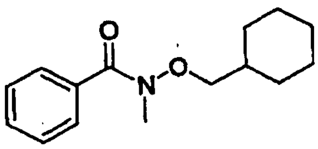 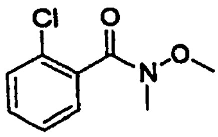

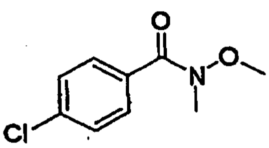 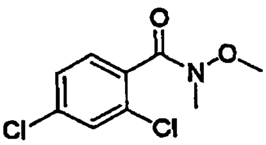 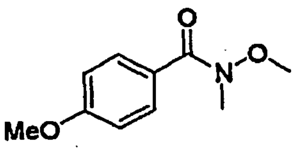

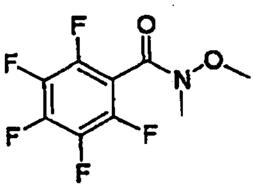 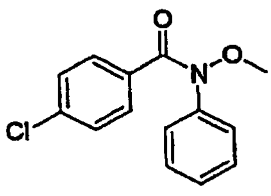 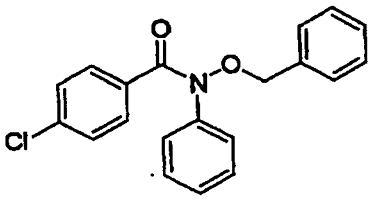

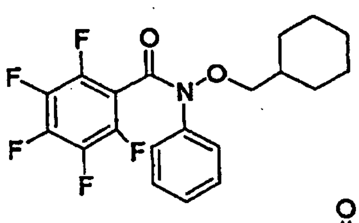
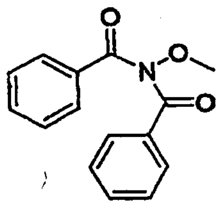
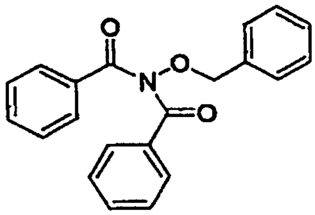
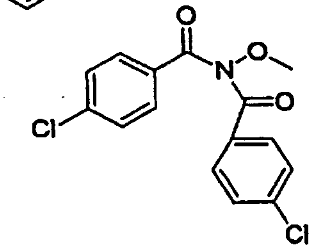
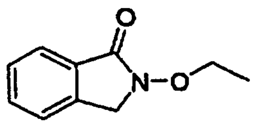

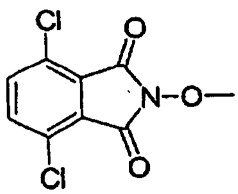
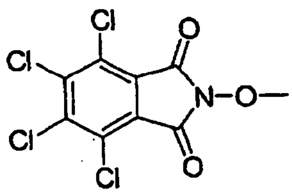
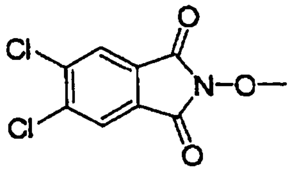

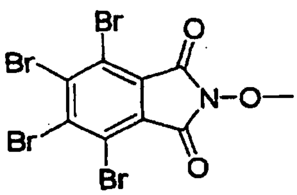
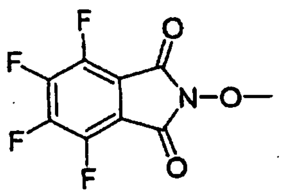
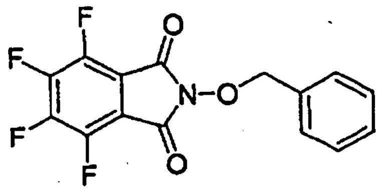

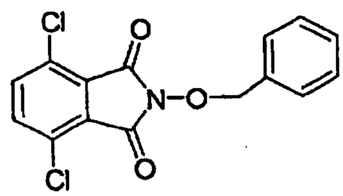
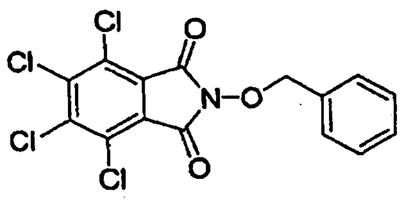

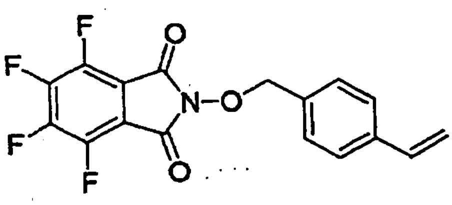
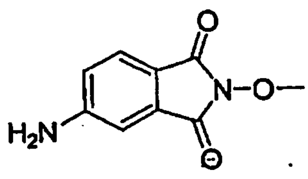

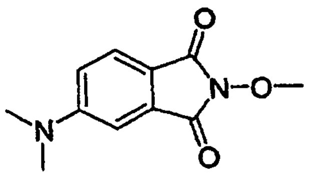
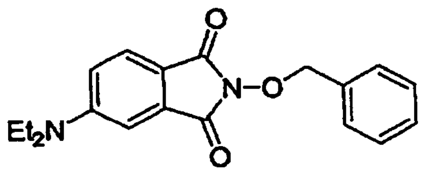

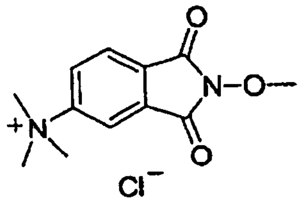
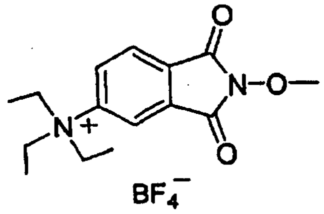

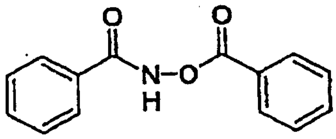
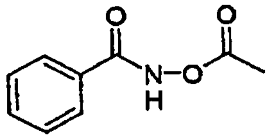
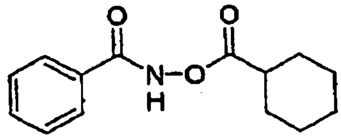

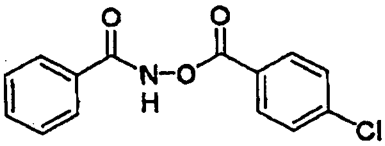
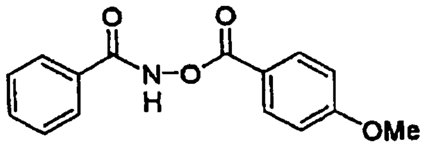

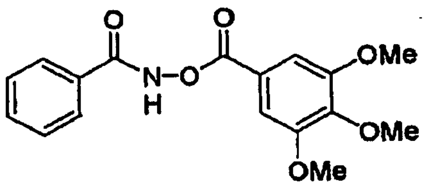
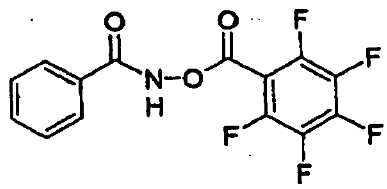

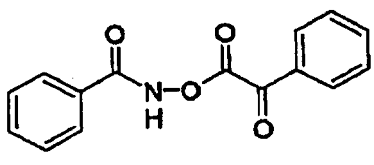
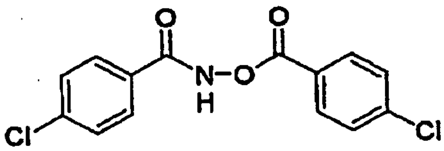

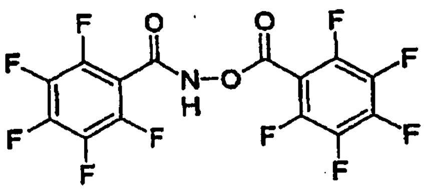
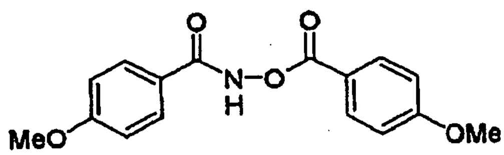

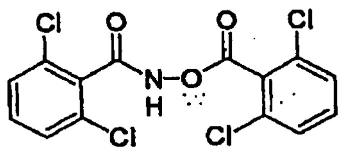

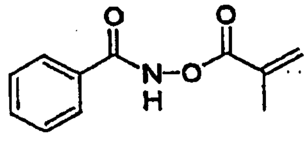

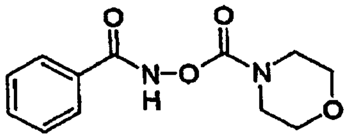

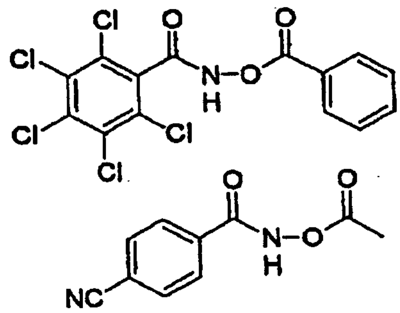

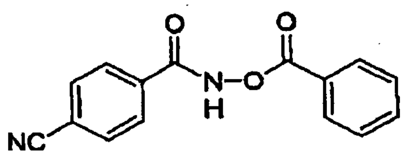

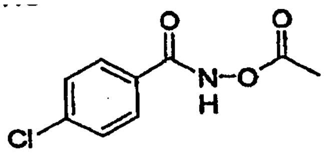

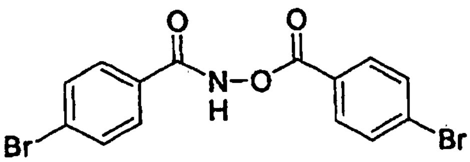

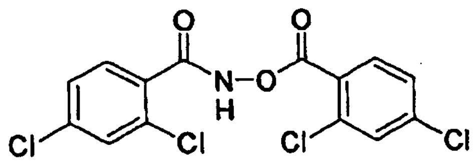

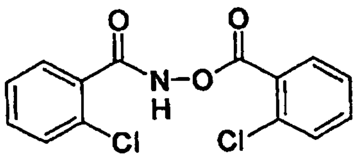

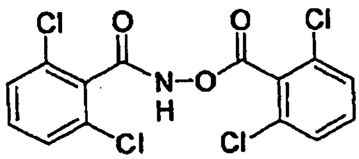

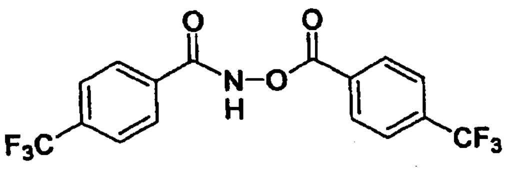

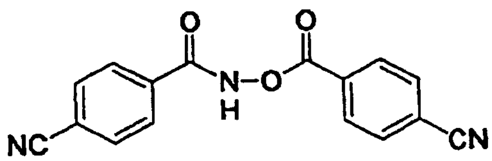

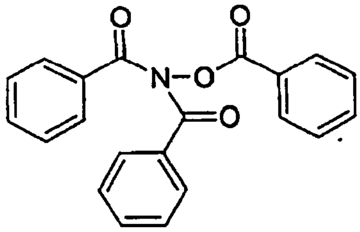

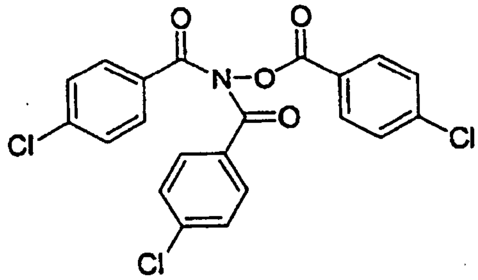

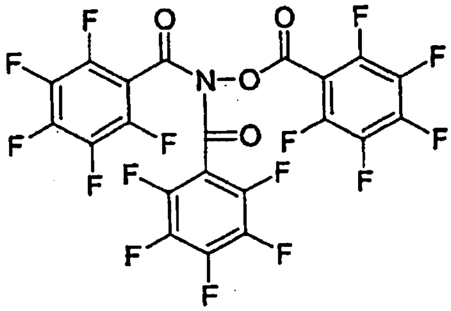

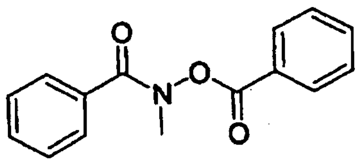

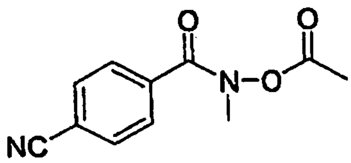

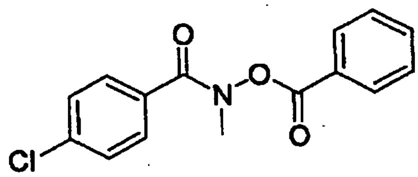

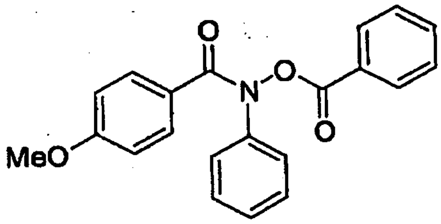

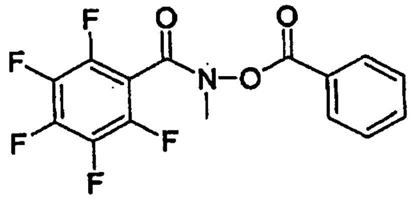

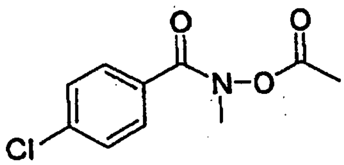

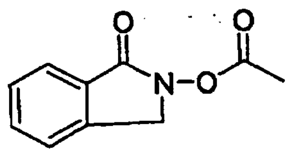

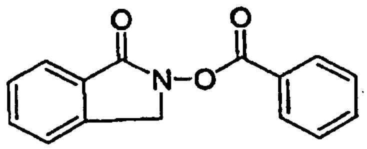

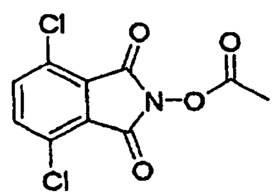
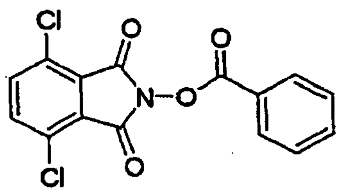
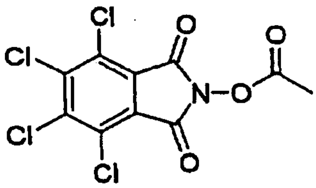

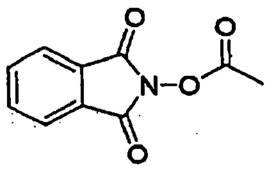
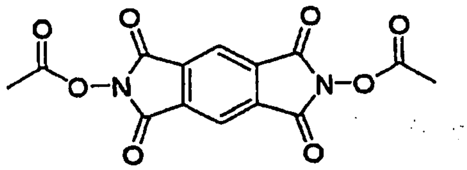

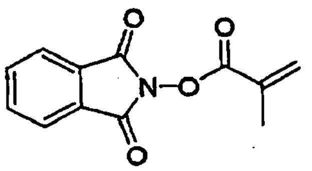
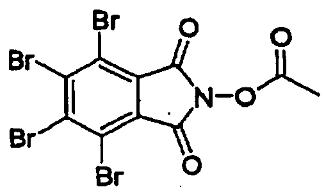
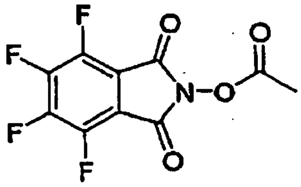

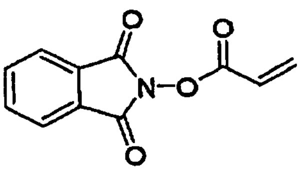
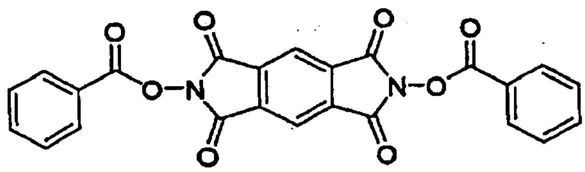

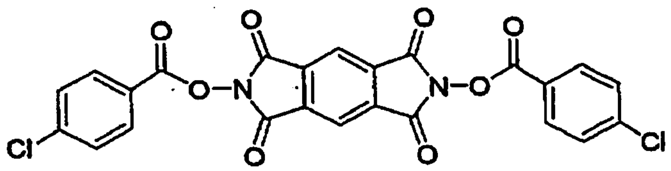

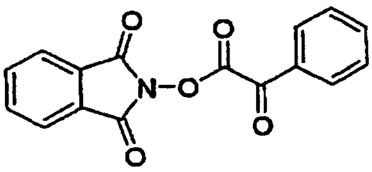
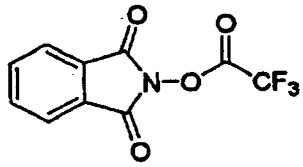

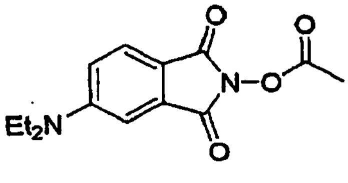
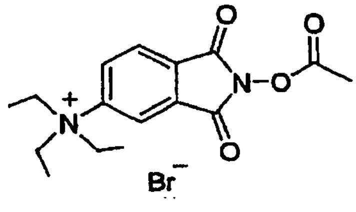

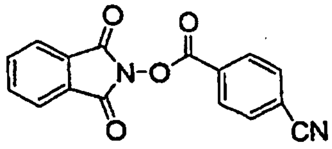
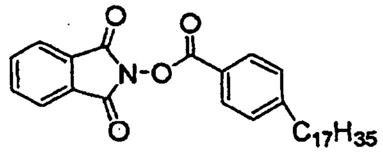

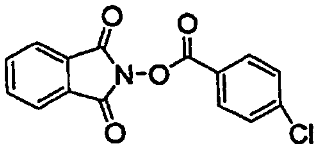
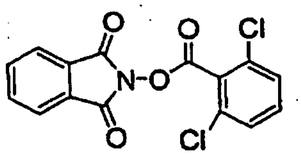

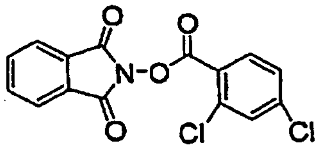
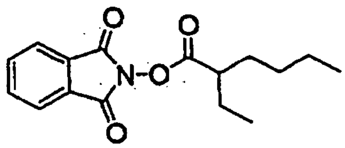

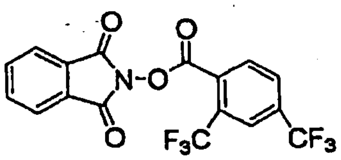
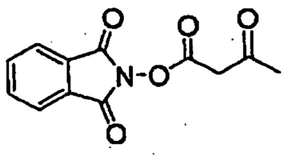
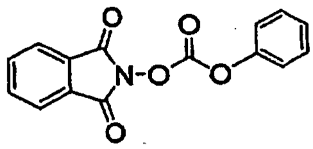

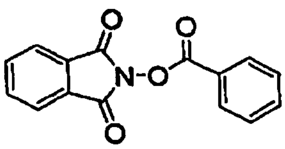
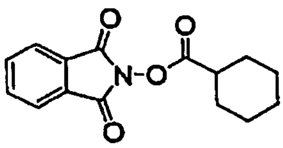
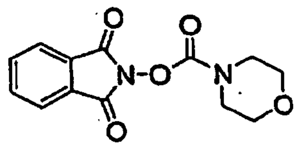

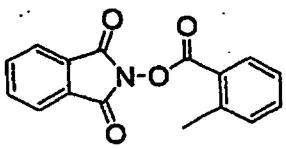
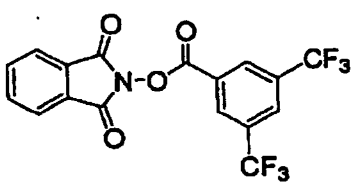
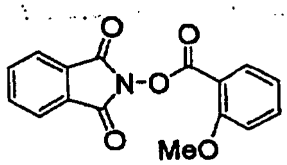

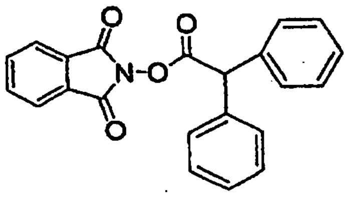
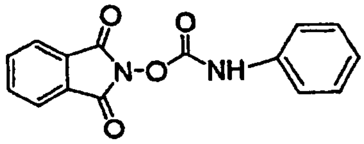

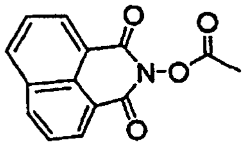

From the standpoint of enhancing the sensitivity, the compound represented by formula (1) is preferably a compound represented by formula (2):

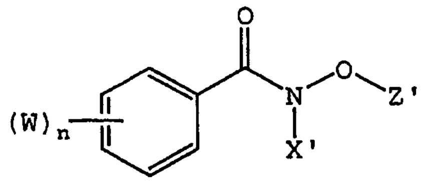

(2)

wherein X', W and Z' each independently represents a monovalent substituent, and n represents an integer of 1 to 5.

Specific examples of X' in formula (2) are the same as those of X above.

Specific examples of Z' in formula (2) are the same as those of Z above.

Specific examples of W in formula (2) include a hydrogen atom, a halogen atom, an alkyl group, a substituted alkyl group, an aryl group, a substituted aryl group, an alkenyl group, a substituted alkenyl group, an alkynyl group, a substituted alkynyl group, a substituted carbonyl group, a substituted sulfinyl group, a substituted sulfonyl group, a hydroxyl group, a substituted oxy group, a mercapto group, a substituted thio group, an amino group, a substituted amino group, a phosphono group, a substituted phosphono group, a phosphonato group, a substituted phosphonato group, a cyano group, a nitro group, a silyl group and a substituted onium group.

In these specific examples of W, preferred examples of the alkyl group, substituted alkyl group, aryl group, substituted aryl group, alkenyl group, substituted alkenyl group, alkynyl group, substituted alkynyl group, substituted carbonyl group, substituted sulfinyl group, substituted sulfonyl group, substituted oxy group, substituted thio group, amino group and substituted amino group are the same as those for X, Y and Z above.

The sulfonato group ($SO_3^-$) means a conjugate base anion group of a sulfo group ($-SO_3H$) and usually, this is preferably used together with a counter cation. Examples of the counter cation include generally known ions, that is, various oniums (e.g., ammoniums, sulfoniums, phosphoniums, iodoniums, aziniums) and metal ions (e.g., $Na^+$, $K^+$, $Ca^{2+}$, $Zn^{2+}$).

The substituted phosphono group means a phosphono group on which one or two hydroxy group is replaced by other organic oxo group. Preferred examples thereof include the above-described dialkylphosphono group, diarylphosphono group, alkylarylphosphono group, monoalkylphosphono group and monoarylphosphono group. Among these, more preferred are a dialkylphosphono group and a diarylphosphono group. Specific examples thereof include a diethylphosphono group, a dibutylphosphono group and a diphenylphosphono group.

The phosphonato group ($-PO_3^{2-}$ or $-PO_3H^-$) means a conjugate base anion group derived from primary acid dissociation or secondary acid dissociation of a phosphono group ($-PO_3H_2$) and usually, this is preferably used together with a counter cation. Examples of the counter cation include generally known ions, that is, various oniums (e.g., ammoniums, sulfoniums, phosphoniums, iodoniums, aziniums) and metal ions (e.g., $Na^+$, $K^+$, $Ca^{2+}$, $Zn^{2+}$).

The substituted phosphonato group is a conjugate base anion group resulting from replacing a hydroxy group of the above-described substituted phosphono group with one organic oxo group. Specific examples thereof include a conjugate base group of the monoalkylphosphono group ($-PO_3H(alkyl)$) and a conjugate base group of the monoarylphosphono group ($-PO_3H(aryl)$). Usually, this is preferably used together with a counter cation. Examples of the counter cation include generally known ions, that is, various oniums (e.g., ammoniums, sulfoniums, phosphoniums, iodoniums, aziniums) and metal ions (e.g., $Na^+$, $K^+$, $Ca^{2+}$, $Zn^{2+}$).

Examples of the substituted onium group include ammoniums, sulfoniums, phosphoniums, iodoniums and aziniums, and examples of the counter anion include a conjugate base of carboxyl group, a sulfonato group, a phosphonato group, a substituted phosphonato group, $Cl^-$, $Br^-$, $I^-$, $BF_4^-$, $ClO_4^-$ and $SbF_6^-$.

X', W and Z' may combine with each other to form a cyclic structure.

When n is 2 or more, Ws may be the same or different and may combine with each other to form a cyclic structure.

Examples of the cyclic structure formed when X' and W, W and Z', X' and Z', or W and W combine with each other include a saturated or unsaturated aliphatic ring. The aliphatic ring is preferably a 5-, 6-, 7- or 8-membered aliphatic ring formed in cooperation with the carbon atoms to which those substituents are bonded, more preferably a 5- or 6-membered aliphatic ring. In these aliphatic rings, a substituent may be present on the carbon atom constituting the ring (examples of the substituent include those described above as examples of the substituent in the substituted alkyl group), or a part of the ring-constituting carbons may be replaced with a heteroatom (e.g., oxygen, sulfur, nitrogen). Furthermore, a part of the aliphatic ring may form a part of an aromatic ring. Specific preferred examples thereof include a cyclopentane ring, a cyclohexane ring, a cycloheptane ring, a cyclooctane ring, a cyclo-1,3-dioxapentane ring, a cyclopentene ring, a cyclohexene ring, a cycloheptene ring, a cyclooctene ring, a cyclo-1,3-dioxapentene ring, a cyclo-1,3-dioxahexene ring, a cyclohexadiene ring, a benzocyclohexene ring, a benzocyclohexadiene ring, a tetrahydropyranone ring, maleimide, succinimide, phthalimide, 1,2,3,6-tetrahydrophthalimide, 1,2-cyclohexanedicarboxyimide, 2,4,6-piperidinetrione and 1,4,5,6,7,7-hexachloro-5-norbornene-2,3-dicarboxyimide.

Examples of the aromatic ring formed when X' and W, W and Z', X' and Z', or W and W combine with each other include a quinoline ring, an isoquinoline ring, an acridine ring, a phenanthridine ring, a benzoquinoline ring and a benzoisoquinoline ring. Among these, a quinoline ring is preferred. Such an aromatic ring may have a substituent on the carbon atom constituting the ring (examples of the substituent include the above-described substituents on the substituted alkyl group).

Specific examples of the compound represented by formula (2) are set forth below, but the present invention is not limited thereto.

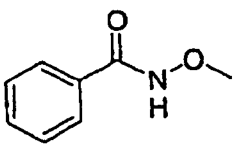
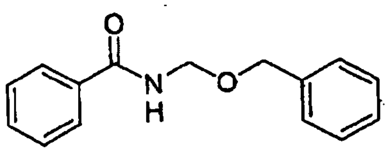
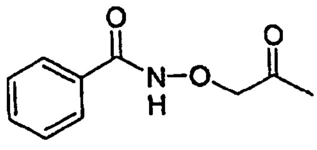

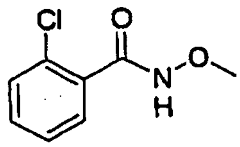
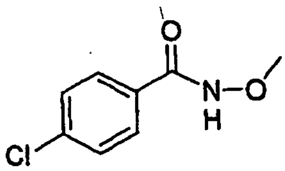
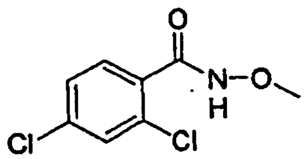

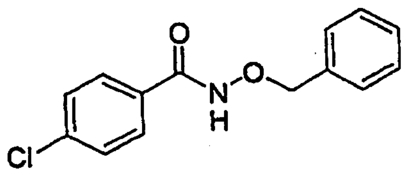
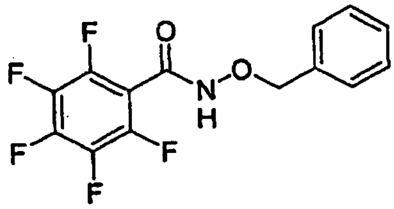

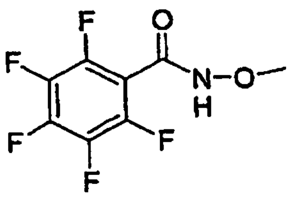
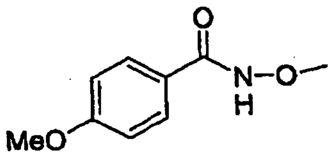

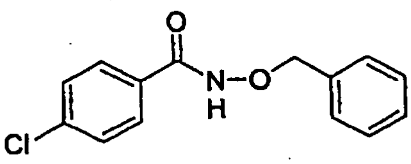
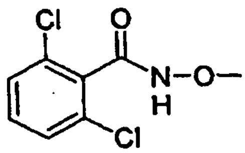

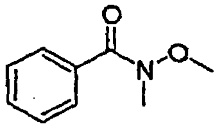
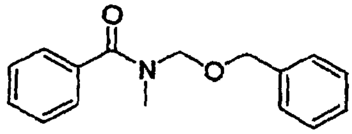
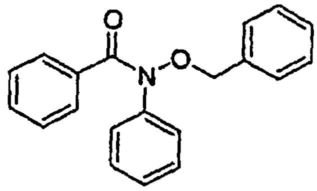

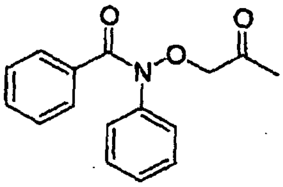
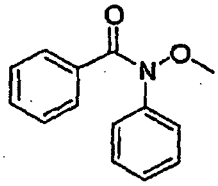
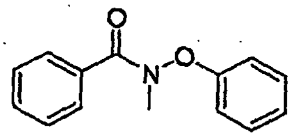

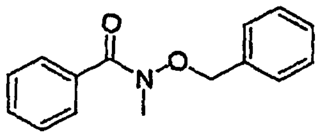
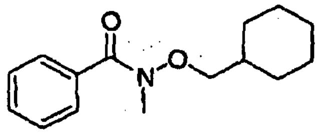
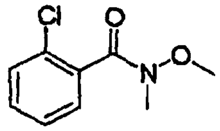

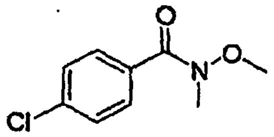
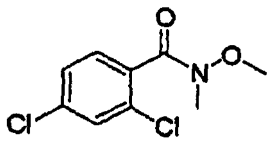
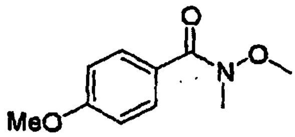

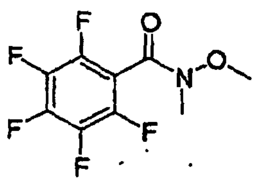
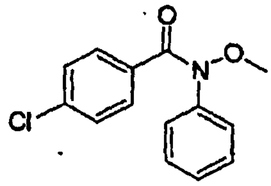
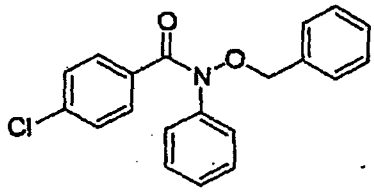

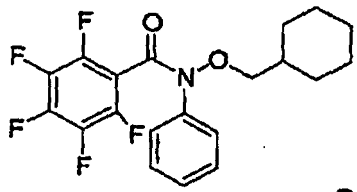
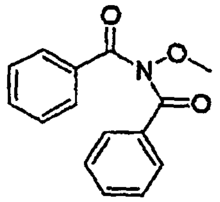
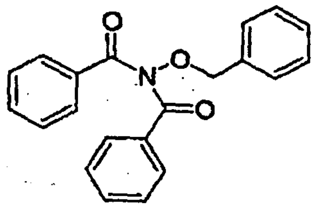

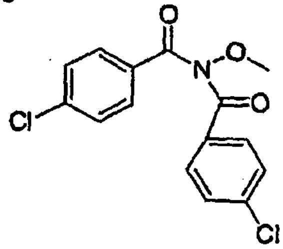
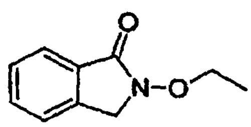

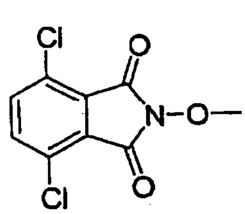
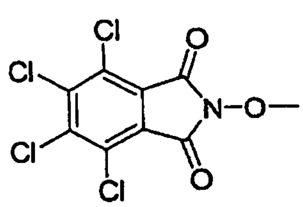
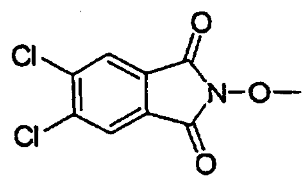

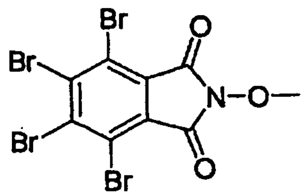

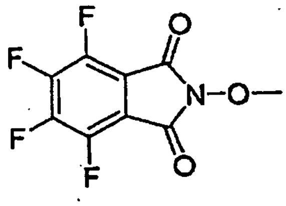

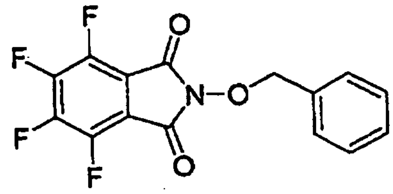

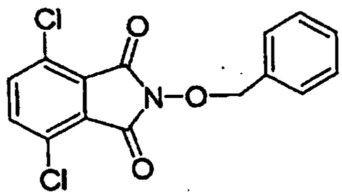

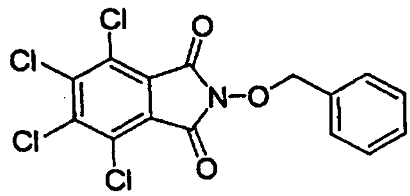

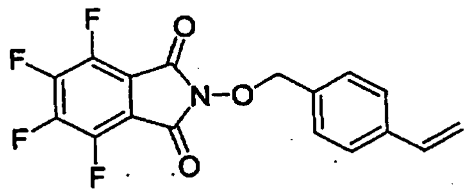

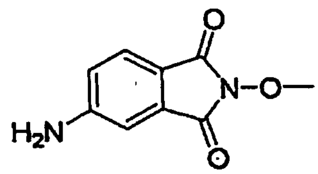

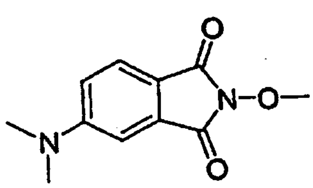

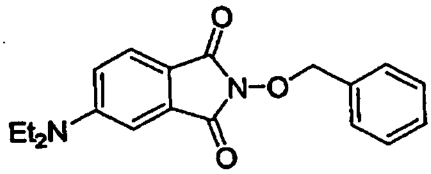

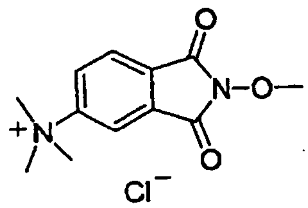

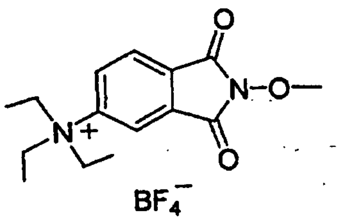

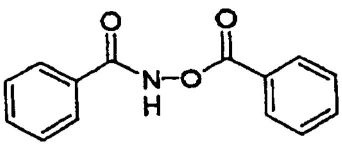

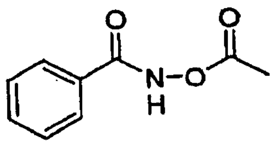

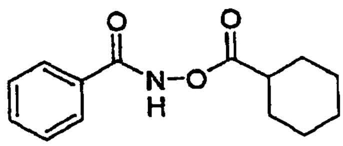

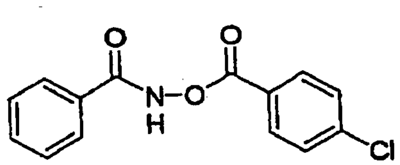

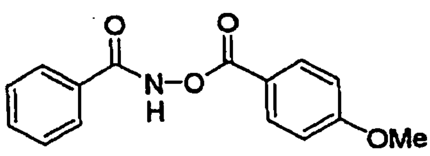

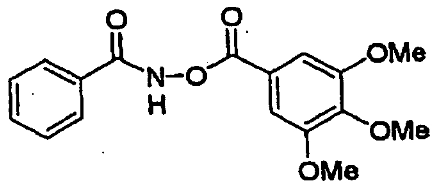

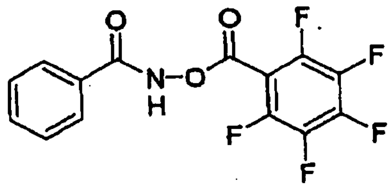

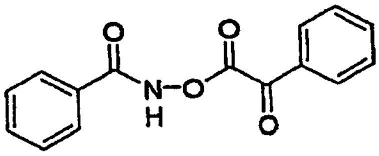

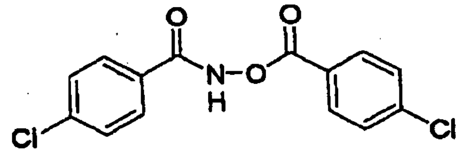

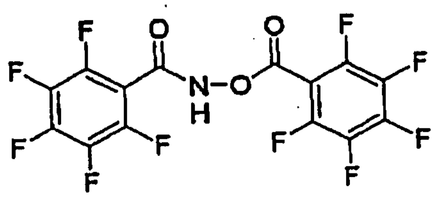

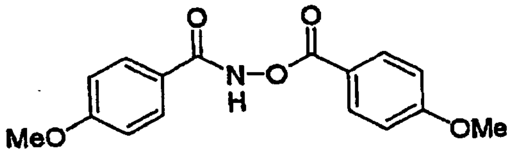

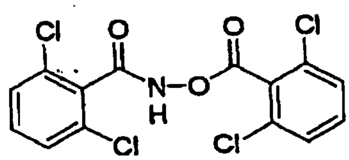

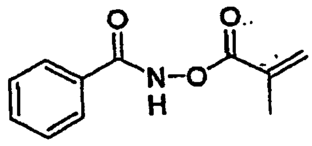

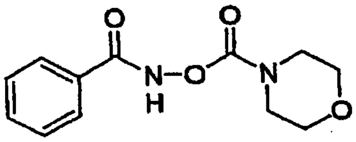

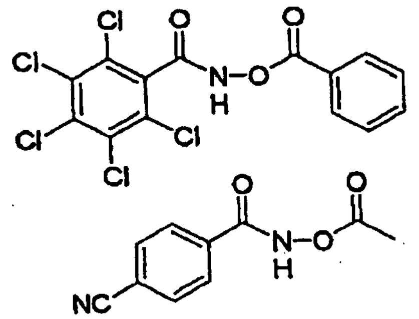

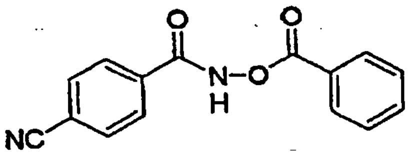

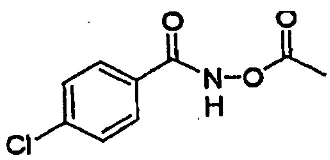

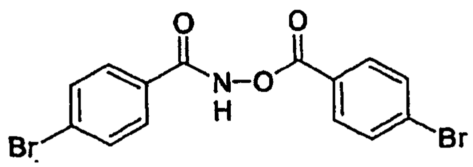

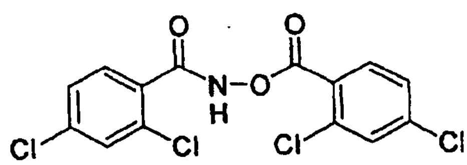

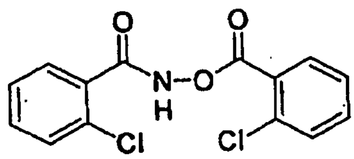

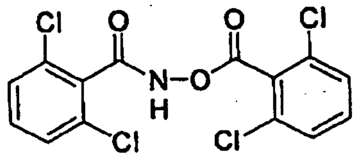

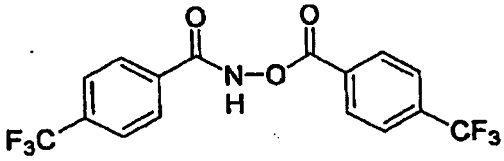

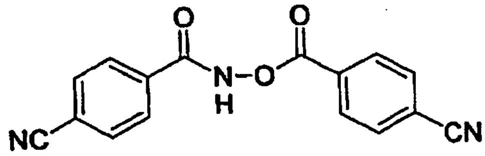

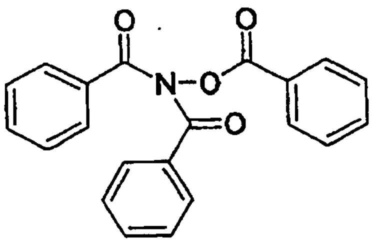

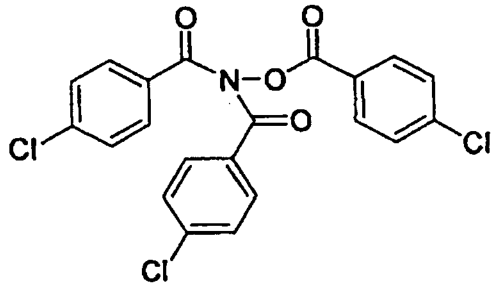

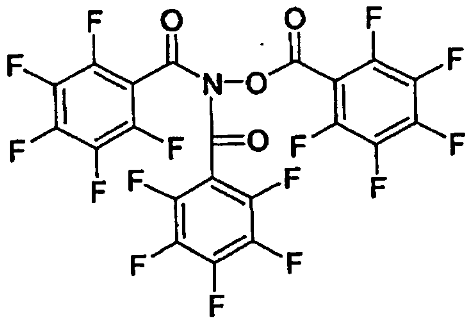

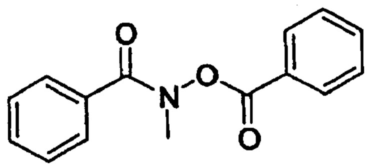

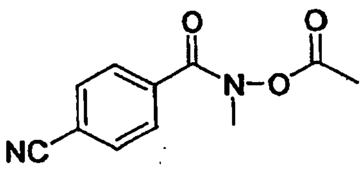

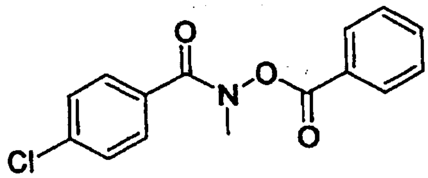

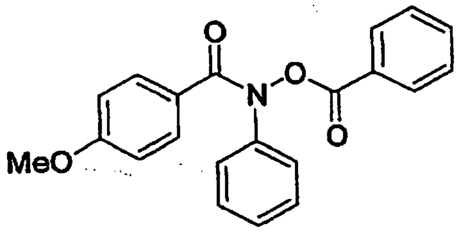

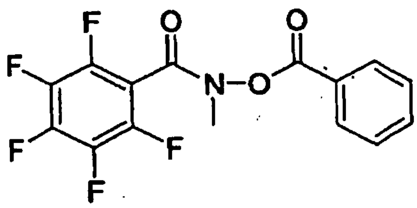

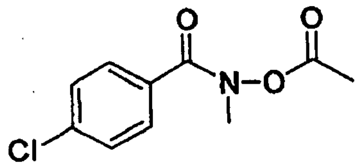

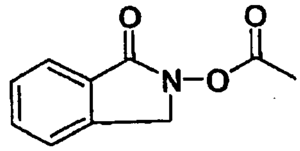

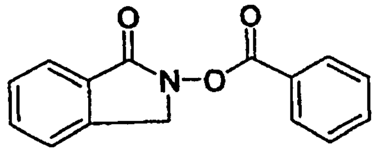

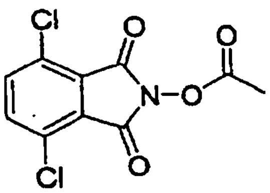

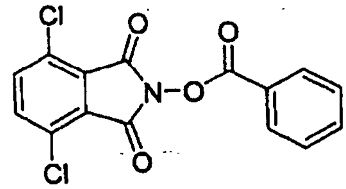

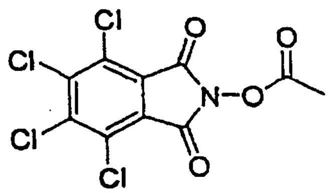

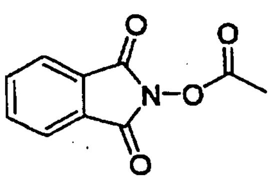

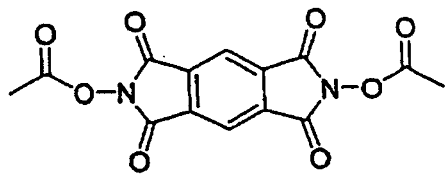

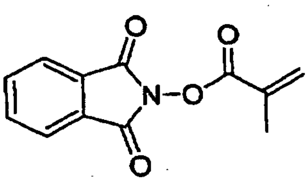

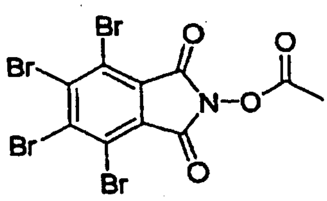

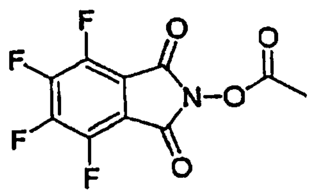

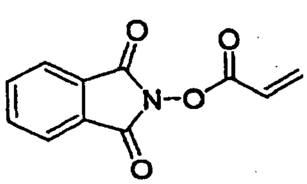

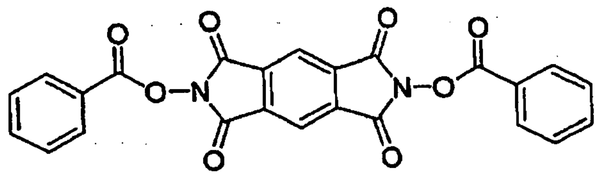

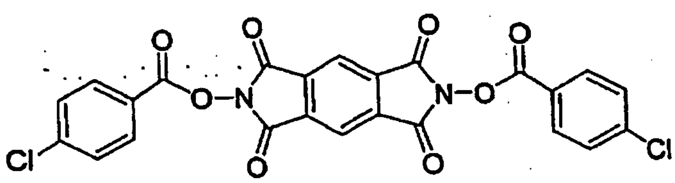

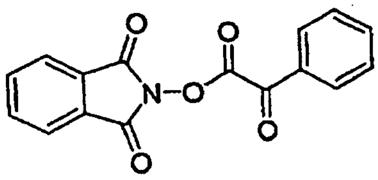
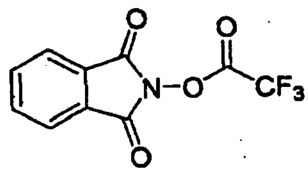

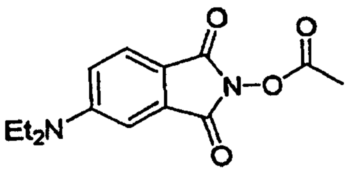
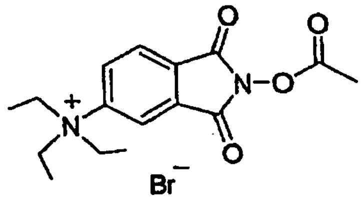

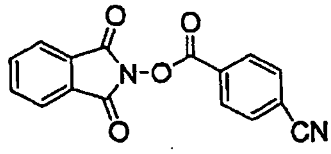
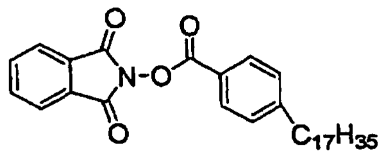

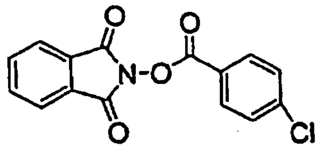
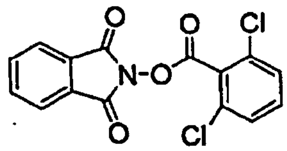

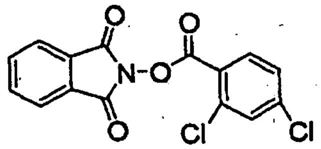
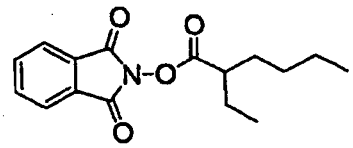

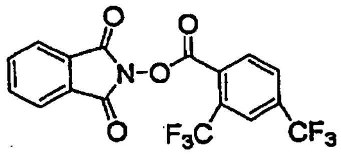
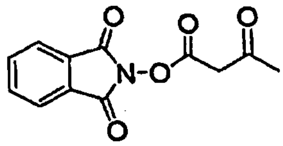
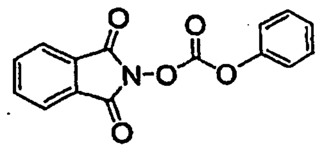

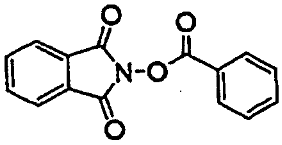
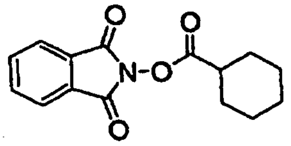
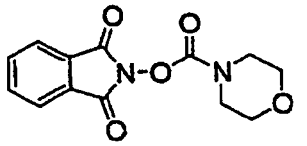

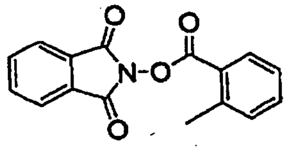

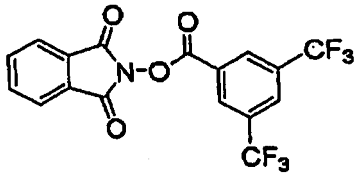

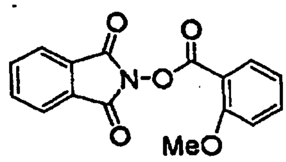

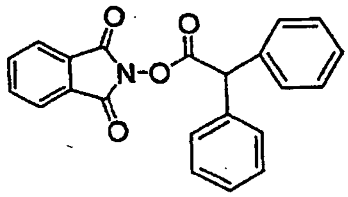

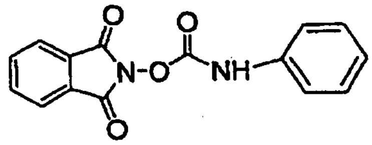

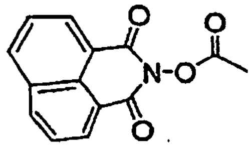

From the standpoint of enhancing the interaction with the photopolymerization initiator such as a titanocene compound, the compound represented by formula (1) is more preferably a compound represented by formula (3):

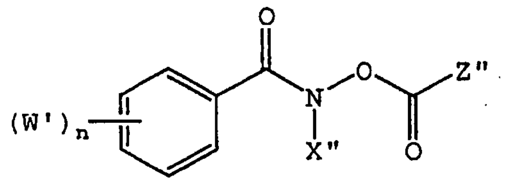

(3)

wherein X", W' and Z" each independently represents a monovalent substituent, and n represents an integer of 1 to 5.

Specific examples of X" in formula (3) are the same as those of X above.

Specific examples of Z" in formula (3) are the same as those of Z above.

Specific examples of W' in formula (3) are the same as those of W above.

X", W' and Z" may combine with each other to form a cyclic structure.

When n is 2 or more, W's may be the same or different and may combine with each other to form a cyclic structure.

Examples of the cyclic structure formed when X" and W', W and Z", X" and Z", or W' and W' combine with each other include a saturated or unsaturated aliphatic ring. The aliphatic ring is preferably a 5-, 6-, 7- or 8-membered aliphatic ring formed in cooperation with the carbon atoms to which those substituents are bonded, more preferably a 5- or 6-membered aliphatic ring. In these aliphatic rings, a substituent may be present on the carbon atom constituting the ring (examples of the substituent include those described above as examples of the substituent in the substituted alkyl group), or a part of the ring-constituting carbons may be replaced with a heteroatom (e.g., oxygen, sulfur, nitrogen). Furthermore, a part of the aliphatic ring may form a part of an aromatic ring. Specific preferred examples thereof include a cyclopentane ring, a cyclohexane ring, a cycloheptane ring, a cyclooctane ring, a cyclo-1,3-dioxapentane ring, a cyclopentene ring, a cyclohexene ring, a cycloheptene ring, a cyclooctene ring, a cyclo-1,3-dioxapentene ring, a cyclo-1,3-dioxahexene ring, a cyclohexadiene ring, a benzocyclohexene ring, a benzocyclohexadiene ring, a tetrahydropyranone ring, maleimide, succinimide, phthalimide, 1,2,3,6-tetrahydrophthalimide, 1,2-cyclohexanedicarboxyimide, 2,4,6-piperidinetrione and 1,4,5,6,7,7-hexachloro-5-norbornene-2,3-dicarboxyimide.

Examples of the aromatic ring formed when X" and W, W' and Z", X" and Z", or W' and W' combine with each other include a quinoline ring, an isoquinoline ring, an acridine ring, a phenanthridine ring, a benzoquinoline ring and a benzoisoquinoline ring. Among these, a quinoline ring is preferred. Such an aromatic ring may have a substituent on the carbon atom constituting the ring (examples of the substituent include the above-described substituents on the substituted alkyl group).

Specific examples of the compound represented by formula (3) are set forth below, but the present invention is not limited thereto.

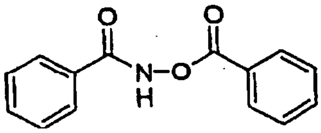
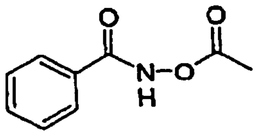
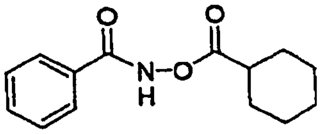

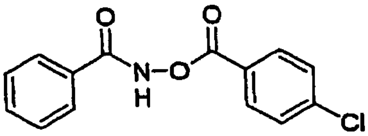
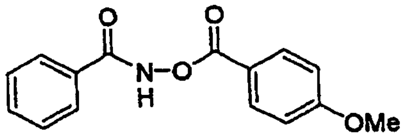

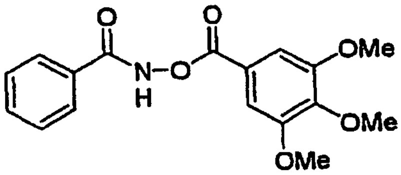
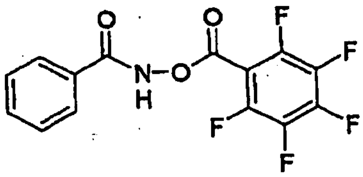

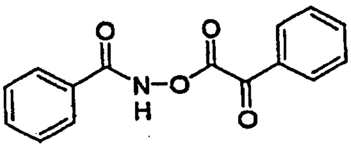
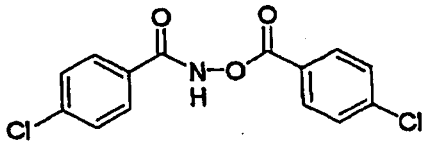

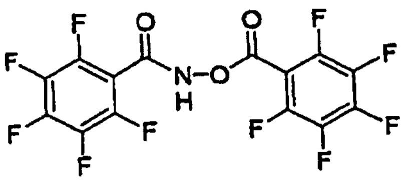
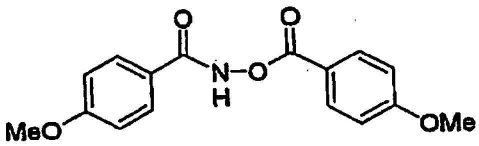

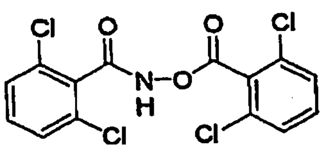
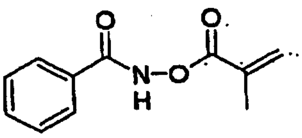

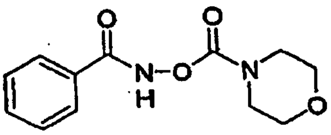
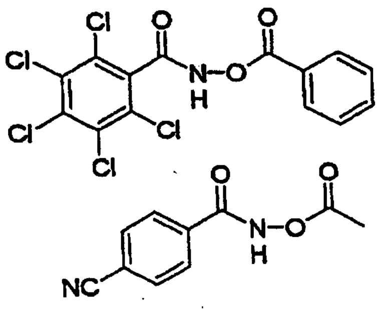

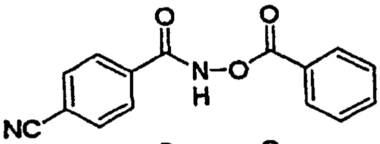

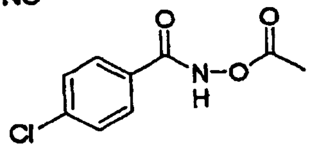

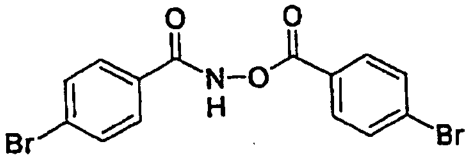
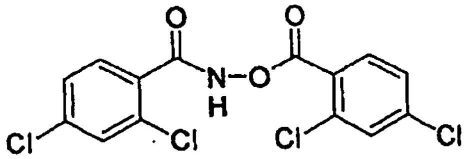

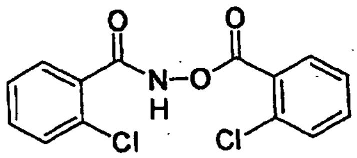
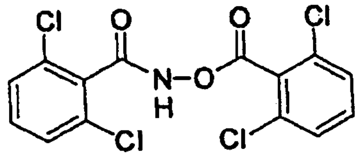

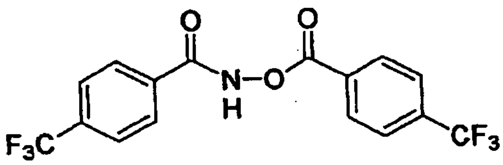
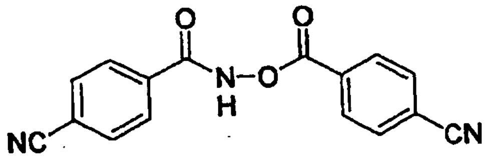

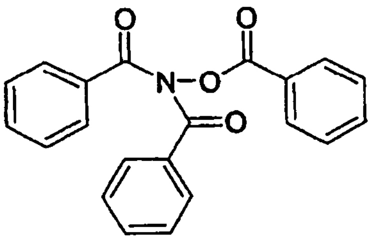
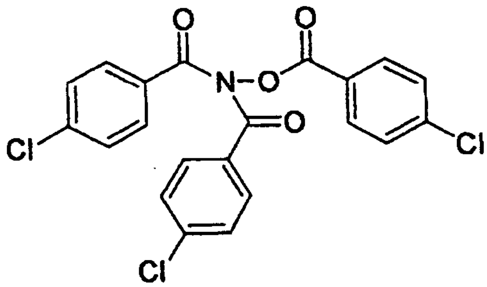

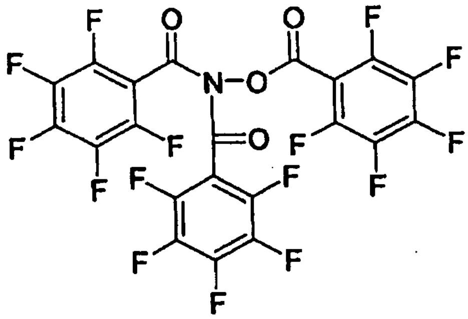
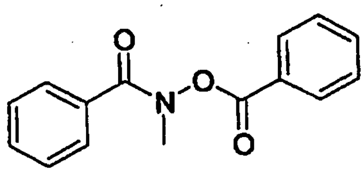

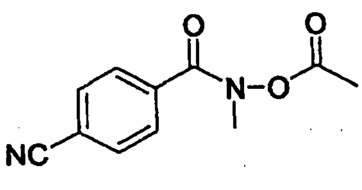
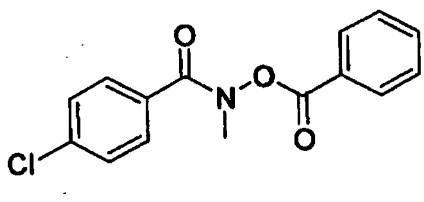

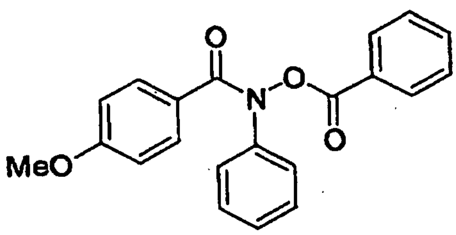
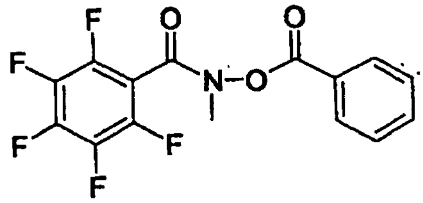

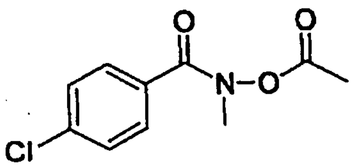
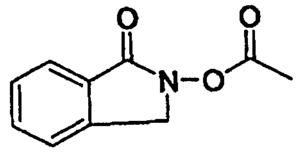

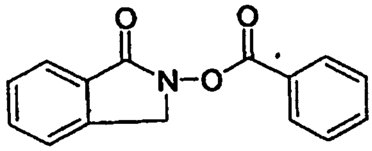

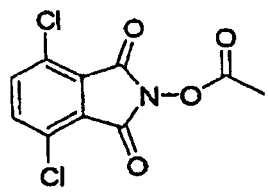
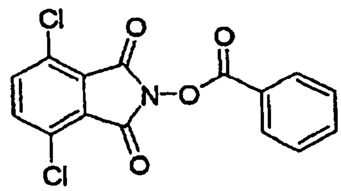
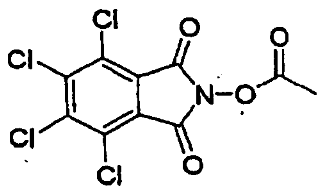

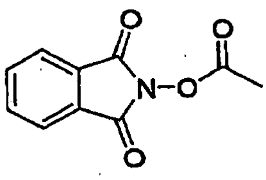
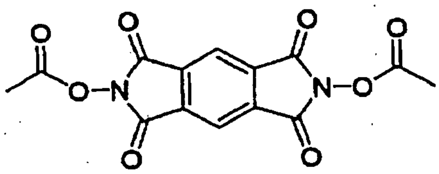

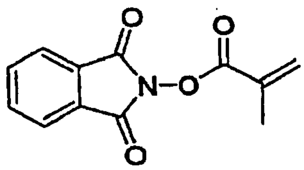
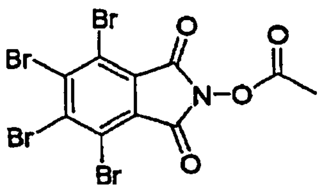
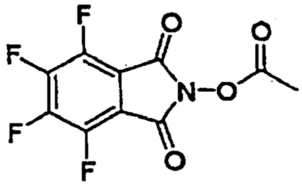

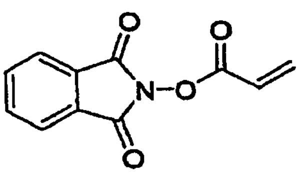
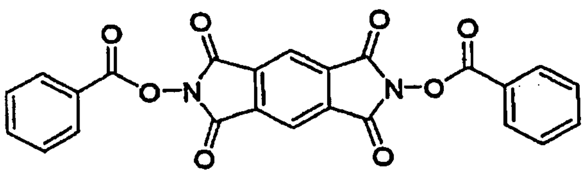

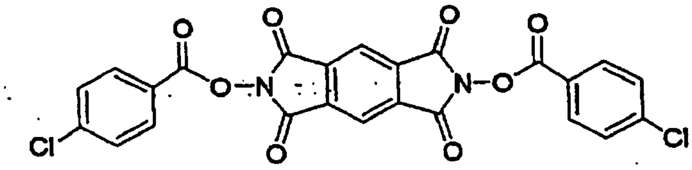

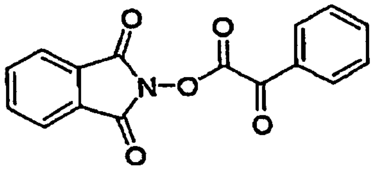

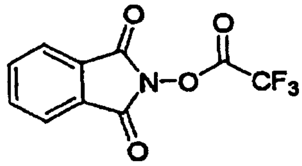

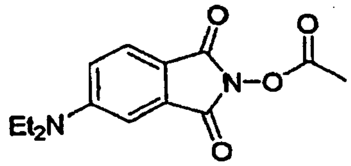

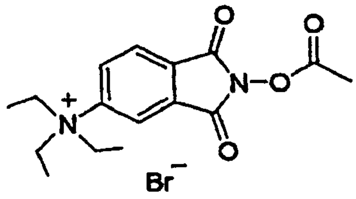

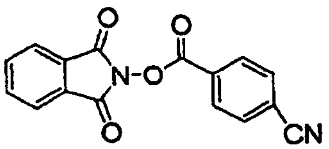

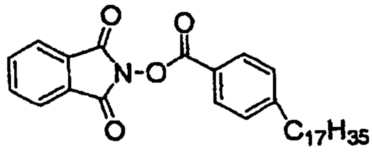

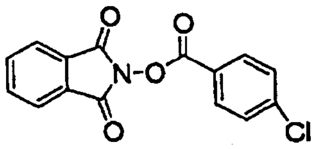

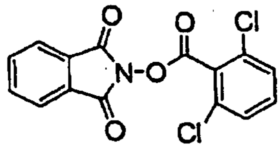

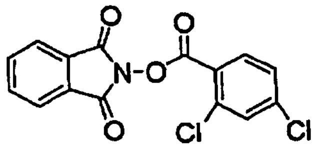

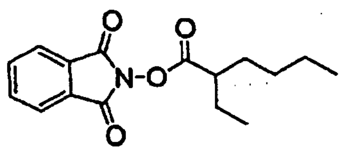

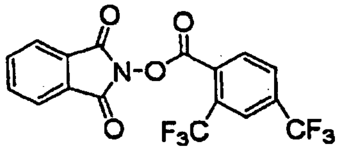

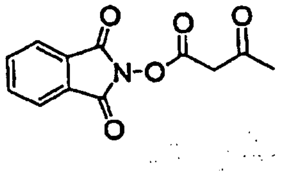

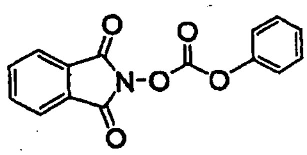

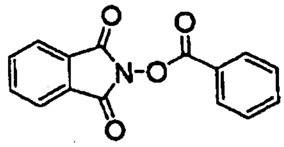

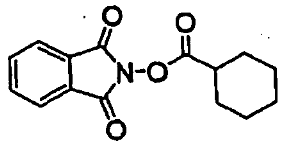

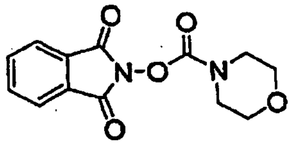

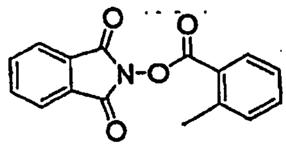 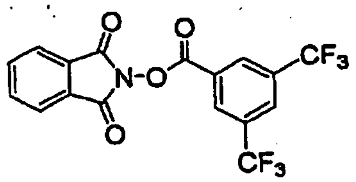 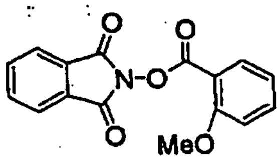

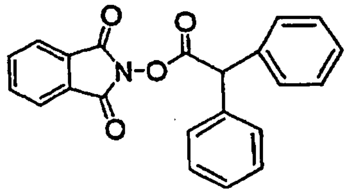 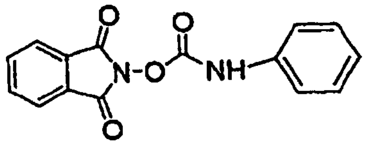

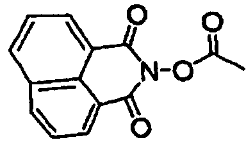

From the standpoint of satisfying both sensitivity and stability in aging, the compound represented by formula (1) is still more preferably a compound represented by formula (4) or (5):

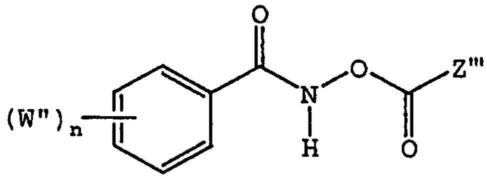

(4)

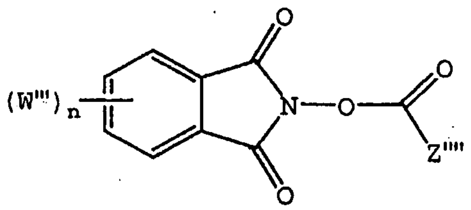

(5)

wherein W", W'", Z'" and Z"" each independently represents a monovalent substituent, and n represents an integer of 1 to 5.

Specific examples of Z'" and Z"" in formulae (4) and (5) are the same as those of Z above.

Specific examples of W" and W'" in formulae (4) and (5) are the same as those of W above.

W" and Z"', or W'" and Z"" may combine with each other to form a cyclic structure.

When n is 2 or more, W"s or W'"s may be the same or different and may combine with each other to form a cyclic structure.

Examples of the cyclic structure formed when W" and Z"', W'" and Z"", W" and W", or W'" and W'" combine with each other include a saturated or unsaturated aliphatic ring. The aliphatic ring is preferably a 5-, 6-, 7- or 8-membered aliphatic ring formed in cooperation with the carbon atoms to which those substituents are bonded, more preferably a 5- or 6-membered aliphatic ring. In these aliphatic rings, a substituent may be present on the carbon atom constituting the ring (examples of the substituent include those described above as examples of the substituent in the substituted alkyl group), or a part of the ring-constituting carbons may be replaced with a heteroatom (e.g., oxygen, sulfur, nitrogen). Furthermore, a part of the aliphatic ring may form a part of an aromatic ring. Specific preferred examples thereof include a cyclopentane ring, a cyclohexane ring, a cycloheptane ring, a cyclooctane ring, a cyclo-1,3-dioxapentane ring, a cyclopentene ring, a cyclohexene ring, a cycloheptene ring, a cyclooctene ring, a cyclo-1,3-dioxapentene ring, a cyclo-1,3-dioxahexene ring, a cyclohexadiene ring, a benzocyclohexene ring, a benzocyclohexadiene ring and a tetrahydropyranone ring.

Examples of the aromatic ring formed when W" and Z"', W"' and Z"", W" and W", or W" and W"' combine with each other include a quinoline ring, an isoquinoline ring, an acridine ring, a phenanthridine ring, a benzoquinoline ring and a benzoisoquinoline ring. Among these, a quinoline ring is preferred. Such an aromatic ring may have a substituent on the carbon atom constituting the ring (examples of the substituent include the above-described substituents on the substituted alkyl group).

Specific examples of the compounds represented by formulae (4) and (5) are set forth below, but the present invention is not limited thereto.

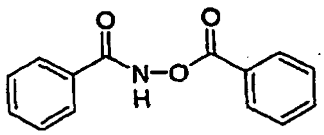
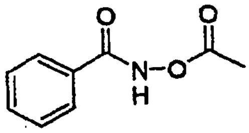
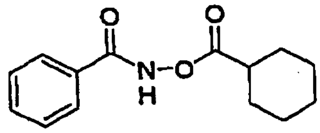

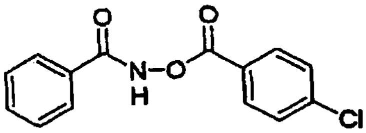
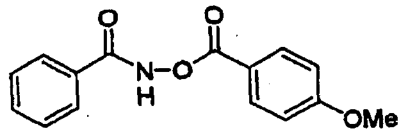

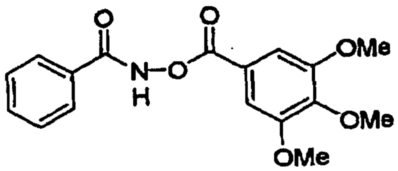
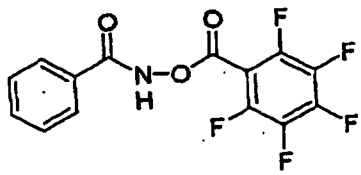

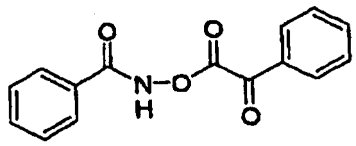
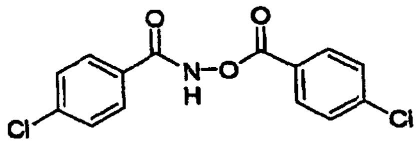

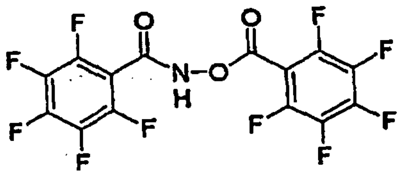
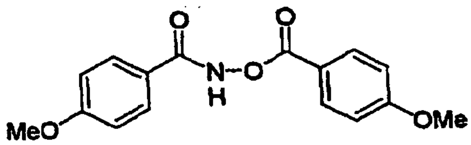

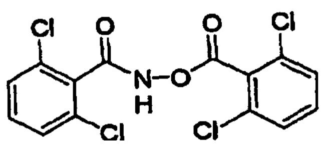
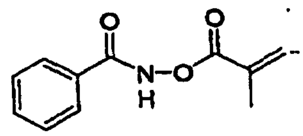

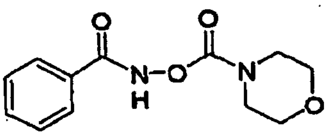
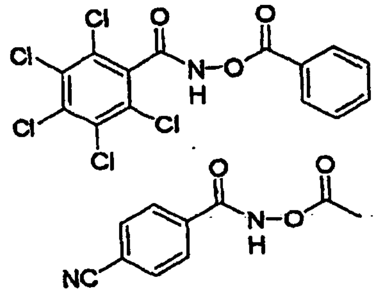
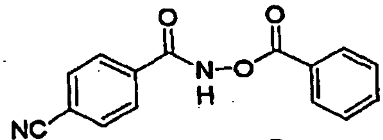
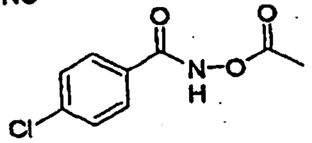

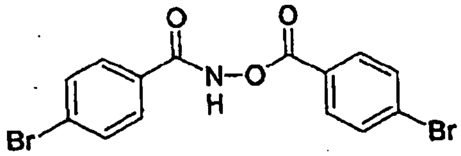
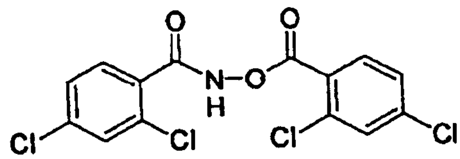

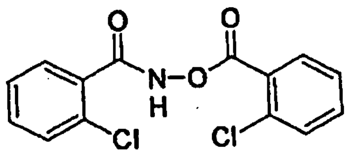
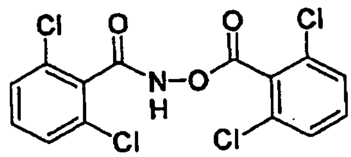

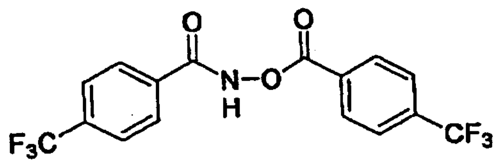
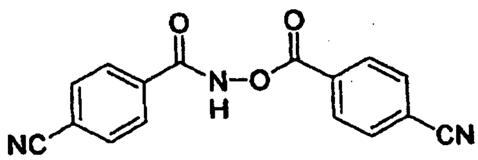

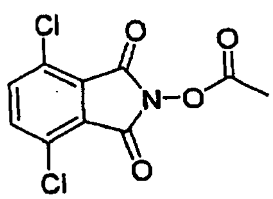
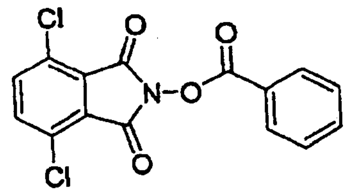
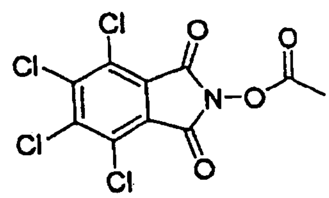

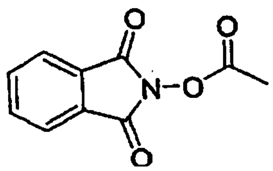
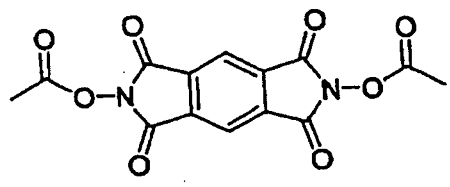

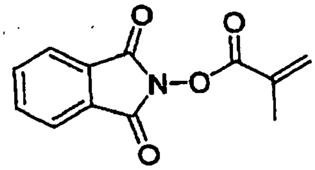
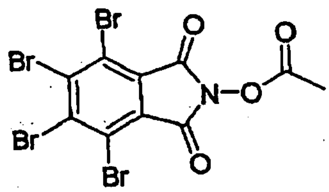
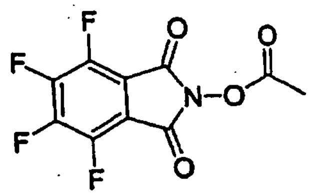

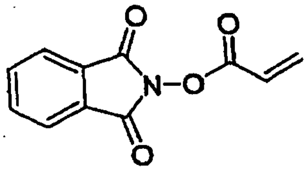
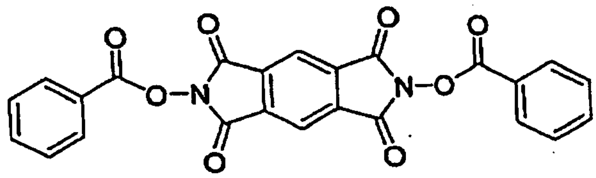

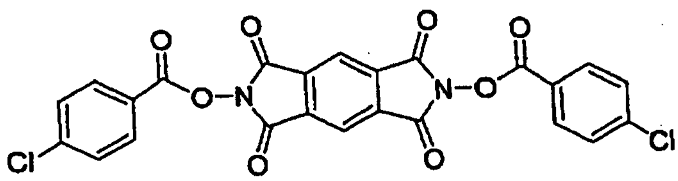

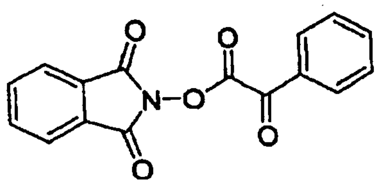
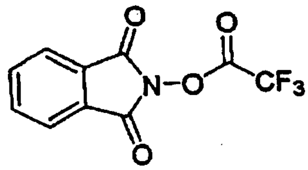

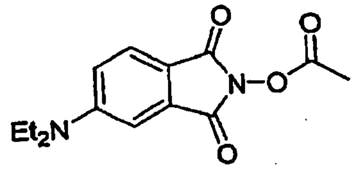
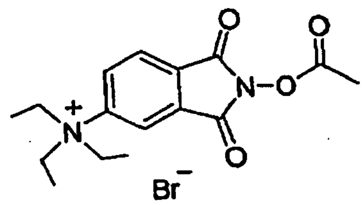

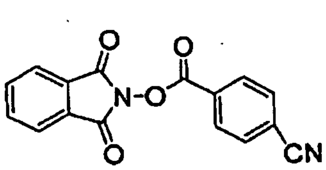
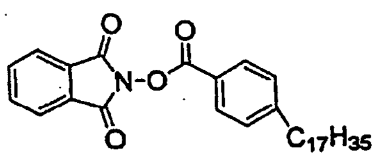

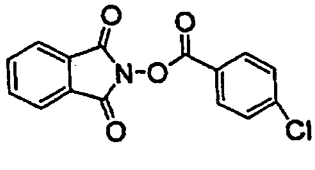
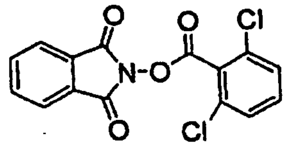

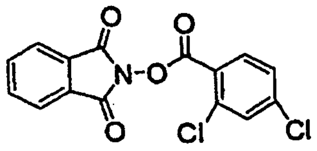
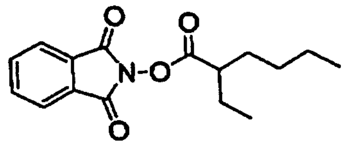

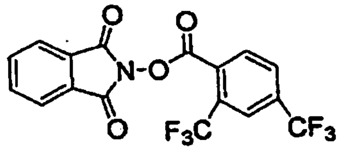
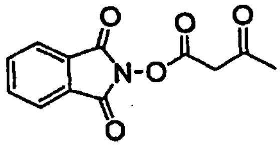
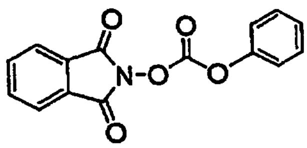

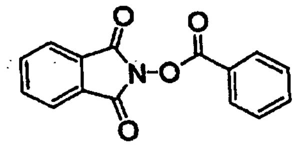
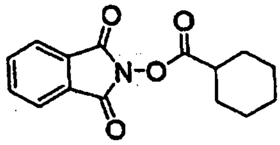
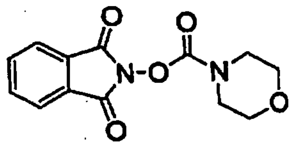

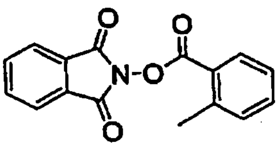
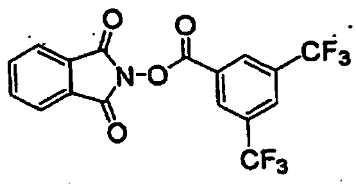
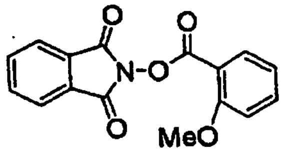

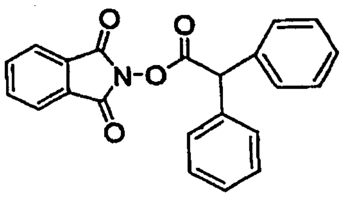
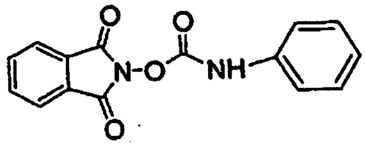
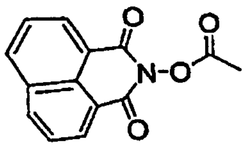

When such an N-oxyamide compound is used in combination with the following co-sensitizer, the generated radical species efficiently reacts and the sensitization effect is elevated. In particular, use in combination with the following compound is preferred.

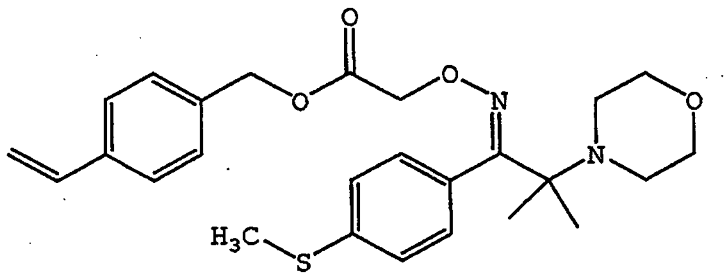

Also, when such an N-oxyamide compound is used in combination with a specific dye (e.g., sensitizing dye represented by the following formula (XVIII)) described in JP-A-2001-100412 (Japanese Patent Application No. 11-280204), the initiation efficiency and sensitization effect are enhanced and this is preferred. In particular, use in combination with a specific dye represented by the following formula is more preferred.

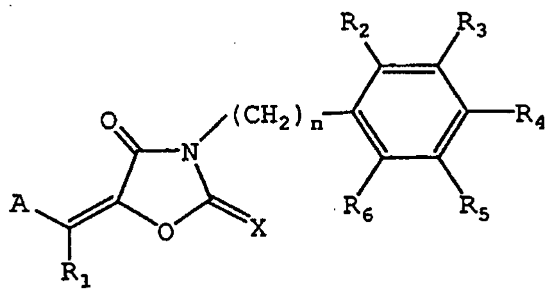

(XVIII)

(wherein A represents an aromatic or heterocyclic ring which may have a substituent, X represents an oxygen atom, a sulfur atom or $=NR_7$, $R_1$, $R_2$, $R_3$, $R_4$, $R_5$, $R_6$ and $R_7$ each independently represents a hydrogen atom or a monovalent nonmetallic atom group, provided that at least one of $R_2$, $R_3$, $R_4$, $R_5$ and $R_6$ is a substituent represented by $-OR_8$ (wherein $R_8$ independently represents a monovalent nonmetallic atom group), and n represents an integer of 1 to 6).

Furthermore, when such an N-oxyamide compound is used in combination with a urethane binder, a high effect of enhancing the press life is obtained. In particular, use in combination with polyurethane containing 10 weight% (mass%) or more of an aromatic group is preferred.

In use of such an N-oxyamide compound, the method therefor can be appropriately and arbitrarily selected in accordance with the designed performance of the photosensitive material. Usually, the amount of the N-oxyamide compound used is preferably larger in view of photosensitivity and when the composition is used as a material for the photosensitive layer of a lithographic printing plate precursor, the amount of the N-oxyamide compound used is preferably from 0.01 to 40 parts by weight, more preferably from 0.05 to 30 parts by weight, and most preferably from 1 to 10 parts by weight, per 100 parts by weight of the photosensitive layer components. Within this range, sufficiently high photosensitivity can be obtained.

(A2) Titanocene Compound

The titanocene compound which is preferably used as the photopolymerization initiator in the present invention may be any titanocene compound as long as it can generate an active species upon irradiation with light in the region of 350 to 450 nm, and known compounds described, for example, in JP-A-59-152396, JP-A-61-151197, JP-A-63-41484, JP-A-63-41484, JP-A-2-249, JP-A-2-291, JP-A-3-27393, JP-A-3-12403 and JP-A-6-41170 can be appropriately selected and used.

Specific examples of the titanocene compound include dicyclopentadienyl-Ti-dichlorida, dicyclopentadienyl-Ti-bis-phenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,3,5,6-tetrafluorophen-1-yl, dimethylcyclopentadienyl-Ti-bis-2,4-difluorophen-1-yl, bis-(cyclopentadienyl)bis[2,6-difluoro-3-(pyr-1-yl)phenyl]titanium.

In use of such a titanocene compound, similarly to the N-oxyamide compound, the method therefor can be appropriately and arbitrarily selected in accordance with the designed performance of the photosensitive material. For

example, when two or more titanocene compounds are used in combination, compatibility with the photosensitive layer can be enhanced. Usually, the amount of the titanocene compound used is preferably larger in view of photosensitivity and when the composition is used as a material for the photosensitive layer of a lithographic printing plate precursor, the amount of the titanocene compound used is preferably from 0.5 to 80 parts by weight, more preferably from 1 to 50 parts by weight, per 100 parts by weight of the photosensitive layer components. Within this range, sufficiently high photosensitivity can be obtained. However, the titanocene compound itself has absorption for visible light in some cases and in use under yellow or white light, the amount of the titanocene compound used is preferably smaller in view of fogging due to light in the vicinity of 500 nm, and the amount used is preferably 6 parts by weight or less, more preferably 1.9 parts by weight or less. At the home appliance shop, even when the amount of the titanocene compound used is decreased to 4 parts by weight or less, satisfactory photosensitivity can be obtained.

In the photoinitiation system of the present invention, a sensitizing dye is preferably further used for the purpose of enhancing the photosensitivity. Preferred examples of the sensitizing dye are described below.

(A3) Sensitizing Dye

Preferred examples of the sensitizing dye for use in the present invention include those having absorption at a wavelength in the region of 350 to 450 nm and belonging to the following compounds: polynuclear aromatics (e.g., pyrene, perylene, triphenylene), xanthenes (e.g., fluorescein, eosine, erythrosine, Rhodamine B, Rose Bengal), cyanines (e.g., thiacarbocyanine, oxacarbocyanine), merocyanines (e.g., merocyanine, carbomerocyanine), thiazines (e.g., thionine, methylene blue, toluidine blue), acridines (e.g., acridine orange, chloroflavin, acriflavine), anthraquinones (e.g., anthraquinone) and squaliums (e.g., squalium).

More preferred examples of the sensitizing dye include the compounds represented by the following formulae (XIV) to (XVIII):

Formula (XIV):

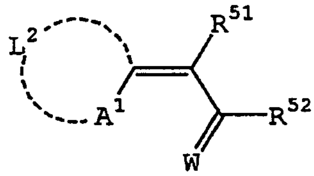

(wherein $A^1$ represents a sulfur atom or $NR^{50}$, $R^{50}$ represents an alkyl group or an aryl group, $L^2$ represents a nonmetallic atom group necessary for forming a basic nucleus of the dye in cooperation with the adjacent $A^1$ and the adjacent carbon atom, $R^{51}$ and $R^{52}$ each independently represents a hydrogen atom or a monovalent nonmetallic atom group, $R^{51}$ and $R^{52}$ may combine with each other to form an acidic nucleus of the dye, and W represents an oxygen atom or a sulfur atom).

Specific preferred examples of the compound represented by formula (XIV) are set forth below.

(A-1)

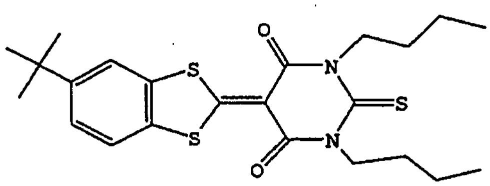

(A-2)

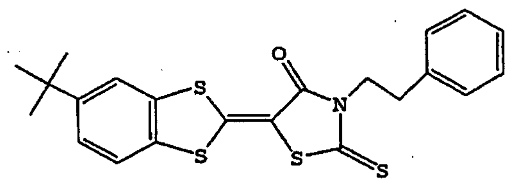

(A-3)

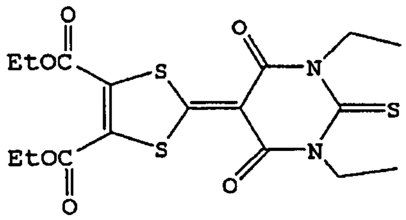

(A-4)

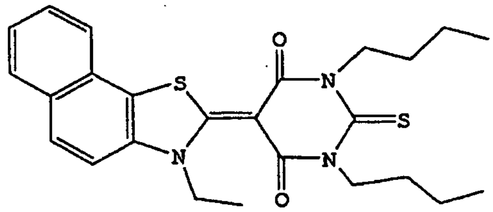

(A-5)

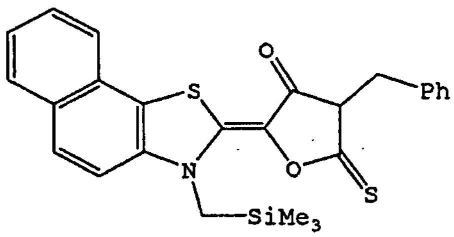

Formula (XV):

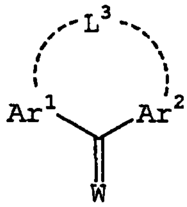

(wherein $Ar^1$ and $Ar^2$ each independently represents an aryl group and are linked through a bond of - $L^3$-, $L^3$ represents -O- or -S-, and W has the same definition as in formula (XIV).

Preferred examples of the compound represented by formula (XV) include the followings:

(A-6)

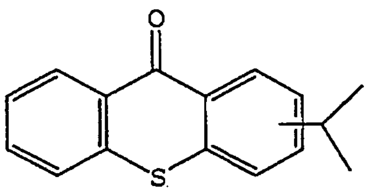

(A-7)

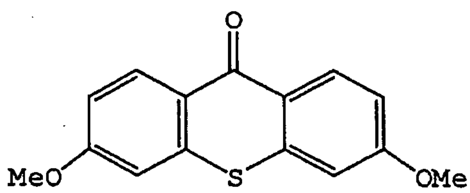

(A-8)

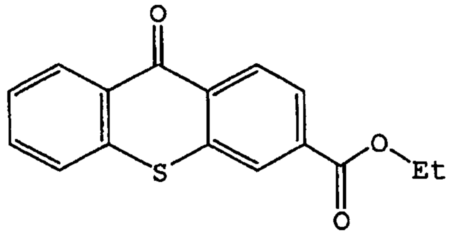

Formula (XVI):

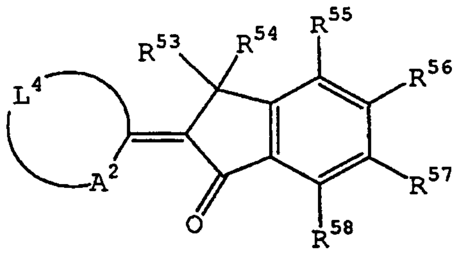

(wherein $A^2$ represents a sulfur atom or $NR^{59}$, $L^4$ represents a nonmetallic atom group necessary for forming a basic nucleus of the dye in cooperation with the adjacent $A^2$ and the adjacent carbon atom, $R^{53}$, $R^{54}$, $R^{55}$, $R^{56}$, $R^{57}$ and $R^{58}$ each independently represents a monovalent nonmetallic atom group, and $R^{59}$ represents an alkyl group or an aryl group).

Preferred examples of the compound represented by formula (XVI) include the followings:

(A-9)

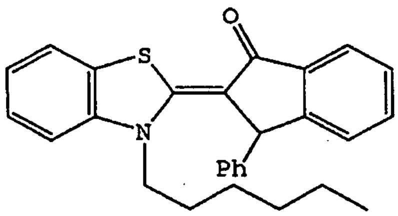

(A-10)

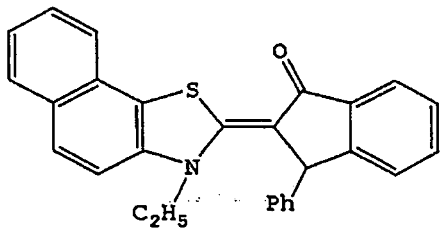

(A-11)

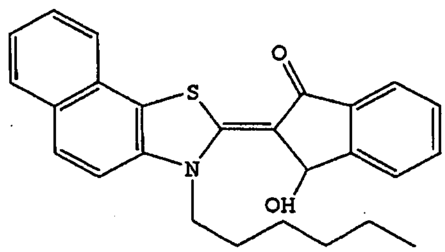

Formula (XVII):

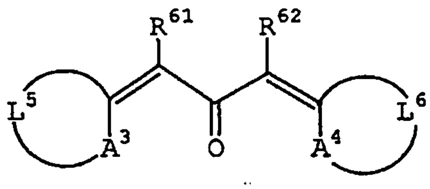

(wherein $A^3$ and $A^4$ each independently represents -S-, -$NR^{62}$- or -$NR^{63}$-, $R^{63}$ and $R^{64}$ each independently represents a substituted or unsubstituted alkyl group or a substituted or unsubstituted aryl group, $L^5$ and $L^6$ each independently represents a nonmetallic atom group necessary for forming a basic nucleus of the dye in cooperation with the adjacent $A^3$ or $A^4$ and the adjacent carbon atom, and $R^{60}$ and $R^{61}$ each independently represents a monovalent nonmetallic atom group or may combine with each other to form an aliphatic or aromatic ring).

Preferred examples of the compound represented by formula (XVII) include the followings:

(A-12)

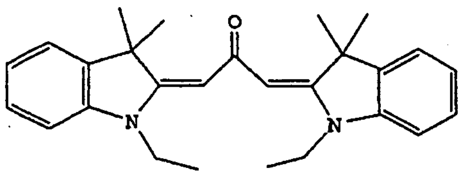

(A-13)

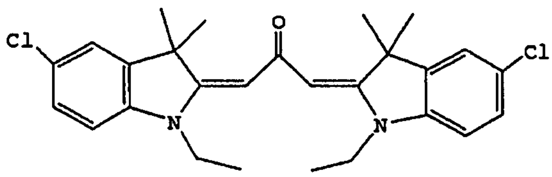

(A-14)

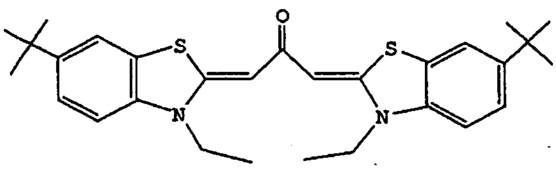

(A-15)

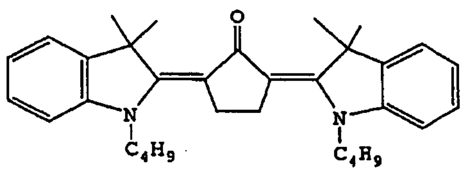

Formula (XVIII):

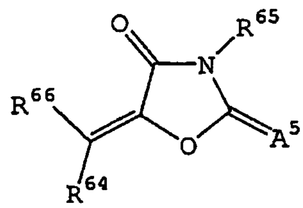

(wherein $R^{66}$ represents an aromatic or heterocyclic ring which may have a substituent, $A^5$ represents an oxygen atom, a sulfur atom or -$NR^{67}$-, $R^{64}$, $R^{65}$ and $R^{67}$ each independently represents a hydrogen atom or a monovalent nonmetallic atom group, and $R^{67}$ and $R^{64}$, or $R^{65}$ and $R^{67}$ may combine with each other to form an aliphatic or aromatic ring).

Preferred examples of the compound represented by formula (XVIII) include the followings:

(A-16)

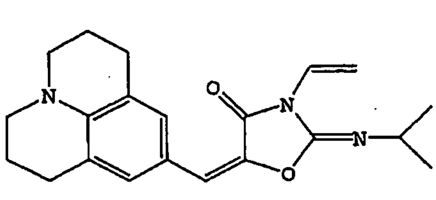

(A-17)

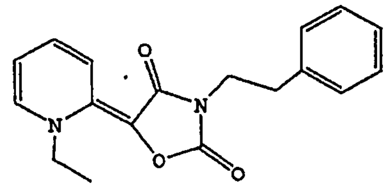

(A-18)

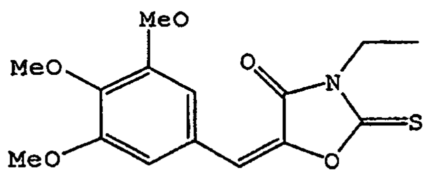

(A-19)

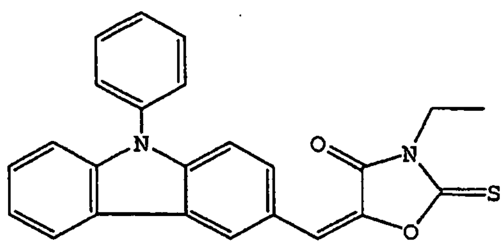

(A-20)

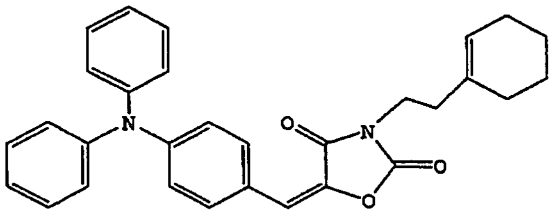

In the case of using the composition of the present invention for a lithographic printing plate precursor, the above-described sensitizing dye can be subjected to various chemical modifications so as to improve the properties of the photosensitive layer. For example, when the sensitizing dye is bonded to an addition-polymerizable compound structure (e.g., acryloyl group, methacryloyl group) by a method such as covalent bonding, ion bonding and hydrogen bonding, the strength of the exposed film can be increased or unnecessary precipitation of the dye from the exposed film can be prevented.

Also, in the case of producing a lithographic printing plate precursor by using the photosensitive composition of the present invention, introduction of a hydrophilic moiety (an acid group or a polar group, such as carboxyl group or its ester, sulfonic group or its ester, and ethylene oxide group) is effective for the purpose of enhancing the processing aptitude for an (alkali) aqueous developer, which is a preferred use mode of the photosensitive layer. Particularly, an ester-type hydrophilic group has a characteristic feature that in the photosensitive layer, excellent compatibility is assured by virtue of its relatively hydrophobic structure, whereas in the developer, the hydrophilicity increases because an acid group is produced due to hydrolysis. Other than these, an appropriate substituent may be introduced so as to, for example, improve compatibility and inhibit crystallization in the photosensitive layer. For example, in a certain photosensitive system, an unsaturated bond such as aryl group and allyl group is sometimes very effective in improving the compatibility, or crystallization can be significantly inhibited when steric hindrance between dye $\pi$ planes is introduced by a method such as introduction of a branched alkyl structure. Also, the adhesion to an inorganic material such as metal or metal oxide can be enhanced by introducing a phosphonic acid group, an epoxy group, a trialkoxysilyl group or the like. In addition, formation of the sensitizing dye into a polymer or the like may also be used according to the purpose.

Details on use of the sensitizing dye, such as structure, sole or combination use and amount added, can be appropriately selected in accordance with the designed performance of the final photosensitive material. For example, when two or more sensitizing dyes are used in combination, the compatibility in the photosensitive composition layer can be enhanced. In the selection of the sensitizing dye, the molar extinction coefficient at the oscillation wavelength of the light source used is an important factor in addition to the photosensitivity. When a dye having a large molar extinction

coefficient is used, the amount of the dye added can be made to be relatively small and this is profitable and also advantageous in view of film properties of the photosensitive layer when the composition is used for a lithographic printing plate precursor. The photosensitivity and resolution of the photosensitive layer and the physical properties of the exposed film are greatly affected by the absorbance at the wavelength of the light source and therefore, the amount of the sensitizing dye added is appropriately selected by taking account of these properties. For example, when the absorbance is in a low region of 0.1 or less, the sensitivity decreases. Also, the resolution lowers by the effect of halation.

However, for the purpose of curing a thick film of, for example, 5 μm or more, such low absorbance is sometimes rather effective in elevating the curing degree. When the absorbance is in a high region of 3 or more, light is mostly absorbed on the surface of the photosensitive layer, as a result, curing in the inner side does not proceed and in use as a printing plate, the film strength and the adhesion to substrate are not satisfied. In use as a lithographic printing plate where the photosensitive layer has a relatively small thickness, the amount of the sensitizing dye added is preferably set such that the absorbance of the photosensitive layer becomes from 0.1 to 1.5, more preferably from 0.25 to 1. In the case of use as a lithographic printing plate, this is usually from 0.05 to 30 parts by weight, preferably from 0.1 to 20 parts by weight, more preferably from 0.2 to 10 parts by weight, per 100 parts by weight of the photosensitive layer components.

[B. Component (iii)]

The third essential component (iii) in the composition of the present invention is a compound which irreversibly changes in its physical or chemical property under the action of the active species produced upon photoreaction of the above-described photoinitiation system, and an arbitrary compound can be used as the component (iii) without limitation as long as it exhibits such a behavior. For example, the compounds described above regarding the initiation system exhibit such a behavior by themselves in many cases. The properties of the component (iii), which are changed under the action of either a radical or an acid produced from the photoinitiation system, include physical properties from the molecular aspect, such as absorption spectrum (color), chemical structure and polarizability, and physical properties from the material aspect, such as solubility, strength, refractive index, fluidity and adhesive property.

For example, when like a pH indicator, the compound used as the component (iii) undergoes change in the absorption spectrum depending on the pH and an acid or base is generated from the initiation system, color tint only in the exposed area can be changed. Such a composition is useful as an image-forming material. Similarly, when a compound of undergoing change in the absorption spectrum by oxidation-reduction or nucleophilic addition reaction is used as the component (iii), image formation can be effected by inducing oxidation, reduction or the like under the action of a radical produced from the initiation system. Examples of such changes are disclosed in J. Am. Chem. Soc.. 108, 128 (1986), J. Imaging. Sci., 30, 215 (1986), and Israel. J. Chem., 25, 264 (1986).

Furthermore, when a compound capable of addition polymerization or polycondensation is used as the component (III) and combined with an initiation system, a photocurable resin or negative photopolymer can be formed.

As for the component (iii), a radical polymerizable compound (for example, a compound having an ethylenically unsaturated bond), a cationic polymerizable compound (for example, an epoxy compound, a vinyl ether compound and a methylol compound) or an anionic polymerizable compound (for example, an epoxy compound) is used. These compounds are described, for example, in Photopolymer Handbook, the Conference of Photopolymer Science and Technology (compiler), Kogyo Chosakai Publishing, Inc. (1989), and Kobunshi (Polymer), 45, 786 (1996). Also, a composition in which a thiol compound is used as the component (iii) and combined with a photoradical generating system is well known.

It is also effective to use an acid-decomposable compound as the component (iii) and combine it with a photoacid generator. For example, a material which uses a polymer having a side or main chain decomposable under the action of an acid and which undergoes change in the solubility, hydrophilicity/hydrophobicity or the like by the effect of light is broadly used in practice as a photodecomposition-type photosensitive resin or a positive photopolymer. Specific examples thereof include those described in ACS. Symp. Ser., 242, 11 (1984), JP-A-60-3625, U.S. Patents 5,102,771, 5,206,317 and 5,212,047, JP-A-4-26850, JP-A-3-1921731, JP-A-60-10247 and JP-A-62-40450.

The component (iii) particularly useful for obtaining a high-sensitivity lithographic printing plate which is one of the objects of the present invention is an addition-polymerizable compound having an ethylenically unsaturated double bond, and this compound is described in detail below.

(B-1) Addition-Polymerizable Compound

The addition-polymerizable compound having at least one ethylenically unsaturated double bond, which is a preferred component (iii) for use in the present invention, is selected from compounds having at least one, preferably two or more, terminal ethylenically unsaturated bond(s). These compounds are widely known in this industrial field and can be used in the present invention without any particular limitation. These compounds have a chemical mode such as a monomer, a prepolymer (namely, dimer, trimer or oligomer) or a mixture or copolymer thereof. Examples of the

monomer or a copolymer thereof include an unsaturated carboxylic acid (e.g., acrylic acid, methacrylic acid, itaconic acid, crotonic acid, isocrotonic acid, maleic acid), and esters and amides thereof. Among these, esters of an unsaturated carboxylic acid with an aliphatic polyhydric alcohol compound, and amides of an unsaturated carboxylic acid with an aliphatic polyvalent amine compound are preferred. Also, for example, an addition reaction product of an unsaturated carboxylic acid ester or amide having a nucleophilic substituent such as hydroxyl group, amino group or mercapto group with a monofunctional or polyfunctional isocyanate or epoxy, and a dehydrating condensation reaction product with a monofunctional or polyfunctional carboxylic acid, may be suitably used. Furthermore, an addition reaction product of an unsaturated carboxylic acid ester or amide having an electrophilic substituent such as isocyanate group or epoxy group with a monofunctional or polyfunctional alcohol, amine or thiol, and a displacement reaction product of an unsaturated carboxylic acid ester or amide having a disorptive substituent such as halogen group or tosyloxy group with a monofunctional or polyfunctional alcohol, amine or thiol, may also be suitably used. Other than these, compounds resulting from replacing the unsaturated carboxylic acid of the above-described compounds with an unsaturated phosphonic acid, styrene, vinyl ether or the like may also be used.

Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylaxe, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerytbritol diacrylate, dipentaerythritol hexaacrylate, sorbitol triacrylate, sorbitol tetraacrylate, sorbitol pentaacrylate, sorbitol hexaacrylate, tri(acryloyloxy-ethyl)isocyanurate and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimetbacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)-phenyl]dimethylmethane and bis[p-(methacryloxyethoxy)phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate.

Examples of the crotonic acid ester include ethylene glycol dicrotonate, tetramethylene glycol dicrotonate, pentaerythritol dicrotonate and sorbitol tetradicrotonate.

Examples of the isocrotonic acid ester include ethylene glycol diisocrotonate, pentaerythritol diisocrotonate and sorbitol tetraisocrotonate.

Examples of the maleic acid ester include ethylene glycol dimaleate, triethylene glycol dimaleate, pentaerythritol dimaleate and sorbitol tetramaleate.

Other examples of the ester which can be suitably used include aliphatic alcohol-based esters described in JP-B-46-27926, JP-B-51-47334 and JP-A-57-196231, those having an aromatic skeleton described in JP-A-59-5240, JP-A-59-5241 and JP-A-2-226149, and those containing an amino group described in JP-A-1-165613.

These ester monomers may also be used as a mixture thereof.

Specific examples of the amide monomer of an aliphatic polyvalent amine compound with an unsaturated carboxylic acid include methylenebisacrylamide, methylenebismethacrylamide, 1,6-hexamethylenebisacrylamide, 1,6-hexamethylenebismethacrylamide, diethylenetriaminetris-acrylamide, xylylenebisacrylamide and xylylenebismethacrylamide.

Other preferred examples of the amide-based monomer include those having a cyclohexylene structure described in JP-B-54-21726.

A urethane-based addition-polymerizable compound produced by using an addition reaction of an isocyanate with a hydroxyl group is also preferred, and specific examples thereof include vinyl urethane compounds having two or more polymerizable vinyl groups within one molecule described in JP-B-48-41708, which are obtained by adding a vinyl monomer containing a hydroxyl group represented by the following formula (III) to a polyisocyanate compound having two or more isocyanate groups within one molecule.

$$CH_2=C(R)COOCH_2CH(R')OH \qquad (III)$$

(wherein R and R' each represents H or $CH_3$).

In addition, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 are also suitably used.

Furthermore, when an addition-polymerizable compound having an amino or sulfide structure within the molecule described in JP-A-63-277653, JP-A-63-260909 and JP-A-1-105238 is used, a photopolymerizable composition having remarkably excellent photosensitization speed can be obtained.
Other examples include polyfunctional acrylates and methacrylates such as polyester acrylates described in JP-A-48-64183, JP-B-49-43191 and JP-B-52-30490 and epoxy acrylates obtained by reacting an epoxy resin with a (meth)acrylic acid. Also, specific unsaturated compounds described in JP-B-46-43946, JP-B-1-40337 and JP-B-1-40336, and vinyl phosphonic acid-based compounds described in JP-A-2-25493 may be used. In some cases, a structure containing a perfluoroalkyl group described in JP-A-61-22048 is suitably used. Furthermore, those described as a photocurable monomer or oligomer in Adhesion, Vol. 20, No. 7, pp. 300-308 (1984) may also be used.
Details on use of the addition-polymerizable compound, such as structure, sole or combination use and amount added, can be freely selected according to the performance designed for the final photosensitive material. For example, these are selected from the following aspects. In view of photosensitization speed, a structure having a larger unsaturated group content per molecule is preferred and in most cases, a bifunctional or greater polyfunctional compound is preferred. For increasing the strength of image area, namely, cured film, a trifunctional or greater polyfunctional compound is preferred. Also, a method of controlling both photosensitivity and strength by using a combination of compounds differing in the functional number or in the polymerizable group (for example, an acrylic acid ester, a methacrylic acid ester, a styrene-based compound and a vinyl ether-based compound) is effective. A compound having a large molecular weight or a compound having high hydrophobicity is sometimes not preferred in view of development speed or precipitation in the developer, despite excellent photosensitization speed or film strength. The selection and use method of the addition-polymerizable compound are important factors also for compatibility and dispersibility with other components (e.g., binder polymer, initiator, colorant) in the photosensitive layer. For example, the compatibility may be improved in some cases by using a low purity compound or using two or more compounds in combination. Also, a specific structure may be selected for the purpose of improving the adhesion to the support, overcoat layer or the like. With respect to the blending ratio of the addition-polymerizable compound in the photosensitive layer, a larger ratio is advantageous in terms of sensitivity, but if excessively large, undesired phase separation may occur or there may arise a problem in view of production process due to tackiness of the photosensitive layer (for example, production failure ascribable to transfer or sticking of photosensitive material component), or a problem such as precipitation from the developer. From these standpoints, in many cases, the blending ratio of the addition-polymerizable compound is preferably from 5 to 80 weight%, more preferably from 25 to 75 weight%, based on all components in the composition. The addition-polymerizable compounds may be used individually or in combination of two or more thereof. Other than these, as for the use method of the addition-polymerizable compound, an appropriate structure, formulation or amount added can be freely selected by taking account of the degree of polymerization inhibition due to oxygen, resolution, fogging, change in refractive index, surface tackiness and the like. Depending on the case, a layer structure-coating method such as undercoat and overcoat can also be employed.

[C. Binder Polymer]

In the application to a lithographic printing plate which is a preferred embodiment of the present invention, the photosensitive composition preferably further contains a binder polymer. A linear organic high molecular polymer is preferred as the binder. This "linear organic high molecular polymer" may be any polymer. A water- or alkalescent water-soluble or swellable linear organic high molecular polymer enabling water development or alkalescent water development is preferably selected. The linear organic high molecular polymer is selected and used according to usage not only as a film-forming agent of the composition but also as a developer with the water, alkalescent water or organic solvent. For example, when a water-soluble organic high molecular polymer is used, water development can be performed. Examples of this linear organic high molecular polymer includes addition polymers having a carboxylic acid group in the side chain such as methacrylic acid copolymer, acrylic acid copolymer, itaconic acid copolymer, crotonic acid copolymer, maleic acid copolymer and partially esterified maleic acid copolymer described in JP-A-59-44615, JP-B-54-34327, JP-B-58-12577, JP-B-54-25957, JP-A-54-92723, JP-A-59-53836 and JP-A-59-71048. Furthermore, acidic cellulose derivatives similarly having a carboxylic acid group in the side chain may be used. In addition, those obtained by adding a cyclic acid anhydride to an addition polymer having a hydroxyl group are also useful.
Among these, a copolymer of [benzyl (meth)acrylate/ (meth)acrylic acid/other addition polymerizable vinyl monomer, if desired] and a copolymer of [allyl (meth)acrylatel(meth)acrylic acid/other addition polymerizable vinyl monomer, if desired] are particularly preferred because of excellent balance in the film strength, sensitivity and developability.
Furthermore, urethane-based binder polymer containing an acid group described in JP-B-7-12004, JP-B-7-120041, JP-B-7-120042, JP-B-8-12424, JP-A-63-287944, JP-A-63-287947, JP-A-1-271741 and Japanese Patent Application No. 10-116232 have very excellent strength and these are advantageous in view of press life and low exposure aptitude.
Also, the binder having an amide group described in JP-A-11-171907 is preferred because of good developability

and excellent film strength.

Other than these, polyvinylpyrrolidone, polyethylene oxide and the like are useful as the water-soluble linear organic polymer. In order to increase the strength of the cured film, for example, an alcohol-soluble nylon and a polyether of 2,2-bis(4-hydroxyphenyl)propane with epichlorohydrin are also useful. Such a linear organic high molecular polymer can be mixed in an arbitrary amount in the entire composition. However, if the amount exceeds 90 weight%, an undesirable effect results in view of strength or the like of the image formed. The amount is preferably from 30 to 85 weight%. Also, the ratio of the photopolymerizable compound having an ethylenically unsaturated double bond to the linear organic high molecular polymer is preferably from 1/9 to 7/3 (by weight). In a preferred embodiment, the binder polymer is substantially insoluble in water and soluble in alkali. By using such a binder, use of an organic solvent which is preferably not used in the developer from the environmental concern can be avoided or limited to a very small amount. In such a case, the acid value (acid content per 1 g of polymer, expressed by the chemical equivalent number) and molecular weight of the binder polymer are appropriately selected by taking account of the image strength and the developability. The binder polymer preferably has an acid value of 0.4 to 3.0 meq/g and a molecular weight of 3,000 to 500,000 in terms of the weight average molecular weight, more preferably an acid value of 0.6 to 2.0 meq/g and a molecular weight of 10,000 to 300,000.

[D. Other Components]

The photosensitive composition of the present invention may further appropriately contain other components suitable for use, production method and the like. Preferred additives are described below.

(D1) Co-sensitizer

The sensitivity can be further improved by using a certain kind of additive (hereinafter referred to as a "co-sensitizer"). The operation mechanism thereof is not clearly known but is considered to mostly rely on the following chemical process. That is, the co-sensitizer reacts with various intermediate active species (e.g., radical, peroxide, oxidant, reductant) generated in the process of photoreaction initiated by the light absorption of the above-described initiation system and subsequent addition polymerization reaction, to produce a new active radical. Such compounds are roughly classified into (a) a compound which is reduced to produce an active radical, (b) a compound which is oxidized to produce an active radical and (c) a compound which react with a radical having low activity to convert it into a more highly active radical or act as a chain transfer agent. However, in many cases, a common view is not present about which compound belongs to which type.

(a) Compound which is Reduced to Produce Active Radical

Compound Having Carbon-Halogen Bond:

An active radical is considered to be generated by the reductive cleavage of carbon-halogen bond. Specific examples of the compound which can be suitably used include trihalomethyl-s-triazines and trihalomethyloxadiazoles.

Compound Having Nitrogen-Nitrogen Bond:

An active radical is considered to be generated by the reductive cleavage of nitrogen-nitrogen bond. Specific examples of the compound which can be suitably used include hexaarylbiimidazoles.

Compound Having Oxygen-Oxygen Bond:

An active radical is considered to be generated by the reductive cleavage of oxygen-oxygen bond. Specific examples of the compound which can be suitably used include organic peroxides.

Onium Compound:

An active radical is considered to be generated by the reductive cleavage of carbon-hetero bond or oxygen-nitrogen bond. Specific examples of the compound which can be suitably used include diaryliodonium salts, triarylsulfonium salts and N-alkoxypyridinium (azinium) salts.

Ferrocene and Iron Allene Complexes:

An active radical can be reductively produced.

(b) Compound which is Oxidized to Produce Active Radical

Allrylaxe Complex:

An active radical is considered to be generated by the oxidative cleavage of carbon-hetero bond. Specific examples of the compound which can be suitably used include triaryl alkylborates.

Alkylamine compound:

An active radical is considered to be generated by the oxidative cleavage of C-3C bond on the carbon adjacent to nitrogen, where X is preferably a hydrogen atom, a carboxyl group, a trimethylsilyl group or a benzyl group. Specific examples of the compound include ethanolamines, N-phenylglycines and N-trimethylsilyhnethylanilines.

Sulfur- or Tin-Containing Compound:

This is a compound in which the nitrogen atom of the above-described amines is replaced by a sulfur atom or a tin atom. An active radical is produced by the same action. Also, a compound having an S-S bond is known to effect sensitization by the cleavage of S-S.

$\alpha$-Substituted Methylcarbonyl Compound:

An active radical is produced by the oxidative cleavage of carbonyl-$\alpha$ carbon bond. The compound in which the carbonyl is converted into an oxime ether also shows the similar action. Specific examples of the compound include 2-alkyl-1-[4-(alkylthio)phenyl]-2-morpholinopronone-1 and oxime ethers thereof obtained by the reaction with a hydroxyamine and subsequent etherification ofN-OH.

Sulfinic Acid Salts:

An active radical is reductively produced. Specific examples of the compound include sodium arylsulfinate.

(c) Compound which Reacts with Radical to Convert it into More Highly Active Radical or Acts as Chain Transfer Agent:

For example, compounds having SH, PH, SiH or GeH within the molecule can be used. These compounds donate hydrogen to a low activity radical species to produce a radical or are oxidized and deprotonized to produce a radical. Specific examples of the compound include 2-mercaptobenzimidazoles.

A large number of examples of the co-sensitizer are more specifically described, for example, in JP-A-9-236913 as an additive for improving sensitivity. Some of these are set forth below, but the present invention is not limited thereto. In the following compounds, -TMS is a trimethylsilyl group.

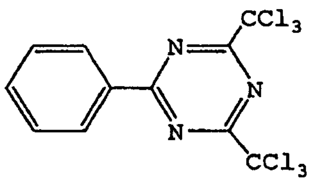
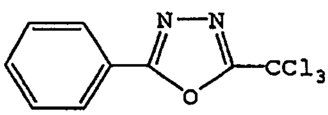
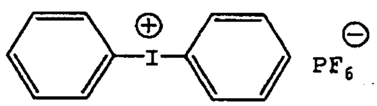

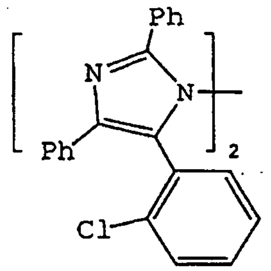

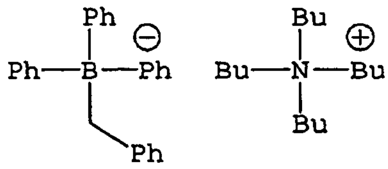

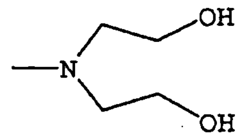

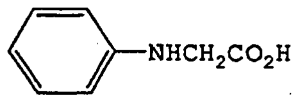

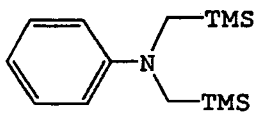

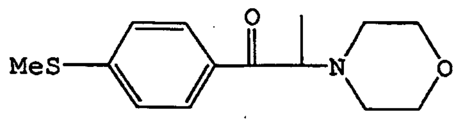

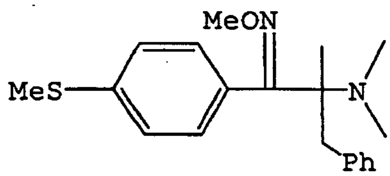

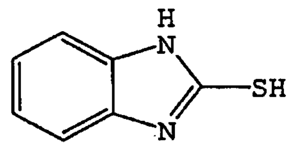

Similarly to the above-described sensitizing dye, the co-sensitizer can be subjected to various chemical modifications so as to improve the properties of the photosensitive layer. For example, methods such as binding to the sensitizing dye, activator, addition-polymerizable unsaturated compound or other parts, introduction of a hydrophilic moiety, introduction of a substituent for improving compatibility, inhibiting crystallization or improving adhesion, and formation of a polymer, may be used.

These co-sensitizers can be used individually or in combination of two or more thereof. The amount of the co-sensitizer used is from 0.05 to 100 parts by weight, preferably from 1 to 80 parts by weight, more preferably from 3 to 50 parts by weight, per 100 parts by weight of the compound having an ethylenically unsaturated double bond.

(D2) Polymerization Inhibitor

In the present invention, a small amount of a thermal polymerization inhibitor is preferably added in addition to the above-described basic components, so as to prevent the polymerizable compound having an ethylenically unsaturated double bond from undergoing undesirable thermal polymerization during the production or storage of the photosensitive composition. Examples of suitable thermal polymerization inhibitors include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6 tert-butylphenol) and N-nitrosophenylhydroxyamine cerium(III) salt. The amount of the thermal polymerization inhibitor added is preferably from about 0.01 to about 5 weight%, based on the weight of the entire composition. If desired, in order to prevent polymerization inhibition by oxygen, a higher fatty acid derivative such as behenic acid or behenic acid amide may be added and allowed to localize on the photosensitive layer surface during drying after the coating. The amount of the higher fatty acid derivative added is preferably from about 0.5 to about 10 weight% based on the entire composition.

(D3) Coloring Agent, etc.

Furthermore, a dye or a pigment may be added for the purpose of coloring the photosensitive layer. By such coloring, so-called plate inspection such as visibility of the printing plate after the plate-making or suitability for an image density meter can be improved. Since many dyes cause reduction in the sensitivity of photopolymerization-system photosensitive layer, a pigment is preferably used as the coloring agent. Specific examples include, pigments such as phthalocyanine-based pigment, azo-based pigment, carbon black and titanium oxide, and dyes such as Ethyl Violet, Crystal Violet, azo-based dye, anthraquinone-based dye and cyanine-based dye. The amount of the dye or pigment added is preferably from about 0.5 to about 5 weight% based on the entire composition.

(D4) Other Additives

Other known additives may be further added, such as inorganic filler and plasticizer for improving the physical properties of the cured film, and oil-sensitizer capable of improving the inking property on the photosensitive layer surface.

Examples of the plasticizer include dioctyl phthalate, didodecyl phthalate, triethylene glycol dicaprylate, dimethyl glycol phthalate, tricresyl phosphate, dioctyl adipate, dibutyl sebacate and triacetylglycerol. In the case of using a binder, the plasticizer can be added in an amount of 10 weight% or less based on the total weight of the compound having an ethylenically unsaturated double bond and the binder.

Also, a UV initiator, a heat crosslinking agent and the like may be added for elevating the effect of heating and exposure after the development and thereby improving the film strength (press life) which will be described later.

In addition, for improving the adhesion between the photosensitive layer and a support or elevating the developing and removing property of unexposed photo-sensitive layer, an additive may be added or an interlayer may be provided. For example, a compound showing a relatively strong interaction with the substrate, such as compound having a diazonium structure or phosphone compound may be added or undercoated, whereby the adhesive property and the press life can be enhanced. Also, by the addition or undercoating of a hydroplulic polymer such as polyacrylic acid or polysulfonic acid, the developability of non-image area is improved and resistance to staining can be improved.

In the case of coating the photopolymerizable composition of the present invention on a support, the composition is used after dissolving it in various organic solvents. Examples of the solvent used here include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, $\gamma$-butyrolactone, methyl lactate and ethyl lactate. These solvents may be used individually or as a mixture. The concentration of solid content in the coating solution is suitably from 2 to 50 weight%.

The coverage of the photosensitive layer on the support affects mainly the sensitivity and developability of photosensitive layer and the strength and press life of exposed layer and therefore, an appropriate coverage is preferably selected according to the use end. If the coverage is too small, press life is not sufficient, whereas if it is excessively large, the sensitivity decreases, as a result, not only the exposure but also the development processing disadvantageously take a longer time. In the case of a lithographic printing plate for scanning exposure, which is a main object of the present invention, the coverage is suitably, in terms of the weight after drying, from about 0.1 to about 10 $g/m^2$, more preferably from 0.5 to 5 $g/m^2$.

[E. Support]

In order to obtain a lithographic printing plate as a main object of the present invention, the above-described photosensitive layer is preferably provided on a support having a hydrophilic surface. As for the hydrophilic support, conventionally known hydrophilic supports used for lithographic printing plates can be used without any limitation. The support used is preferably a dimensionally stable plate-like material, such as paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film having laminated or vapor-deposited thereon the above-described metal. If desired, the surface of the support may be subjected to an appropriate known physical or chemical treatment for the purpose of imparting hydrophilicity, improving the strength or the like.

Among these supports, preferred are paper, polyester film and aluminum plate. In particular, aluminum plate is preferred, because it has good dimensional stability, is relatively inexpensive and can provide a surface having excellent hydrophilicity and strength, if desired, by a surface treatment. Also, a composite sheet comprising a polyethylene terephthalate film having bonded thereon an aluminum sheet described in JP-B-48-18327 is preferred.

The aluminum plate is preferably a pure aluminum plate or an alloy plate mainly comprising aluminum and containing trace hetero-elements. A plastic film laminated or vapor-deposited with aluminum may also be used. Examples of the hetero-element contained in the aluminum alloy include silicon, iron, manganese, copper, magnesium, chromium, zinc, bismuth, nickel and titanium. The hetero-element content in the alloy is at most 10 weight%. The aluminum particularly preferred in the present invention is pure aluminum, but since perfect pure aluminum is difficult to produce in view of the refining technique, the aluminum may contain trace hetero-elements. The composition of the aluminum plate for use in the present invention is not specified and conventionally known aluminum plates in common use can be appropriately used. The thickness of the aluminum plate for use in the present invention is approximately from 0.1 to 0.6 mm, preferably from 0.15 to 0.4 mm, more preferably from 0.2 to 0.3 mm.

In the case of a support having a metal surface, particularly an aluminum surface, the support is preferably subjected to a surface treatment such as surface roughening (graining), dipping in an aqueous solution of sodium silicate, potassium fluorozirconate or phosphate, or anodization.

The surface roughening treatment of the aluminum plate may be performed by various methods such as a method of mechanically roughening the surface, a method of electrochemically dissolving and roughening the surface or a method of selectively dissolving the surface by chemical means. Examples of the mechanical method which can be used include known methods such as ball graining, brush graining, blast graining and buff graining. Examples of the electrochemical surface roughing method include a method of performing the surface roughening in an electrolytic solution such as hydrochloric acid or nitric acid by passing an alternating current or a direct current. A combination of these two kinds of methods disclosed in JP-A-54-63902 may also be used. If desired, in order to remove rolling oil on the surface, a degreasing treatment with a surfactant, an organic solvent, an alkaline aqueous solution or the like is performed in advance of the surface roughening of the aluminum plate.

An aluminum plate which is surface-roughened and then dipped in an aqueous sodium silicate solution may also be preferably used. An aluminum plate subjected to an anodization treatment and then to a dipping treatment in an aqueous alkali metal silicate solution described in JP-B-47-5125 is suitably used. The anodization treatment is performed by passing a current using the aluminum plate as anode in an aqueous or non-aqueous electrolytic solution of an inorganic acid such as phosphoric acid, chromic acid, sulfuric acid or boric acid, an organic acid such as oxalic acid or sulfamic acid, or a salt thereof. These aqueous or non-aqueous electrolytic solutions may be used individually or in combination of two or more thereof.

The silicate electrodeposition method described in U.S. Patent 3,658,662 is also effective.

Furthermore, a surface treatment in which a support subjected to electrolytic graining is combined with the above-described anodization treatment and sodium silicate treatment, disclosed in JP-B-46-27481, JP-A-52-58602 and JP-A-52-30503, is also useful.

Also, a support subjected to mechanical roughening, chemical etching, electrolytic graining, anodization and sodium silicate treatment in this order, disclosed in JP-A-56-28893, is suitably used.

A support which is subjected to, after these treatments, undercoating with a water-soluble resin such as polyvinylphosphonic acid, polymer or copolymer having a sulfonic acid group on the side chain, polyacrylic acid, water-soluble metal salt (e.g., zinc borate), yellow dye, amine salt or the like, is also suitably used.

In addition, a substrate subjected to a sol-gel treatment, where a functional group capable of undergoing an addition reaction by a radical is covalently bonded, disclosed in JP-A-7-154983 may also be suitably used.

Other preferred examples include those obtained by providing a water-resistant hydrophilic layer as a surface layer on an arbitrary support. Examples of the surface layer include a layer comprising an inorganic pigment and a binder described in U.S. Patent 3,055,295 and JP-A-56-13168, a hydrophilic swelling layer described in JP-A-9-80744 and a sol-gel film comprising titanium oxide, polyvinyl alcohol and silicic acids described in JP-T-8-507727 (the term "JP-T" as used herein means a "published Japanese translation of a PCT patent application").

The hydrophilization treatment is performed not only to render the support surface hydrophilic but also to prevent a harmful reaction of the photopolymerizable composition provided thereon and at the same time, to improve adhesive property of the photosensitive layer.

[F. Protective Layer]

In the case of a lithographic printing plate for scan exposure as a preferred embodiment of the present invention, the exposure is generally performed in air and therefore, a protective layer is preferably provided further on the photopolymerizable composition layer. The protective layer prevents low molecular compounds such as oxygen and basic substance present in air, which inhibit the image forming reaction generated upon exposure in the photosensitive layer, from permeating into the photosensitive layer and enables exposure in air. Accordingly, the properties required of the protective layer are to have low permeability to low molecular weight compounds such as oxygen, not to substantially inhibit the transmission of light used for exposure, to exhibit good adhesion to the photosensitive layer and to be easily removable in the development step after exposure. Various designs have been made on the protective layer and are described in detail, for example, in U.S. Patent 3,458,311 and JP-A-55-49729. The material which can be used for the protective layer is suitably, for example, a water-soluble polymer compound having relatively excellent crystallinity. Specifically, water-soluble polymers such as polyvinyl alcohol, polyvinylpyrrolidone, acidic celluloses, gelatin, gum arabic and polyacrylic acid are known. Among these, when polyvinyl alcohol is used as the main component, most excellent results can be obtained in view of fundamental properties such as oxygen blocking property and removability by development.

The polyvinyl alcohol used for the protective layer may be partially replaced with an ester, an ether or an acetal

as long as it contains an unsubstituted vinyl alcohol unit for giving necessary oxygen blocking property and water solubility. Similarly, a part may have another copolymerization component. Examples of the polyvinyl alcohol include those having a hydrolysis degree of 71 to 100 mol% and a molecular weight of 300 to 2,400 in terms of the weight average molecular weight. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (selection of PVA, use of additives), coated amount and the like of the protective layer are determined by taking account of the oxygen blocking property, development removability, fogging, adhesive property and scratch resistance. In general, as the hydrolysis degree of PVA used is higher (as the unsubstituted vinyl alcohol unit content in the protective layer is higher) and as the layer thickness is larger, the oxygen blocking property becomes higher, which is advantageous in view of sensitivity. However, if the oxygen blocking property is excessively elevated, there arise problems, for example, an unnecessary polymerization reaction takes place during the production or stock storage, or undesirable fogging or thickening of image lines is caused at the time of image exposure. The adhesion to the image area and scratch resistance are also very important in view of handling of the plate. The method for coating such a protective layer is described in detail, for example, in U.S. Patent 3,458,311 and JP-A-55-49729.

Other functions may also be imparted to the protective layer. For example, when a coloring agent (e.g., water-soluble dye) ensuring excellent transmission of light at 350 nm to 450 nm used for exposure and being capable of efficiently absorbing light at 500 nm or more is added, the aptitude for safelight can be enhanced without causing decrease in the sensitivity.

[G. Image Forming Method and Plate-Making Process]

In the case where a photosensitive material using the photosensitive composition of the present invention is used as an image-forming material, an image is usually obtained by performing image exposure and then removing the unexposed area of the photosensitive layer with a developer. Examples of the developer preferred in using such a photosensitive composition for the production of a lithographic printing plate include a developer described in JP-B-57-7427. The developer is suitably an aqueous solution of an inorganic alkali agent such as sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate and aqueous ammonia, or an organic alkali agent such as monoethanolamine and diethanolamine. Such an alkali agent is added to give an alkali solution having a concentration of 0.1 to 10 weight%, preferably from 0.5 to 5 weight%.

If desired, such an alkaline aqueous solution may contain a small amount of a surfactant or an organic solvent such as benzyl alcohol, 2-phenoxyethanol and 2-butoxyethanol. Examples thereof include those described in U.S. Patents 3,375,171 and 3,615,480.

Furthermore, developers described in JP-A-50-26601, JP-A-58-54341, JP-B-56-39464 and JP-B-56-42860 are also excellent.

In particular, the developer is preferably the developer described in JP-A-2002-202616, containing a nonionic compound represented by the following formula (IV) and having a pH of 11.5 to 12.8 and an electric conductivity of 3 to 30 mS/cm.

$$A\text{-}W \qquad \text{(IV)}$$

wherein A represents a hydrophobic organic group having logP of 1.5 or more as A-H, and W represents a nonionic hydrophilic organic group having logP of less than 1.0 as W-H.

This developer component is described in detail in JP-A-2002-202616 (paragraphs (0024) to (0067)).

In the present invention, it is effective to add the nonionic compound represented by formula (IV) in an amount of 0.1 to 15 weight%, preferably from 1.0 to 8.0 weight%, in the developer.

In the plate-making process of the lithographic printing plate of the present invention, the entire surface may also be heated, if desired, before or during the exposure or between the exposure and the development. This heating is advantageous in that the image formation reaction in the photosensitive layer is accelerated, the sensitivity and press life are enhanced, and the sensitivity is stabilized. Furthermore, for the purpose of improving the image strength and press life, it is also effective to subject the entire surface of the developed image to post-heating or exposure. Usually, the heating before the development is preferably performed under a mild condition of 150°C or less. When the heating temperature is 150°C or less, the problem of fogging in the non-image area does not arise. The heating after the development uses a very severe condition of usually from 200 to 500°C. When the temperature is 200°C or more, a sufficiently high effect of strengthening the image is obtained and when the temperature is 500°C or less, there arises

no problem such as deterioration of support or thermal decomposition of image area.

As for the method of exposing the lithographic printing plate for scan exposure of the present invention, known methods can be used without limitation. The wavelength of light source is preferably from 350 to 450 nm, and specifically, an InGaN-based semiconductor laser is preferred. The exposure mechanism may be any of internal drum system, external drum system and flat bed system. In addition, the photosensitive layer of the present invention can be made soluble in neutral or alkalescent water by using highly water-soluble components, and a lithographic printing plate having such a construction can be processed by a system of loading the plate on a printing press and then performing exposure-development on the press.

The laser light source of 350 to 450 nm which is available and usable includes the followings.

The gas laser includes an Ar ion laser (364 nm, 351 nm, from 10 mW to 1 W), a Kr ion laser (356 nm, 351 nm, from 10 mW to 1 W) and a He-Cd laser (441 nm, 325 nm, from 1 to 100 mW); the solid laser includes a combination of Nd:YAG ($YVO_4$) with SHG crystalx2 times (355 nm, from 5 mW to 1 W), and a combination of Cr:LiSAF with SHG crystal (430 nm, 10 mW); the semiconductor laser system includes a $KNbO_3$ ring resonator (430 nm, 30 mW), a combination of a wave guide-type wavelength conversion element with an AlGaAs or InGaAs semiconductor (from 380 to 450 nm, from 5 to 100 mW), a combination of a wave guide-type wavelength conversion element with an AlGaInP or AlGaAs semiconductor (from 300 to 350 nm, from 5 to 100 mW), and AlGaInN (from 350 to 450 nm, from 5 to 30 mW); and the pulse laser includes an $N_2$ laser (337 nm, pulse: from 0.1 to 10 mJ), and XeF (351 nm, pulse: from 10 to 250 mJ).

Among these light sources, an AlGaInN semiconductor laser (commercially available InGaN system semiconductor laser, from 400 to 410 nm, from 5 to 30 mW) is preferred in view of wavelength properties and cost.

As for the exposure apparatus using a scan exposure system for lithographic printing plates, the exposure mechanism includes an internal drum system, an external drum system and a flat bed system, and all of the above-described light sources excluding pulse lasers can be used as the light source. In practice, the following exposure devices are particularly preferred in view of relationship between the sensitivity of photosensitive material and the plate-making time:

a single beam exposure apparatus employing an internal drum system and using one gas or solid laser light source,
a multi-beam exposure apparatus employing a flat bed system and using a number (10 or more) of semiconductor lasers, and
a multi-beam exposure apparatus employing an external drum system and using a number (10 or more) of semiconductor lasers.

In the above-described laser direct drawing-type lithographic printing plate, the following equation (eq 1) is generally established among sensitivity X (J/cm$^2$) of photosensitive material, exposure area S (cm$^2$) of photosensitive material, power q (W) of one laser light source, number n of lasers, and entire exposure time t (s):

$$X \cdot S = n \cdot q \cdot t \qquad \text{(eq 1)}$$

i) In the case of an internal drum (single beam) system, the following equation (eq 2) is generally established among rotation number f (radian/s) of laser, sub-scanning length Lx (cm) of photosensitive material, resolution Z (dot/cm), and entire exposure time t (s):

$$f \cdot Z \cdot t = Lx \qquad \text{(eq 2)}$$

ii) In the case of an external drum (multi-beam) system, the following equation (eq 3) is generally established among rotation number F (radian/s) of drum, sub-scanning length Lx (cm) of photosensitive material, resolution Z (dot/cm), entire exposure time t (s), and number (n) of beams:

$$F \cdot Z \cdot n \cdot t = Lx \qquad \text{(eq 3)}$$

iii) In the case of a flat bed (multi-beam) system, the following equation (eq 4) is generally established among rotation number H (radian/s) of polygon mirror, sub-scanning length Lx (cm) of photosensitive material, resolution Z (dot/cm), entire exposure time t (s), and number (n) of beams:

$$H \cdot Z \cdot n \cdot t = Lx \qquad \text{(eq 4)}$$

When the resolution (2,560 dpi) required of the actual printing plate, the plate size (A1/B1, sub-scanning length: 42 inch), the exposure condition of about 20 plates/hour and the photosensitive properties (photosensitive wavelength, sensitivity: about 0.1 $mJ/cm^2$) of the photosensitive composition for use in the present invention are substituted to the above-described equations, it can be understood that a combination of the photosensitive material of the present invention with a semiconductor laser multi-beam exposure system is preferred. Furthermore, when the operability, cost and the like are also taken account of, a combination with a semiconductor laser multi-beam exposure apparatus employing an external drum system is most preferred.

Other examples of the exposure light source which can be used for the photosensitive composition of the present invention include an ultrahigh-pressure mercury lamp, a high-pressure mercury lamp, a medium-pressure mercury lamp, a low-pressure mercury lamp, a chemical lamp, a carbon arc lamp, a xenon lamp, a metal halide lamp, various visible or ultraviolet laser lamps, a fluorescent lamp, a tungsten lamp and sunlight. The photosensitive composition of the present invention can be widely applied without limitation to those known as uses of photocurable resin, in addition to the lithographic printing plate for scan exposure. For example, when the photosensitive composition of the present invention is applied to a liquid photopolymerizable composition using, if desired, a cationic polymerizable compound in combination, a high-sensitivity material for stereolithography can be obtained. Also, a hologram material may be provided by utilizing the change in the refractive index resulting from photopolymerization. Furthermore, application to various transfer materials (e.g., peelable photosensitive material, toner developable photosensitive material) may be realized by utilizing the change in the surface viscosity resulting from photopolymerization. In addition, the photosensitive composition of the present invention can be applied to photocuring of a microcapsule, production of an electronic material such as photoresist, or photocurable resin materials such as ink, paint and adhesive.

## EXAMPLES

The present invention is described below by referring to Examples, but the present invention should not be construed as being limited to these Examples.

[Synthesis Example of N-Oxyamide Compound A (Synthesis Example 1)]

First, 20.0 g of N-hydroxyphthalimide was dissolved in 12.4 g of triethylamine and 80 ml of dimethylacetamide (DMAc), and the resulting solution was stirred under ice cooling. Thereto, 12.5 g of acetic anhydride was added dropwise through a dropping funnel over 3 minutes. After stirring at room temperature for 1 hour, the precipitated crystal was filtered, and the filtrate was washed twice with 50 ml of water and then washed once with 50 ml of methanol, as a result, 24.5 g of Compound A shown below could be obtained.

A:

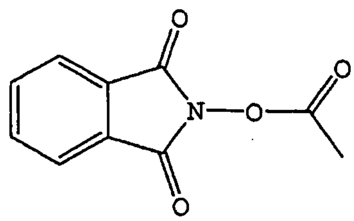

[Synthesis Example of N-Oxyamide Compound B]

Compound B (28.5 g) shown below was obtained in the same manner as in Synthesis Example 1 except for using 17.2 g of benzoyl chloride in place of acetic anhydride.

B:

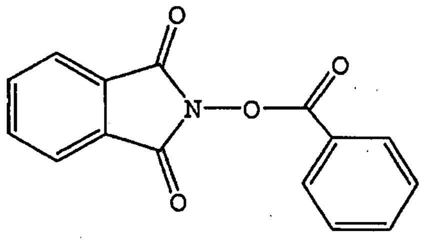

[Synthesis Example of N-Oxyamide Compound C]

Compound C (26.3 g) shown below was obtained in the same manner as in Synthesis Example 1 except for using 12.8 g of methacrylic acid chloride in place of acetic anhydride.

C:

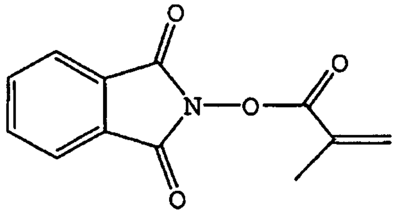

[Synthesis Example of N-Oxyamide Compound D]

Compound D (38.3 g) shown below was obtained in the same manner as in Synthesis Example 1 except for using 21.5 g of p-methoxybenzoyl chloride in place of acetic anhydride.

D:

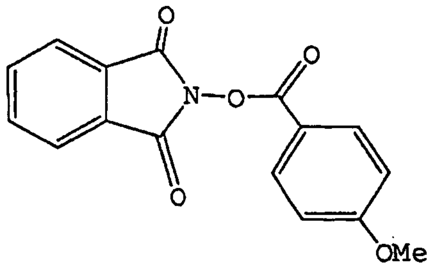

[Synthesis Example of N-Oxyamide Compound E]

Compound E (30.2 g) shown below was obtained in the same manner as in Synthesis Example 1 except for using 36.9 g of tetrachlorophthalimide in place of N-hydroxyphthalimide.

E:

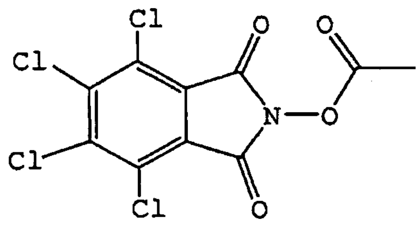

[Synthesis Example of N-Oxyamide Compound F]

Compound F (23.2 g) shown below was obtained in the same manner as in Synthesis Example 1 except for using 28.8 g of tetrafluorophthalimide in place of N-hydroxyphthalimide.

F:

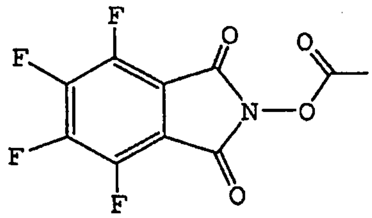

[Synthesis Example of N-Oxyamide Compound G]

First, 20.0 g of benzohydroxamic acid was dissolved in 14.8 g of triethylamine and 80 ml of DMAc, and the resulting solution was stirred under ice cooling. Thereto, 20.5 g of benzoyl chloride was added dropwise through a dropping funnel over 3 minutes. After stirring at room temperature for 1 hour, the precipitated crystal was filtered, and the filtrate was washed twice with 50 ml of water and then washed once with 50 ml of methanol, as a result, 33.4 g of Compound G shown below could be obtained.

G:

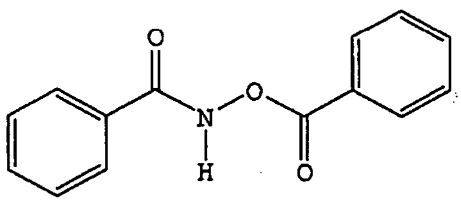

[Synthesis Example of N-Oxyamide Compound H]

First, 9.9 g of hydroxylamine hydrochloride, 43.4 g of triethylamine, 30 ml of water and 15 ml of DMAc were stirred under ice cooling and thereto, 50.0 g of 4-chlorobenzoyl chloride was added dropwise through a dropping funnel over 3 minutes. After stirring at room temperature for I hour, the reaction solution was charged into 1,000 ml of water, the precipitated crystal was filtered, and the filtrate was washed twice with 50 ml of water and then washed once with 50 ml of methanol, as a result, 25.4 g of Compound H shown below could be obtained.

H:

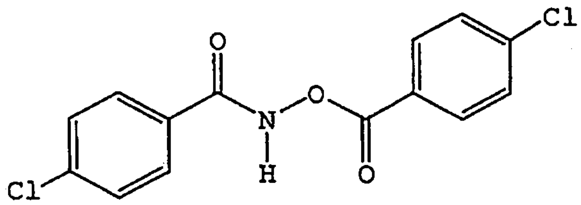

[Synthesis Example of N-Oxyamide Compound I]

First, 10.0 g of benzohydroxamic acid, 10.9 g of benzoylformic acid and 200 mg of p-toluenesulfonic acid monohydrate were dissolved in 100 ml of toluene, and the resulting solution was stirred for 6 hours under reflux with a Dien-Stark reaction tube while removing water. Subsequently, the reaction solution was distilled under reduced pressure, and the produced crystal was dissolved in acetone and charged in 100 ml of water. Thereafter, the precipitated crystal was filtered, and the filtrate was washed twice with 10 ml of water and then washed once with 10 ml of methanol, as a result, 5.4 g of Compound I shown below could be obtained.

I:

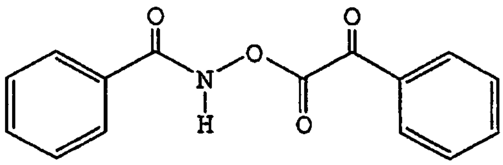

[Synthesis Example of N-Oxyamide Compound J]

First, 10.0 g of N-hydroxyphthalimide, 10.5 g of benzyl bromide, 100 mg of KI and 2.5 g of NaOH were dissolved in 70 ml of DMAc and 70 ml of water, and the resulting solution was stirred at 80°C for 6 hours. After cooling the reaction solution to room temperature, the produced crystal was filtered, and the filtrate was washed twice with 30 ml of water and then washed once with 30 ml of methanol, as a result, 10.8 g of Compound J shown below could be obtained.

J:

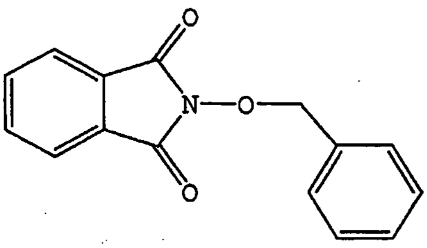

[Synthesis Example of N-Oxyamide Compound K]

First, 10.0 g of N-hydroxyphthalimide, 10.4 g of methyl iodide, 100 mg of KI and 2.5 g of NaOH were dissolved in 50 ml of DMAc and 50 ml of water, and the resulting solution was stirred at 80°C for 6 hours. After cooling the reaction solution to room temperature, the produced crystal was filtered, and the filtrate was washed twice with 30 ml of water and then washed once with 20 ml of methanol, as a result, 2.8 g of Compound K shown below could be obtained.

K:

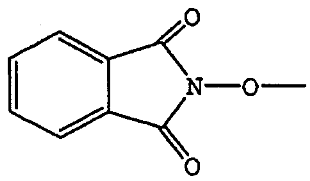

[N-Oxyamide Compound L]

N-Oxyamide Compound L having the following structure, produced by Aldrich, was used.

L:

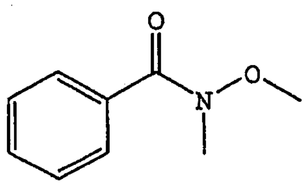

[Production Example of Support]

(Support 1: Production of Anodized Aluminum Support)

The surface of a 0.3 mm-thick IS aluminum plate was grained by using a No. 8 nylon brush and a water suspension of 800-mesh pumice stone and then thoroughly washed with water. Subsequently, the aluminum plate was etched by dipping it in 10% sodium hydroxide solution at 70°C for 60 seconds, washed with running water, neutralized and cleaned with 20% $HNO_3$ and then water washed. This plate was subjected to an electrolytic surface roughening treatment in an aqueous 1% nitric acid solution using an alternating current with a sinusoidal waveform at an anodic time electricity of 300 coulomb/$dm^2$ under the condition of VA=12.7 V. The surface roughness was measured and found to be 0.45 μm (Ra indication). Thereafter, the plate was desmutted by dipping it in an aqueous 30% $H_2SO_4$ solution at 55°C for 2 minutes and after disposing a cathode on the grained surface in an aqueous 20% $H_2SO_4$ solution at 33°C, the plate was anodized at a current density of 5 A/$dm^2$ for 50 seconds, as a result, the thickness of anodic oxide film was 2.7 g/$m^2$. This was designated as Support 1.

(Production of Support 2)

On Support 1 produced above, the following Undercoat Liquid Composition 2 for surface treatment was coated to give an Si coverage of about 0.001 g/$m^2$, and dried at 100°C for 1 minute. This was designated as Support 2.

<Undercoat Liquid Composition 2>

The following components were mixed and stirred. After about 5 minutes, the generation of heat was observed. The reaction was allowed to proceed for 60 minutes and then, the content of the reaction vessel was transferred to another vessel. Thereto, 30,000 parts by weight of methanol was further added. The obtained composition was designated as Liquid Composition 2.

| | |
|---|---|
| Phosmer PE produced by Uni-Chemical Co., Ltd. | 20 parts by weight |
| Methanol | 130 parts by weight |
| Water | 20 parts by weight |
| Paratoluenesulfonic acid | 5 parts by weight |
| Tetraethoxysilane | 50 parts by, weight |
| 3-Methacryloxypropyltriethoxysilane | 50 parts by weight |

(Production of Support 3)

On Support 1 produced above, a solution obtained by dissolving a methyl methacrylate/ethyl acrylate/sodium 2-acrylamide-2-methylpropanesulfonate copolymer (60/25/15 (by mol), molecular weight Mn: 30,000) in water/methanol (=5 g/95 g) was coated to give a coated amount of 3 $mg/m^2$, and dried at 80°C for 30 seconds. This was designated as Support 3.

[Production Example of Lithographic Printing Plate Precursor]

On each of the thus-produced Supports 1 to 3, a photopolymerizable composition having the following composition was coated to give a dry coated weight shown in Table 1, and dried at 95°C to form a photopolymerizable layer.

(Coating Solution for Photopolymerizable Layer (Photopolymerizable Composition): details are shown in Table 1 below)

| | |
|---|---|
| Addition-polymerizable compound (A) | shown in Table 1 |
| Binder polymer (B) | shown in Table 1 |
| Sensitizer (D) | 0.10 parts by weight |
| Initiator (I) | 0.05 parts by weight |
| Additive (H) | 0.25 parts by weight |
| Fluorine-containing surfactant (Megafac F-177, produced by Dai-Nippon Ink & Chemicals, Inc.) | 0.02 parts by weight |
| Thermal polymerization inhibitor (N-nitrosohydroxylamine aluminum salt) | 0.03 parts by weight |
| Dispersion of ε-type copper phthalocyanine | 0.2 parts by weight |
| Methyl ethyl ketone | 16.0 parts by weight |
| Propylene glycol monomethyl ether | 16.0 parts by weight |
| N-Oxyamide compound of the present invention | 0.10 parts by weight |

Table 1 <Photosensitive Layer>

| | Support | Amount Coated ($g/m^2$) | Addition-Polymerizable Compound | | Binder Polymer | | Sensitizing Dye, D | Initiator, I | Additive, H |
|---|---|---|---|---|---|---|---|---|---|
| | | | A | parts by weight | B | parts by weight | | | |
| Photosensitive Layer 1 | 1 | 1.4 | A1 | 0.8 | B1 | 0.9 | D1 | I1 | H1 |
| Photosensitive Layer 2 | 1 | 1.4 | A1 | 0.8 | B1 | 0.9 | D1 | I1 | H3 |
| Photosensitive Layer 3 | 1 | 1.4 | A1 | 0.8 | B1 | 0.9 | D3 | I1 | H1 |
| Photosensitive Layer 4 | 2 | 1.8 | A2 | 0.9 | B3 | 0.7 | D1 | I1 | H1 |
| Photosensitive Layer 5 | 2 | 1.8 | A4 | 0.9 | B3 | 0.7 | D1 | I1 | H1 |
| Photosensitive Layer 6 | 2 | 1.8 | A4 | 0.9 | B3 | 0.7 | D1 | I1 | H2 |
| Photosensitive Layer 7 | 3 | 2.0 | A1 | 1.2 | B1 | 1.0 | D2 | I1 | H1 |

The addition-polymerizable compound (A), binder polymer (B), sensitizer (D), photoinitiator (I) and additive (H) used in the coating solution for the photopolymerizable layer are shown below.

A1 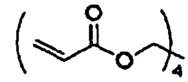

A2 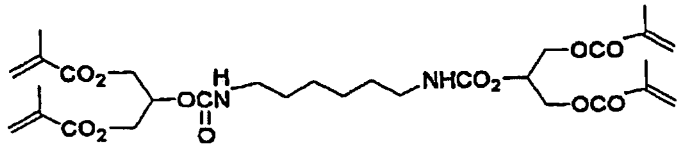

A3 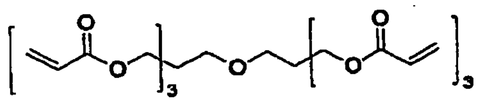

A4 A mixture of isomers:

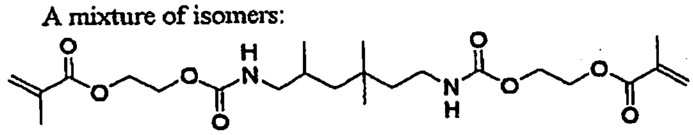

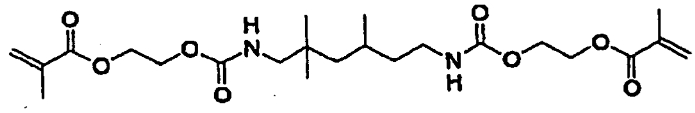

B1 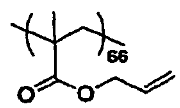 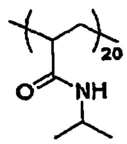 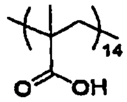

B2 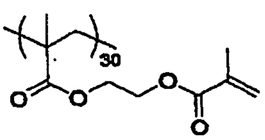 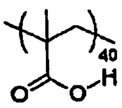 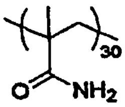 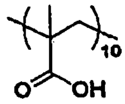

B3 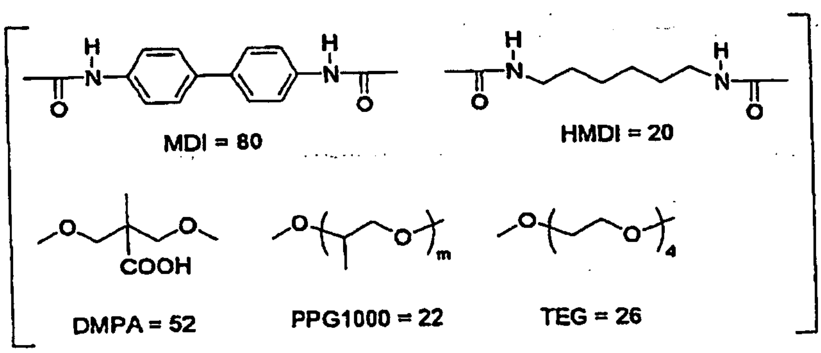

MDI = 80

HMDI = 20

DMPA = 52

PPG1000 = 22

TEG = 26

H1

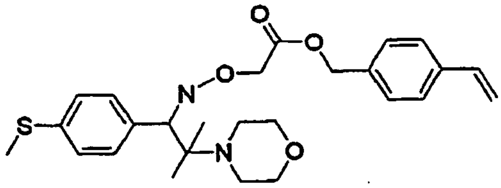

H2

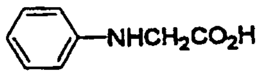

H3

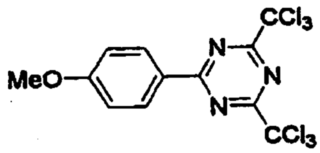

I1

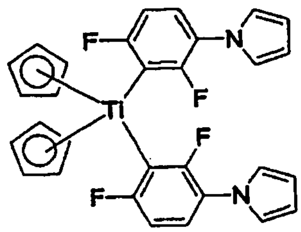

D1

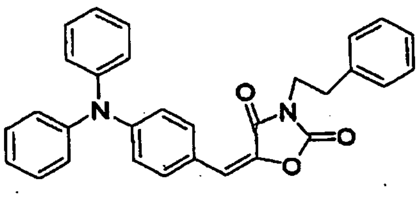

D2

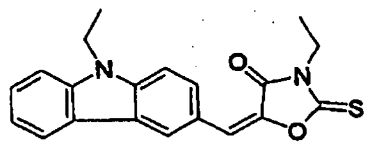

D3

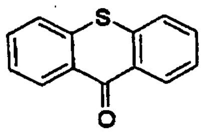

[Coating of Protective Layer]

On the photosensitive layer formed above, an aqueous 3 weight% polyvinyl alcohol (saponification degree: 98 mol%, polymerization degree: 550) solution was coated to give a dry coated weight of 2 $g/m^2$ and dried at 100°C for 2 minutes.

(Exposure)

Exposure 1 (Photosensitive Layers 1 to 4, 6 and 7 and Comparative Photosensitive Layer 1)

The lithographic printing plate precursors having Photosensitive Layers 1 to 4, 6 and 7 and Comparative Photosensitive Layer 1 each was subjected to scan exposure of a solid image or a halftone image of 1 to 99% (in steps of 1%) by using a violet LD (Violet-Boxer, manufactured by FFEI) at a wavelength of 405 nm with an exposure amount of 50 $\mu J/cm^2$ under the conditions of 4,000 dpi and 175 lines/inch.

Exposure 2 (Photosensitive Layer 5)

The lithographic printing plate precursor having Photosensitive Layer 5 was subjected to scan exposure of a solid image or a halftone image of 1 to 99% (in steps of 1%) by using an FD-YAG laser (Plate Jet 4, manufactured by CSI Co., 532 nm) with an exposure amount of 100 $\mu J/cm^2$ under the conditions of 4,000 dpi and 175 lines/inch.

(Development)

A standard processing was performed in an automatic developing machine (LP-850P2, manufactured by Fuji Photo Film Co., Ltd.) where Developer 1 (or 2) and a finishing gum solution FP-2W (produced by Fuji Photo Film Co., Ltd.) were charged. The preheating condition was such that the peak temperature on the plate surface was 100°C. The developer temperature was 30°C, and the dipping time in developer was about 15 seconds.
Developers 1 and 2 each had the following composition, the pH at 25°C was 11.5 (Developer 1) and 12.3 (Developer 2), and the electric conductivity was 5 mS/cm (Developer 1) and 17 mS/cm (Developer 2).

(Composition of Developer 1)

| | |
|---|---|
| Potassium hydroxide | 0.15 g |
| Polyoxyethylene phenyl ether (n=13) | 5.0 g |
| Chilest 400 (chelating agent) | 0.1 g |
| Water | 94.75 g |

(Composition of Developer 2)

| | |
|---|---|
| 1 K-potassium silicate | 2.5 g |
| Potassium hydroxide | 0.15 g |
| Polyoxyethylene phenyl ether (n=13) | 5.0 g |
| Chilest 400 (chelating agent) | 0.1 g |
| Water | 92.25 g |

[Evaluation of Printing, etc.]

The sensitivity, storage stability, press life and antiscumming property of each of these lithographic printing plate precursors were evaluated by the following methods. The results are shown together in Tables 2 to 8.

(Evaluation of Sensitivity)

The printing plates were exposed under respective conditions and immediately developed under the conditions shown in Tables 2 to 8, thereby forming an image. At this time, the area % of 50% halftone dot was measured by a halftone dot area measuring meter (manufactured by Gretag-Macbeth). As the numeral is larger, the sensitivity is higher.

(Test of Press Life of Image Area)

Using a printing press R201 manufactured by Roland Co. and an ink GEOS-G(N) produced by Dai-Nippon Ink & Chemicals, Inc., the test was performed. The printed matter of solid image area was observed, and the press life was examined by the number of sheets when the image started thinning. As the numeral is larger, the press life is better.

(Enforced Test of Press Life of Halftone Part)

Using a printing press R201 manufactured by Roland Co. and an ink GEOS-G(N) produced by Dai-Nippon Ink & Chemicals, Inc., the test was performed. At the 5,000th sheet from the initiation of printing, the halftone part was wiped with a printing sponge impregnated with PS Plate Cleaner CL-2 produced by Fuji Photo Film Co., Ltd. to clean the ink

on the plate surface. Thereafter, 10,000 sheets were printed and the presence or absence of plate slipping of dots on the printed matter was observed with an eye.

(Test of Scumining Resistance of Non-Image Area)

Using a printing press R201 manufactured by Roland Co. and an ink GEOS-G(S) produced by Dai-Nippon Ink & Chemicals, Inc., the test was performed. The printed matter of non-image area (unexposed area) was observed and the scumming resistance was evaluated.

(Evaluation of Storage Stability)

The halftone dot area was measured thoroughly in the same manner as in the evaluation of sensitivity except that the lithographic printing plate precursor was used after it was hermetically packaged in an aluminum kraft paper with inserting paper and left standing at 60°C for 4 days. Then the difference between the halftone dot area with standing at 60°C for 4 days and the halftone dot area without standing at 60°C for 4 days was measured, and the dot fluctuation (Δ%) due to enforced aging was determined. As the absolute value of this numeral is smaller, the effect by the enforced aging is smaller, that is, the storage safety is higher.
The results are shown in Tables 2 to 8.

Table 2

| | | Example | | | | | | | | | | | | Comparative Example |
|---|---|---|---|---|---|---|---|---|---|---|---|---|---|---|
| | | 1 | 2 | 3 | 4 | 5 | 6 | 7 | 8 | 9 | 10 | 11 | 12 | 1 |
| Photosensitive layer | | 1 | 1 | 1 | 1 | 1 | 1 | 1 | 1 | 1 | 1 | 1 | 1 | 1 |
| N-Oxyamide compound | | A | B | C | D | E | F | G | H | I | J | K | L | none |
| Developer | | 1 | 1 | 1 | 1 | 1 | 1 | 1 | 1 | 1 | 1 | 1 | 1 | 1 |
| Sensitivity(%), 50% halftone dot area | | 62 | 62 | 61 | 62 | 62 | 62 | 61 | 62 | 61 | 60 | 60 | 60 | 55 |
| Variation in enforced aging | | 3.0 | 3.0 | 3.5 | 3.0 | 3.0 | 3.0 | 3.0 | 3.0 | 3.0 | 3.0 | 3.0 | 3.0 | 3.0 |
| Printing Perform-ance | Press life of image area (sheets) | 80,000 | 75,000 | 75,000 | 80,000 | 85,000 | 85,000 | 75,000 | 80,000 | 80,000 | 70,000 | 70,000 | 70,000 | 34,000 |
| | Press life of halftone part | good | good | good | good | good | good | good | good | good | good | good | good | good |
| | Scumming resistance of non-image area | good | good | good | good | good | good | good | good | good | good | good | good | good |

Table 3

| | | Example | | | | | | | | | | | | Comparative Example |
|---|---|---|---|---|---|---|---|---|---|---|---|---|---|---|
| | | 13 | 14 | 15 | 16 | 17 | 18 | 19 | 20 | 21 | 22 | 23 | 24 | 2 |
| Photosensitive layer | | 2 | 2 | 2 | 2 | 2 | 2 | 2 | 2 | 2 | 2 | 2 | 2 | 2 |
| N-Oxyamide compound | | A | B | C | D | E | F | G | H | I | J | K | L | none |
| Developer | | 1 | 1 | 1 | 1 | 1 | 1 | 1 | 1 | 1 | 1 | 1 | 1 | 1 |
| Sensitivity(%), 50% halftone dot area | | 60 | 60 | 59 | 60 | 60 | 60 | 59 | 60 | 59 | 58 | 58 | 58 | 54 |
| Variation in enforced aging | | 3.0 | 3.0 | 3.5 | 3.0 | 3.0 | 3.0 | 3.0 | 3.0 | 3.0 | 3.0 | 3.0 | 3.0 | 3.0 |
| Printing Perform-ance | Press life of image area (sheets) | 60,000 | 55,000 | 55,000 | 60,000 | 65,000 | 65,000 | 55,000 | 60,000 | 60,000 | 50,000 | 50,000 | 50,000 | 30,000 |
| | Press life of halftone part | good | good | good | good | good | good | good | good | good | good | good | good | good |
| | Scumming resistance of non-image area | good | good | good | good | good | good | good | good | good | good | good | good | good |

Table 4

| | | Example | | | | | | | | | | | | Comparative Example |
|---|---|---|---|---|---|---|---|---|---|---|---|---|---|---|
| | | 25 | 26 | 27 | 28 | 29 | 30 | 31 | 32 | 33 | 34 | 35 | 36 | 3 |
| Photosensitive layer | | 3 | 3 | 3 | 3 | 3 | 3 | 3 | 3 | 3 | 3 | 3 | 3 | 3 |
| N-Oxyamide compound | | A | B | C | D | E | F | G | H | I | J | K | L | none |
| Developer | | 1 | 1 | 1 | 1 | 1 | 1 | 1 | 1 | 1 | 1 | 1 | 1 | 1 |
| Sensitivity(%), 50% halftone dot area | | 58 | 58 | 57 | 58 | 58 | 58 | 57 | 58 | 57 | 56 | 56 | 56 | 52 |
| Variation in enforced aging | | 3.0 | 3.0 | 3.5 | 3.0 | 3.0 | 3.0 | 3.0 | 3.0 | 3.0 | 3.0 | 3.0 | 3.0 | 3.0 |
| Printing Perform-ance | Press life of image area (sheets) | 50,000 | 45,000 | 45,000 | 50,000 | 55,000 | 55,000 | 45,000 | 50,000 | 50,000 | 40,000 | 40,000 | 40,000 | 20,000 |
| | Press life of halftone part | good | good | good | good | good | good | good | good | good | good | good | good | good |
| | Scumming resistance of non-image area | good | good | good | good | good | good | good | good | good | good | good | good | good |

Table 5

| | | Example | | | | | | | | | | | | Comparative Example |
|---|---|---|---|---|---|---|---|---|---|---|---|---|---|---|
| | | 37 | 38 | 39 | 40 | 41 | 42 | 43 | 44 | 45 | 46 | 47 | 48 | 4 |
| Photosensitive layer | | 4 | 4 | 4 | 4 | 4 | 4 | 4 | 4 | 4 | 4 | 4 | 4 | 4 |
| N-Oxyamide compound | | A | B | C | D | E | F | G | H | I | J | K | L | none |
| Developer | | 2 | 2 | 2 | 2 | 2 | 2 | 2 | 2 | 2 | 2 | 2 | 2 | 2 |
| Sensitivity(%), 50% halftone dot area | | 62 | 62 | 61 | 62 | 62 | 62 | 61 | 62 | 61 | 60 | 60 | 60 | 53 |
| Variation in enforced aging | | 3.5 | 3.5 | 4.0 | 3.5 | 3.5 | 3.5 | 3.5 | 3.5 | 3.5 | 3.5 | 3.5 | 3.5 | 3.5 |
| Printing Perform-ance | Press life of image area (sheets) | 140,000 | 120,000 | 120,000 | 140,000 | 160,000 | 160,000 | 120,000 | 140,000 | 140,000 | 110,000 | 110,000 | 110,000 | 80,000 |
| | Press life of halftone part | good | good | good | good | good | good | good | good | good | good | good | good | good |
| | Scumming resistance of non-image area | good | good | good | good | good | good | good | good | good | good | good | good | good |

Table 6

| | | Example | | | | | | | | | | | | Comparative Example |
|---|---|---|---|---|---|---|---|---|---|---|---|---|---|---|
| | | 49 | 50 | 51 | 52 | 53 | 54 | 55 | 56 | 57 | 58 | 59 | 60 | 5 |
| Photosensitive layer | | 5 | 5 | 5 | 5 | 5 | 5 | 5 | 5 | 5 | 5 | 5 | 5 | 5 |
| N-Oxyamide compound | | A | B | C | D | E | F | G | H | I | J | K | L | none |
| Developer | | 2 | 2 | 2 | 2 | 2 | 2 | 2 | 2 | 2 | 2 | 2 | 2 | 2 |
| Sensitivity(%), 50% halftone dot area | | 63 | 63 | 62 | 63 | 63 | 63 | 62 | 63 | 62 | 61 | 61 | 61 | 54 |
| Variation in enforced aging | | 3.5 | 3.5 | 4.0 | 3.5 | 3.5 | 3.5 | 3.5 | 3.5 | 3.5 | 3.5 | 3.5 | 3.5 | 3.5 |
| Printing Perform-ance | Press life of image area (sheets) | 150,000 | 130,000 | 130,000 | 150,000 | 170,000 | 170,000 | 130,000 | 150,000 | 150,000 | 120,000 | 120,000 | 120,000 | 85,000 |
| | Press life of halftone part | good | good | good | good | good | good | good | good | good | good | good | good | good |
| | Scumming resistance of non-image area | good | good | good | good | good | good | good | good | good | good | good | good | good |

Table 7

| | | Example | | | | | | | | | | | | Comparative Example |
|---|---|---|---|---|---|---|---|---|---|---|---|---|---|---|
| | | 61 | 62 | 63 | 64 | 65 | 66 | 67 | 68 | 69 | 70 | 71 | 72 | 6 |
| Photosensitive layer | | 6 | 6 | 6 | 6 | 6 | 6 | 6 | 6 | 6 | 6 | 6 | 6 | 6 |
| N-Oxyamide compound | | A | B | C | D | E | F | G | H | I | J | K | L | none |
| Developer | | 2 | 2 | 2 | 2 | 2 | 2 | 2 | 2 | 2 | 2 | 2 | 2 | 2 |
| Sensitivity(%), 50% halftone dot area | | 58 | 58 | 57 | 58 | 58 | 58 | 57 | 58 | 57 | 56 | 56 | 56 | 52 |
| Variation in enforced aging | | 3.5 | 3.5 | 4.0 | 3.5 | 3.5 | 3.5 | 3.5 | 3.5 | 3.5 | 3.5 | 3.5 | 3.5 | 3.5 |
| Printing Perform-ance | Press life of image area (sheets) | 90,000 | 80,000 | 80,000 | 90,000 | 95,000 | 95,000 | 80,000 | 90,000 | 90,000 | 75,000 | 75,000 | 75,000 | 70,000 |
| | Press life of halftone part | good | good | good | good | good | good | good | good | good | good | good | good | good |
| | Scumming resistance of non-image area | good | good | good | good | good | good | good | good | good | good | good | good | good |

Table 8

| | | Example | | | | | | | | | | | | Comparative Example |
|---|---|---|---|---|---|---|---|---|---|---|---|---|---|---|
| | | 73 | 74 | 75 | 76 | 77 | 78 | 79 | 80 | 81 | 82 | 83 | 84 | 7 |
| Photosensitive layer | | 7 | 7 | 7 | 7 | 7 | 7 | 7 | 7 | 7 | 7 | 7 | 7 | 7 |
| N-Oxyamide compound | | A | B | C | D | E | F | G | H | I | J | K | L | none |
| Developer | | 2 | 2 | 2 | 2 | 2 | 2 | 2 | 2 | 2 | 2 | 2 | 2 | 2 |
| Sensitivity(%), 50% halftone dot area | | 59 | 59 | 58 | 59 | 59 | 59 | 58 | 59 | 58 | 57 | 57 | 57 | 53 |
| Variation in enforced aging | | 3.0 | 3.0 | 3.5 | 3.0 | 3.0 | 3.0 | 3.0 | 3.0 | 3.0 | 3.0 | 3.0 | 3.0 | 3.0 |
| Printing Performance | Press life of image area (sheets) | 65,000 | 60,000 | 60,000 | 65,000 | 70,000 | 70,000 | 60,000 | 65,000 | 65,000 | 55,000 | 55,000 | 55,000 | 30,000 |
| | Press life of halftone part | good | good | good | good | good | good | good | good | good | good | good | good | good |
| | Scumming resistance of non-image area | good | good | good | good | good | good | good | good | good | good | good | good | good |

As apparent from Tables 2 to 8, in lithographic printing plate precursors of Examples where an N-oxyamide compound as a characteristic feature of the present invention was added, both sensitivity and storage stability were

assured, and the press life and scumming resistance were also satisfied. On the other hand, in lithographic printing plate precursors of Comparative Examples, a practically usable lithographic printing plate was not obtained.

This application is based on Japanese Patent application JP 2004-208777, filed July 15, 2004, the entire content of which is hereby incorporated by reference, the same as if set forth at length.

## Claims

1. A photosensitive composition comprising:

    at least one photopolymerization initiator;
    an N-oxyamide compound represented by formula (1); and
    a compound of undergoing a reaction by an effect of at least one of a radical and an acid to irreversibly change in its physical or chemical property,

    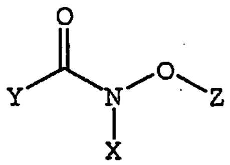

    (1)

    wherein X, Y and Z each independently represents a monovalent substituent.

2. The photosensitive composition according to claim 1, wherein the compound of undergoing a reaction by an effect of at least one of a radical and an acid is a compound having an ethylenically unsaturated double bond.

3. The photosensitive composition according to claim 1, wherein the compound represented by the formula (1) is represented by formula (2):

    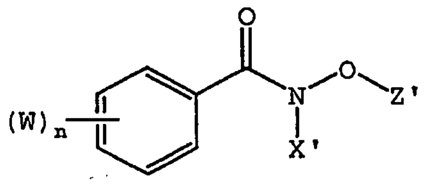

    (2)

    wherein X', W and Z' each independently represents a monovalent substituent, and n represents an integer of from 1 to 5.

4. The photosensitive composition according to claim 1, wherein the compound represented by the formula (1) is represented by formula (3):

    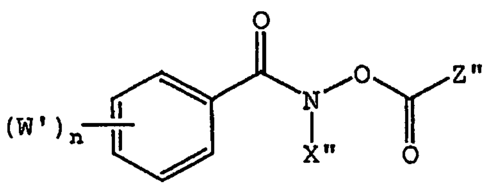

    (3)

    wherein X", W' and Z" each independently represents a monovalent substituent, and n represents an integer of from 1 to 5.

5. The photosensitive composition according to claim 1, wherein the compound represented by the formula (1) is represented by formula (4) or (5):

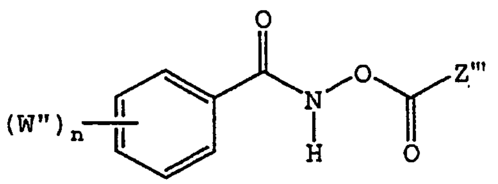

(4)

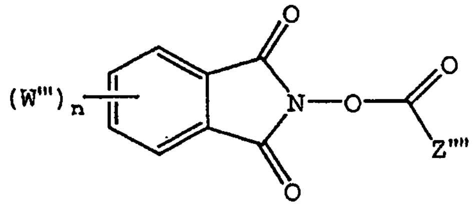

(5)

wherein W", W'", Z'" and Z"" each independently represents a monovalent substituent, and n represents an integer of from 1 to 5.

**6.** The photosensitive composition according to claim 1, further comprising a compound represented by the following formula:

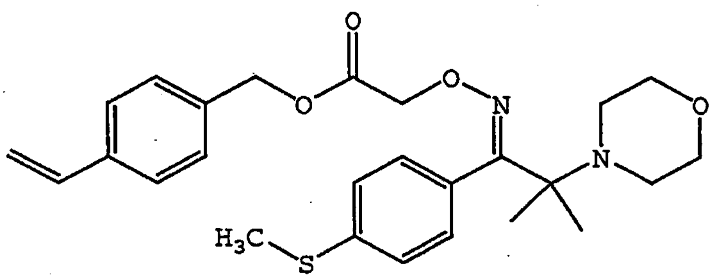

**7.** The photosensitive composition according to claim 1, further comprising a compound represented by formula (XVIII):

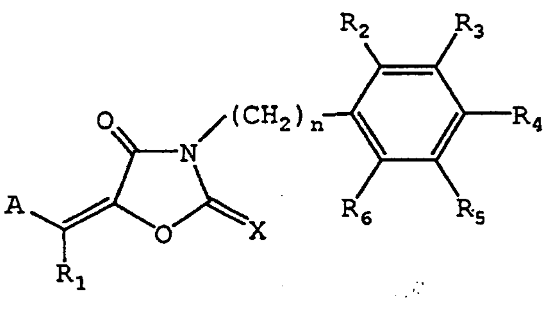

(XVIII)

wherein A represents an aromatic or heterocyclic ring which may have a substituent, X represents an oxygen atom, a sulfur atom or $=NR_7$, $R_1$, $R_2$, $R_3$, $R_4$, $R_5$, $R_6$ and $R_7$ each independently represents a hydrogen atom or a monovalent nonmetallic atomic group, provided that at least one of $R_2$, $R_3$, $R_4$, $R_5$ and $R_6$ is a substituent represented by $-OR_8$ in which $R_8$ represents a monovalent nonmetallic atomic group, and n represents an integer of from 1 to 6.

**8.** The photosensitive composition according to claim 1, further comprising a binder polymer.

**9.** The photosensitive composition. according to claim 1, further comprising a polyurethane having 10 weight% or more of an aromatic group.

**10.** The photosensitive composition according to claim 1, further comprising a sensitizing dye having absorption at a

wavelength in a region of from 350 to 450 nm.

**11.** A lithographic printing plate precursor comprising a photosensitive layer containing the photosensitive composition according to claim 1.

**12.** The lithographic printing plate precursor according to claim 11, further comprising an overcoat layer.

**13.** The lithographic printing plate precursor according to claim 11, wherein an amount of the N-oxyamide compound contained in the photosensitive layer is from 0.01 to 40 parts by weight, per 100 parts by weight of components of the photosensitive layer.

European Patent Office

# EUROPEAN SEARCH REPORT

Application Number
EP 05 01 5446

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 576 143 A (T. AOAI ET AL.) 19 November 1996 (1996-11-19) * column 25, line 1 - line 5 * * column 33; example 12; table 2 * ----- | 1,3-5,8, 11,13 | G03F7/038 G03F7/004 G03F7/031 G03F7/029 |
| X | EP 0 795 789 A (FUJI PHOTO FILM CO LTD) 17 September 1997 (1997-09-17) * page 45; example 16; table 3 * ----- | 1,3,8, 11,13 | |
| X | EP 1 099 691 A (JSR CORPORATION) 16 May 2001 (2001-05-16) * page 38; example 21; table 5 * ----- | 1,3,8 | |
| X | US 4 885 224 A (S. YAMAMOTO ET AL.) 5 December 1989 (1989-12-05) * column 5 - column 7 * * column 19, line 26 - line 29 * * claims 1,6 * ----- | 1-5,8 | |
| A | US 4 371 605 A (C.A. RENNER) 1 February 1983 (1983-02-01) * column 10 - column 11; example 3 * ----- | 1-13 | TECHNICAL FIELDS SEARCHED (Int.Cl.7) G03F |

The present search report has been drawn up for all claims

1

| Place of search | Date of completion of the search | Examiner |
|---|---|---|
| The Hague | 12 August 2005 | Dupart, J.-M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 05 01 5446

This annex lists the patent family members relating to the patent documents cited in the above-mentioned European search report.
The members are as contained in the European Patent Office EDP file on
The European Patent Office is in no way liable for these particulars which are merely given for the purpose of information.

12-08-2005

| Patent document cited in search report | | Publication date | Patent family member(s) | | | Publication date |
|---|---|---|---|---|---|---|
| US 5576143 | A | 19-11-1996 | JP | 5158239 | A | 25-06-1993 |
| | | | JP | 5158242 | A | 25-06-1993 |
| EP 0795789 | A | 17-09-1997 | JP | 9239945 | A | 16-09-1997 |
| | | | DE | 69701266 | D1 | 16-03-2000 |
| | | | DE | 69701266 | T2 | 08-06-2000 |
| | | | EP | 0795789 | A1 | 17-09-1997 |
| | | | US | 6403283 | B1 | 11-06-2002 |
| | | | JP | 10080994 | A | 31-03-1998 |
| EP 1099691 | A | 16-05-2001 | DE | 60018350 | D1 | 07-04-2005 |
| | | | EP | 1099691 | A1 | 16-05-2001 |
| | | | IL | 139513 | A | 15-12-2004 |
| | | | JP | 2001199955 | A | 24-07-2001 |
| | | | SG | 92753 | A1 | 19-11-2002 |
| | | | TW | 513408 | B | 11-12-2002 |
| | | | US | 6517992 | B1 | 11-02-2003 |
| US 4885224 | A | 05-12-1989 | JP | 1894990 | C | 26-12-1994 |
| | | | JP | 6023836 | B | 30-03-1994 |
| | | | JP | 63097940 | A | 28-04-1988 |
| US 4371605 | A | 01-02-1983 | NONE | | | |

EPO FORM P0459

For more details about this annex : see Official Journal of the European Patent Office, No. 12/82